(19) Europäisches Patentamt
European Patent Office
Office européen des brevets

(11) EP 3 438 114 B1

(12) **EUROPEAN PATENT SPECIFICATION**

(45) Date of publication and mention of the grant of the patent:
**04.11.2020 Bulletin 2020/45**

(21) Application number: **17775450.4**

(22) Date of filing: **30.03.2017**

(51) Int Cl.:
***C07F 15/00*** *(2006.01)* ***C09K 11/06*** *(2006.01)*
***H01L 51/50*** *(2006.01)*

(86) International application number:
**PCT/JP2017/013374**

(87) International publication number:
**WO 2017/170916 (05.10.2017 Gazette 2017/40)**

(54) **METAL COMPLEX, COMPOSITION AND LIGHT-EMITTING DEVICE**

METALLKOMPLEX, ZUSAMMENSETZUNG UND LICHTEMITTIERENDES GERÄT

COMPLEXE MÉTALLIQUE, COMPOSITION ET DISPOSITIF ÉLECTROLUMINESCENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.03.2016 JP 2016071414**

(43) Date of publication of application:
**06.02.2019 Bulletin 2019/06**

(73) Proprietor: **Sumitomo Chemical Company, Limited**
**Tokyo 104-8260 (JP)**

(72) Inventors:
- **YOSHIOKA, Mayu**
  **Tsukuba-shi**
  **Ibaraki 300-3294 (JP)**
- **ABE, Taichi**
  **Tsukuba-shi**
  **Ibaraki 300-3294 (JP)**
- **SASADA, Toshiaki**
  **Tsukuba-shi**
  **Ibaraki 300-3294 (JP)**
- **ASADA, Kohei**
  **Tsukuba-shi**
  **Ibaraki 300-3294 (JP)**
- **AKINO, Nobuhiko**
  **Tsukuba-shi**
  **Ibaraki 300-3294 (JP)**

(74) Representative: **J A Kemp LLP**
**14 South Square**
**Gray's Inn**
**London WC1R 5JJ (GB)**

(56) References cited:
**WO-A1-2014/196685**
**WO-A1-2016/185183**
**JP-A- 2011 213 715**
**JP-A- 2011 253 980**
**JP-A- 2012 046 479**
**JP-A- 2012 046 492**
**JP-A- 2012 214 463**
**JP-A- 2015 113 283**
**US-A1- 2012 289 708**
**US-A1- 2015 349 267**
**US-A1- 2016 049 598**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 438 114 B1

## Description

### Technical Field

The present invention relates to a metal complex, a composition comprising the metal complex, and a light emitting device comprising the metal complex.

### Background Art

Use of phosphorescent compounds that exhibit light emission from a triplet excited state as light emitting materials in light emitting layers in light emitting devices has been studied. For example, Patent Literature 1 and Patent Literature 2 disclose iridium complexes with ligands having the 1,2,4-triazole structure. Patent Literature 3 describes further iridium or platinum complexes.

### Citation List

### Patent Literature

Patent Literature 1: US Patent Application Publication No. 2015/0349267
Patent Literature 2: International Publication No. 2014/085296
Patent Literature 3: JP 2015 113283

### Summary of Invention

### Technical Problem

However, the light emission stability has been not sufficient with the above-mentioned metal complexes.

Therefore, it is an object of the present invention to provide a metal complex having excellent light emission stability. Further, it is another object of the present invention to provide a composition, a film, and a light emitting device comprising the metal complex.

### Solution to Problem

The present invention provides the following [1] to [15].

[1] A metal complex represented by formula (1):

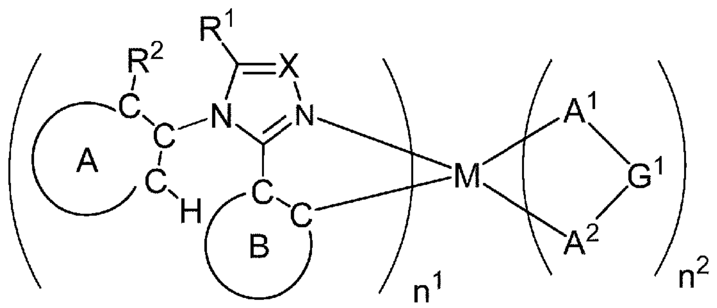

(1)

wherein,

X represents a nitrogen atom or a group represented by =C($R^X$)-, where $R^X$ represents a hydrogen atom, an alkyl group, a cycloalkyl group, an alkoxy group, a cycloalkoxy group, an aryl group, an aryloxy group, a monovalent heterocyclic group, a substituted amino group, or a halogen atom and these groups may have a substituent selected from the group consisting of a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group and a cycloalkynyl

group, and when there are a plurality of X, they may be the same or different;
$R^1$ represents an alkyl group having 5 or more carbon atoms, the group may have a substituent selected from the group consisting of an alkoxy group, a cycloalkyl group, a cycloalkoxy group, an aryl group, a monovalent heterocyclic group, a substituted amino group and a halogen atom, and when there are a plurality of $R^1$, they may be the same or different;
$R^2$ represents an alkyl group, a cycloalkyl group, an alkoxy group, a cycloalkoxy group, an aryl group, an aryloxy group, a monovalent heterocyclic group, a substituted amino group, or a halogen atom and these groups may have a substituent selected form the group consisting of an alkyl group, a cycloalkyl group, an alkoxy group, a cycloalkoxy group, an aryl group, a monovalent heterocyclic group, a substituted amino group and a halogen atom, and when there are a plurality of $R^2$, they may be the same or different;
ring A and ring B each independently represent an aromatic hydrocarbon ring or an aromatic heterocyclic ring and these rings may have a substituent, and when there are a plurality of substituents, they may be the same or different or bonded to each other to form a ring together with atoms to which they are bonded; when there are a plurality of ring A and ring B exist, they may be the same or different;
wherein the optional substituents of ring A are selected from the group consisting of an alkyl group, a cycloalkyl group, an aryl group, a monovalent heterocyclic group and a substituted amino group;
wherein the optional substituents of ring B are selected from the group consisting of an alkyl group, a cycloalkyl group, an aryl group, a monovalent heterocyclic group, a substituted amino group and a halogen atom;
M represents a rhodium atom, a palladium atom, an iridium atom, or a platinum atom;
$n^1$ represents an integer of 1 or more, $n^2$ represents an integer of 0 or more, and $n^1 + n^2$ is 2 or 3;
when M is a rhodium atom or an iridium atom, $n^1 + n^2$ is 3, and when M is a palladium atom or a platinum atom, $n^1 + n^2$ is 2;
$A^1$-$G^1$-$A^2$ represents an anionic bidentate ligand; $A^1$ and $A^2$ each independently represent a carbon atom, an oxygen atom, or a nitrogen atom and these atoms may be atoms constituting a ring; $G^1$ represents a single bond; or an atomic group constituting a bidentate ligand together with $A^1$ and $A^2$; and when there are a plurality of $A^1$-$G^1$-$A^2$, they may be the same or different.

[2] The metal complex according to [1], wherein the ring B is a benzene ring, a fluorene ring, a dibenzofuran ring, or a dibenzothiophene ring.
[3] The metal complex according to [2], wherein the metal complex is represented by formula (1a):

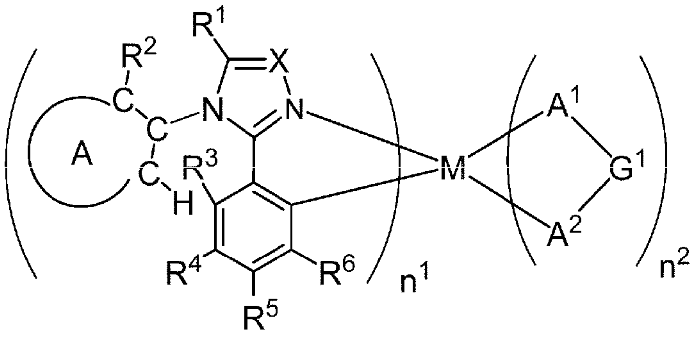

(1a)

wherein,

M, $n^1$, $n^2$, $R^1$, $R^2$, ring A, X, and $A^1$-$G^1$-$A^2$ represent the same meanings as described above;
$R^3$, $R^4$, $R^5$, and $R^6$ each independently represent a hydrogen atom, an alkyl group, a cycloalkyl group, an alkoxy group, a cycloalkoxy group, an aryl group, an aryloxy group, a monovalent heterocyclic group, a substituted amino group, or a halogen atom and these groups may have a substituent selected from the group consisting of an alkyl group, a cycloalkyl group, an alkoxy group, a cycloalkoxy group, an aryl group, a monovalent heterocyclic group, a substituted amino group and a halogen atom,
when there are a plurality of $R^3$, $R^4$, $R^5$, and $R^6$, they may be the same or different; $R^3$ and $R^4$, $R^4$ and $R^5$, and $R^5$ and $R^6$ each may be bonded to each other to form a ring together with the atoms to which they are bonded.

[4] The metal complex according to [3], wherein the metal complex is represented by formula (1b):

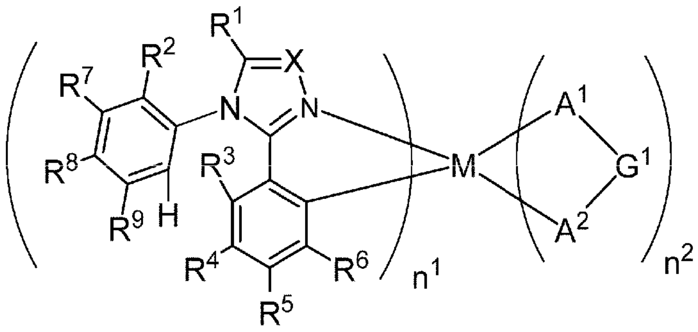

(1b)

wherein,

M, $n^1$, $n^2$, $R^1$, $R^2$, $R^3$, $R^4$, $R^5$, $R^6$, X, and $A^1$-$G^1$-$A^2$ have the same meanings as described above;
$R^7$, $R^8$, and $R^9$ each independently represent a hydrogen atom, an alkyl group, a cycloalkyl group, an alkoxy group, a cycloalkoxy group, an aryl group, an aryloxy group, a monovalent heterocyclic group, a substituted amino group, or a halogen atom and these groups may have a substituent selected from the group consisting of an alkyl group, a cycloalkyl group, an alkoxy group, a cycloalkoxy group, an aryl group, a monovalent heterocyclic group, a substituted amino group and a halogen atom; when there are a plurality of $R^7$, $R^8$, and $R^9$, they may be the same or different; $R^7$ and $R^8$ and $R^8$ and $R^9$ may be bonded to each other to form a ring together with the atoms to which they are bonded.

[5] The metal complex according to any of [1] to [4], wherein at least one of $R^1$ is a group represented by formula (2):

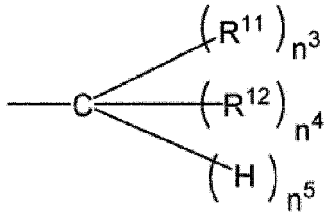

(2)

wherein,

$R^{11}$ represents an alkyl group and the group may have a substituent selected from the group consisting of an alkoxy group, a cycloalkyl group, a cycloalkoxy group, an aryl group, a monovalent heterocyclic group, a substituted amino group and a halogen atom; when there are a plurality of $R^{11}$, they may be the same or different;
$R^{12}$ represents a cycloalkyl group, an alkoxy group, a cycloalkoxy group, an aryl group, an aryloxy group, a monovalent heterocyclic group, a substituted amino group, or a halogen atom and these groups may have a substituent selected from the group consisting of an alkyl group, a cycloalkyl group, an alkoxy group, a cycloalkoxy group, an aryl group, a monovalent heterocyclic group, a substituted amino group and a halogen atom; when there are a plurality of $R^{12}$, they may be the same or different;
$n^3$ represents an integer of 1 to 3, $n^4$ represents an integer of 0 to 2, $n^5$ represents 0 or 1, and $n^3 + n^4 + n^5$ is 3.

[6] The metal complex according to [5], wherein $n^5$ is 0.
[7] The metal complex according to [5] or [6], wherein $n^4$ is 0.
[8] The metal complex according to any of [1] to [7], wherein $R^2$ is an alkyl group that may have a substituent.
[9] The metal complex according to any of [1] to [8], wherein M is a platinum atom or an iridium atom.
[10] The metal complex according to any of [1] to [9], wherein $n^2$ is 0.
[11] The metal complex according to any of [1] to [10], wherein X is a nitrogen atom.
[12] A composition comprising:

a metal complex according to any of [1] to [11]; and
a compound represented by formula (H-1) and at least one selected from the group consisting of polymer compounds comprising a constitutional unit represented by formula (Y):

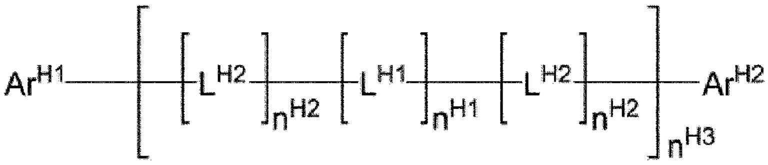 (H-1)

wherein,

$Ar^{H1}$ and $Ar^{H2}$ each independently represent an aryl group or a monovalent heterocyclic group and these groups may have a substituent selected from the group consisting of a halogen atom, an alkyl group, a cycloalkyl group, an alkoxy group, a cycloalkoxy group, an aryl group and a monovalent heterocyclic group;
$n^{H1}$ and $n^{H2}$ each independently represent 0 or 1; when there are a plurality of $n^{H1}$, they may be the same or different; when there are a plurality of $n^{H2}$, they may be the same or different;
$n^{H3}$ represents an integer of 0 or more;
$L^{H1}$ represents an arylene group, a divalent heterocyclic group, or a group represented by $-[C(R^{H11})_2]n^{H11}-$ and these groups may have a substituent selected from the group consisting of a halogen atom, an alkyl group, a cycloalkyl group, an alkoxy group, a cycloalkoxy group, an aryl group and a monovalent heterocyclic group; when there are a plurality of $L^{H1}$, they may be the same or different;
$n^{H11}$ represents an integer of 1 or more and 10 or less; $R^{H11}$ represents a hydrogen atom, an alkyl group, a cycloalkyl group, an alkoxy group, a cycloalkoxy group, an aryl group, or a monovalent heterocyclic group and these groups may have a substituent selected from the group consisting of a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group and a cycloalkynyl group; a plurality of $R^{H11}$ may be the same or different and they may be bonded to each other to form a ring together with carbon atoms to which they are bonded;
$L^{H2}$ represents a group represented by $-N(-L^{H21}-R^{H21})-$; when there are a plurality of $L^{H2}$, they may be the same or different;
$L^{H21}$ represents a single bond, an arylene group, or a divalent heterocyclic group, and these groups may have a substituent selected from the group consisting of a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group and a cycloalkynyl group; $R^{H21}$ represents a hydrogen atom, an alkyl group, a cycloalkyl group, an aryl group, or a monovalent heterocyclic group, and these groups may have a substituent selected from the group consisting of a halogen atom, an alkyl group, a cycloalkyl group, an alkoxy group, a cycloalkoxy group, an aryl group and a monovalent heterocyclic group.

$$-[-Ar^{Y1}-]- \qquad (Y)$$

wherein $Ar^{Y1}$ represents an arylene group, a divalent heterocyclic group, or a divalent group in which at least one arylene group and at least one divalent heterocyclic group are directly bonded and these groups may have a substituent selected from the group consisting of an alkyl group, a cycloalkyl group and an aryl group.

[13] A composition comprising

a metal complex according to any of [1] to [11] and
at least one material selected from the group consisting of a hole transporting material, a hole injecting material, an electron transporting material, an electron injecting material, a luminescent material, an antioxidant, and a solvent.

[14] A film comprising the metal complex according to any of [1] to [11].
[15] A light emitting device comprising a metal complex according to any of [1] to [11].

## Advantageous Effects of Invention

According to the present invention, a metal complex having excellent light emission stability can be provided.

Moreover, according to the present invention, a composition, a film, and a light emitting device comprising the metal complex can be provided.

**Description of Embodiments**

Preferable embodiments of the present invention will now be described in detail.

<Description of Common Terms>

Unless otherwise stated, terms commonly used in the present specification have the following meanings.

Me represents a methyl group, Et represents an ethyl group, Bu represents a butyl group, i-Pr represents an isopropyl group, t-Bu represents tert-butyl, and Ph represents a phenyl group.

The hydrogen atom (also represented by "H".) may be a heavy hydrogen atom or a light hydrogen atom.

In the formula representing a metal complex, a solid line representing a bond to the central metal represents a covalent bond or a coordinate bond.

The term "polymer compound" means a polymer having molecular weight distribution and having a polystyrene-equivalent number-average molecular weight of $1 \times 10^3$ or more (for example, $1 \times 10^3$ to $1 \times 10^8$).

The polymer compound may be any of a block copolymer, a random copolymer, an alternating copolymer, and a graft copolymer, or may even be some other form.

If a polymerization active group remains intact at the terminal group of the polymer compound, light emitting properties or the luminance lifetime may deteriorate if such a polymer compound is used to fabricate the light emitting device, and therefore, it is preferable that the terminal group be a stable group. This terminal group is preferably a group covalently bonded to the main chain, and examples thereof include groups bonding to an aryl group or a monovalent heterocyclic group via a carbon-carbon bond.

The term "constitutional unit" means a unit occurring one or more times in a polymer compound.

The term "low molecular weight compound" means a compound that does not have a molecular weight distribution and that has a molecular weight of $1 \times 10^4$ or less.

The "alkyl group" may be either linear or branched. The linear alkyl group usually has 1 to 50 carbon atoms, preferably 1 to 10 carbon atoms, and more preferably 1 to 6 carbon atoms, not including the carbon atoms of the substituent. The branched alkyl group usually has 3 to 50 carbon atoms, preferably 3 to 12 carbon atoms, and more preferably 4 to 8 carbon atoms, not including the carbon atoms of the substituent.

The alkyl group may have a substituent. Examples of the alkyl group include a methyl group, an ethyl group, a propyl group, an isopropyl group, a butyl group, a 2-butyl group, an isopropyl group, a butyl group, a 2-butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group, a dodecyl group, and the like. Moreover, the alkyl group may be a group obtained by substituting a part or all of the hydrogen atoms of any of these groups with a cycloalkyl group, an alkoxy group, a cycloalkoxy group, an aryl group, a fluorine atom, or the like. Examples of such alkyl groups include a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-hexylphenyl)propyl group, and a 6-ethyloxyhexyl group.

The "cycloalkyl group" usually has 3 to 50 carbon atoms, preferably 3 to 30 carbon atoms, and more preferably 4 to 20 carbon atoms, not including the carbon atoms of the substituent.

The cycloalkyl group may have a substituent. Examples of the cycloalkyl group include a cyclohexyl group, a cyclohexylmethyl group, and a cyclohexylethyl group.

The term "aryl group" means the atomic group remaining after removing from an aromatic hydrocarbon one hydrogen atom that is directly bonded to a carbon atom constituting the ring. The aryl group usually has 6 to 60 carbon atoms, preferably 6 to 20 carbon atoms, and more preferably 6 to 10 carbon atoms, not including the carbon atoms of the substituent.

The aryl group may have a substituent. Examples of the aryl group include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group, a 4-phenylphenyl group, and the like. Moreover, the alkyl group may be a group obtained by substituting a part or all of the hydrogen atoms of any of these groups with an alkyl group, a cycloalkyl group, an alkoxy group, a cycloalkoxy group, an aryl group, a fluorine atom, or the like.

The "alkoxy group" may be any of linear and branched. The linear alkoxy group usually has 1 to 40 carbon atoms, and preferably 4 to 10 carbon atoms, not including the carbon atoms of the substituent. The branched alkoxy group usually has 3 to 40 carbon atoms, and preferably 4 to 10 carbon atoms, not including the carbon atoms of the substituent.

The alkoxy group may have a substituent. Examples of the alkoxy group include a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group, a lauryloxy group, and the like. Moreover, the alkyl group may be a group obtained by substituting a part or all of the hydrogen atoms of any of these groups with a cycloalkyl group, an alkoxy group, a cycloalkoxy group, an aryl group, a fluorine atom, or the like.

The "cycloalkoxy group" usually has 3 to 40 carbon atoms, and preferably 4 to 10 carbon atoms, not including the carbon atoms of the substituent.

The cycloalkoxy group may have a substituent. Examples of the cycloalkoxy group include a cyclohexyloxy group.

The "aryloxy group" usually has 6 to 60 carbon atoms, and preferably 6 to 48, not including the carbon atoms of the substituent.

The aryloxy group may have a substituent. Examples of the aryloxy group include a phenoxy group, a 1-naphthyloxy group, a 2-naphthyloxy group, a 1-anthracenyloxy group, a 9-anthracenyloxy group, a 1-pyrenyloxy group, and the like. Moreover, the alkyl group may be a group obtained by substituting a part or all of the hydrogen atoms of any of these groups with an alkyl group, a cycloalkyl group, an alkoxy group, a cycloalkoxy group, a fluorine atom, or the like.

The term "p-valent heterocyclic group" (p denotes an integer of 1 or more) means an atomic group remaining after removing from a heterocyclic compound p atoms of hydrogen among the hydrogen atoms that are directly bonded to carbon atoms or hetero atoms constituting the ring. Among p-valent heterocyclic groups, preferable are "p-valent aromatic heterocyclic groups", which are the atomic groups remaining after p atoms of hydrogen among the hydrogen atoms directly bonded to carbon atoms or hetero atoms constituting the ring are removed from an aromatic heterocyclic compound.

The term "aromatic heterocyclic compound" means, for example, a compound in which the heterocyclic ring itself exhibits aromaticity, such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzophosphole, and the like, or a compound in which an aromatic ring is condensed to a heterocyclic ring even if the heterocyclic ring itself does not exhibit aromaticity, such as phenoxazine, phenothiazine, dibenzoborole, dibenzosilole, benzopyran, and the like.

The p-valent heterocyclic group has usually 2 to 60, preferably 3 to 20, and more preferably 4 to 20 carbon atoms, not including the carbon atoms of the substituent.

The p-valent heterocyclic group may have a substituent, and examples of a monovalent heterocyclic group, among the p-valent heterocyclic groups, include a thienyl group, a pyrrolyl group, a furyl group, a pyridinyl group, a piperidinyl group, a quinolinyl group, an isoquinolinyl group, a pyrimidinyl group, a triazinyl group, and the like. Moreover, the monovalent heterocyclic group may be a group obtained by substituting a part or all of the hydrogen atoms of any of these groups with an alkyl group, a cycloalkyl group, an alkoxy group, a cycloalkoxy group, or the like.

The term "halogen atom" means a fluorine atom, a chlorine atom, a bromine atom, or an iodine atom.

An "amino group" may have a substituent, and a substituted amino group is preferable. As the substituent that the amino group has, an alkyl group, a cycloalkyl group, an aryl group, or a monovalent heterocyclic group is preferable.

Substituted amino groups are preferably disubstituted amino groups. Examples of the disubstituted amino groups include a dialkylamino group, a dicycloalkylamino group, and a diarylamino group.

Examples of the disubstituted amino group include a dimethylamino group, a diethylamino group, a diphenylamino group, a bis(4-methylphenyl)amino group, a bis(4-tert-butylphenyl)amino group, and a bis(3,5-di-tert-butylphenyl)amino group.

An "alkenyl group" may be any of linear and branched. The linear alkenyl group usually has 2 to 30 carbon atoms, and preferably 3 to 20 carbon atoms, not including the carbon atoms of the substituent. The branched alkenyl group usually has carbon atoms 3 to 30, and preferably 4 to 20 carbon atoms, not including the carbon atoms of the substituent.

A "cycloalkenyl group" usually has 3 to 30 carbon atoms, and preferably 4 to 20 carbon atoms, not including the carbon atoms of the substituent.

The alkenyl group and the cycloalkenyl group may have a substituent. Examples of the alkenyl group include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group, a 7-octenyl group, and groups obtained by substituting a part or all the hydrogen atoms of these groups with a substituent. Examples of the cycloalkenyl group include a cyclohexenyl group and a 2-norbornylenyl group.

An "alkynyl group" may be any of linear and branched. The alkynyl group usually has 2 to 20 carbon atoms, and preferably 3 to 20 carbon atoms, not including the carbon atoms of the substituent. The branched alkynyl group usually has 4 to 30 carbon atoms, and preferably 4 to 20 carbon atoms, not including the carbon atoms of the substituent.

A "cycloalkynyl group" usually has 4 to 30 carbon atoms, and preferably 4 to 20 carbon atoms, not including

the carbon atoms of the substituent.

The alkynyl group and the cycloalkynyl group may have a substituent. Examples of the alkynyl group include an ethynyl group, a 1-propynyl group, a 2-propynyl group, a 2-butynyl group, a 3-butynyl group, a 3-pentynyl group, a 4-pentynyl group, a 1-hexynyl group, a 5-hexynyl group, and groups obtained by substituting a part or all of the hydrogen atoms of these groups with a substituent.

An "arylene group" means an atomic group remaining after removing from an aromatic hydrocarbon two hydrogen atoms that are directly bonded to a carbon atom constituting the ring. The arylene group usually has 6 to 60 carbon atoms, preferably 6 to 30 carbon atoms, and more preferably 6 to 18 carbon atoms, not including the carbon atoms of the substituent.

The arylene group may have a substituent. Examples of the arylene group include a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group, a chrysenediyl group, and groups obtained by substituting a part or all of the hydrogen atoms of these groups with a substituent. The arylene group is preferably a group represented by one of formula (A-1) to formula (A-20). The arylene group may be a group obtained by bonding a plurality of these groups.

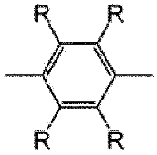
(A-1)
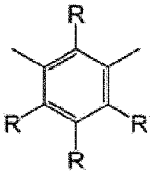
(A-2)
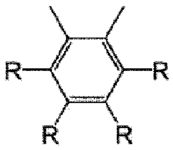
(A-3)
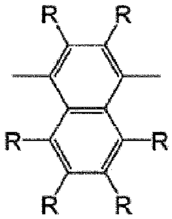
(A-4)
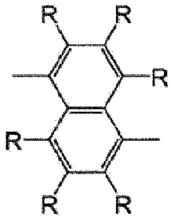
(A-5)
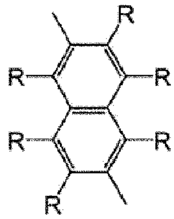
(A-6)

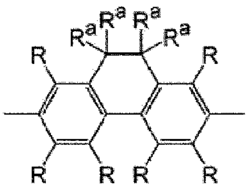
(A-7)
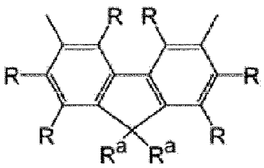
(A-8)
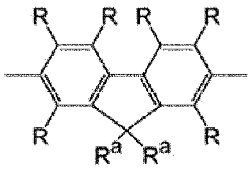
(A-9)
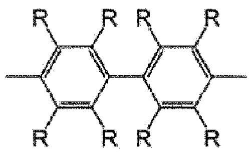
(A-10)

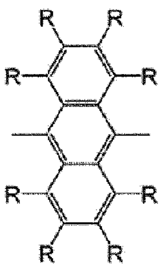
(A-11)
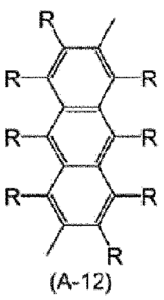
(A-12)
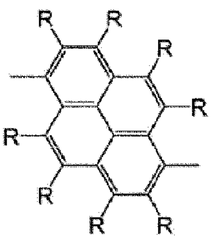
(A-13)
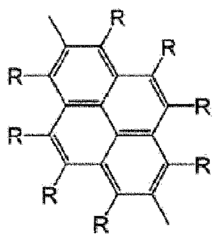
(A-14)
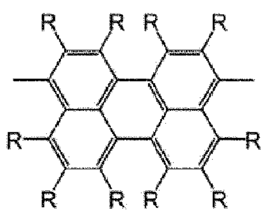
(A-15)

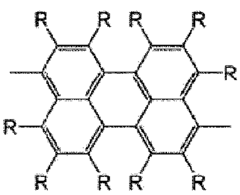
(A-16)
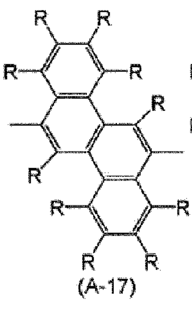
(A-17)
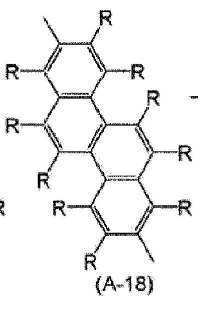
(A-18)
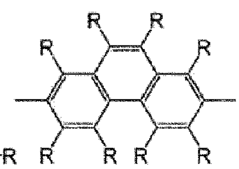
(A-19)
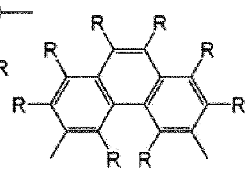
(A-20)

In the formulas, R and $R^a$ each independently represent a hydrogen atom, an alkyl group, a cycloalkyl group,

an aryl group or a monovalent heterocyclic group; a plurality of R and $R^a$ each may be the same or different; and the plurality of $R^a$ may be bonded to each other to form a ring together with the atoms to which they are bonded.

The divalent heterocyclic group usually has 2 to 60 carbon atoms, preferably 3 to 20 carbon atoms, and more preferably 4 to 15 carbon atoms, not including the carbon atoms of the substituent.

The divalent heterocyclic group may have a substituent. Examples of the divalent heterocyclic group include divalent groups obtained by removing 2 hydrogen atoms of the hydrogen atoms directly bonded to a carbon atom or a heteroatom constituting the ring(s) from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole, or triazole and groups obtained by substituting a part or all of the hydrogen atoms of these groups with a substituent. The divalent heterocyclic group is preferably a group represented by one of formula (AA-1) to formula (AA-34). The divalent heterocyclic group may be a group obtained by bonding a plurality of these groups.

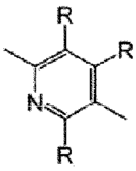
(AA-1)
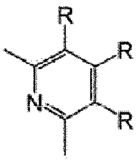
(AA-2)
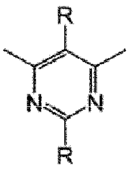
(AA-3)
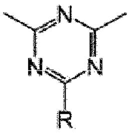
(AA-4)
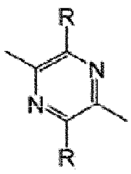
(AA-5)
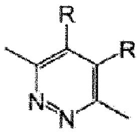
(AA-6)
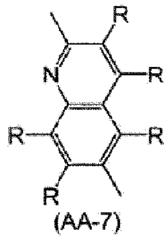
(AA-7)
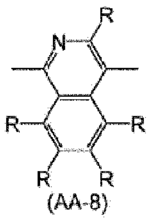
(AA-8)
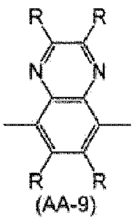
(AA-9)
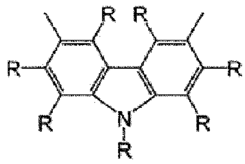
(AA-10)
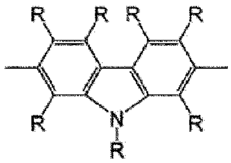
(AA-11)
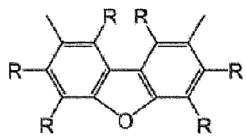
(AA-12)
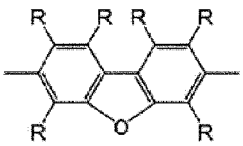
(AA-13)
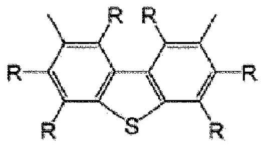
(AA-14)
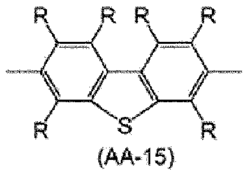
(AA-15)
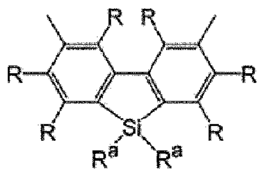
(AA-16)
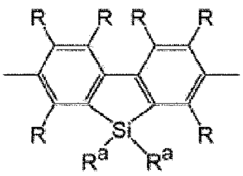
(AA-17)
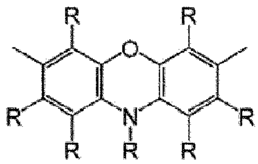
(AA-18)
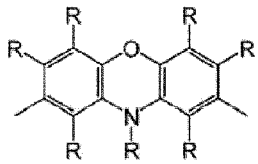
(AA-19)
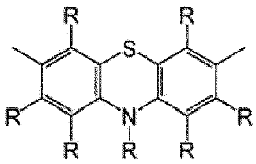
(AA-20)
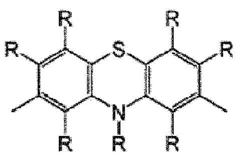
(AA-21)
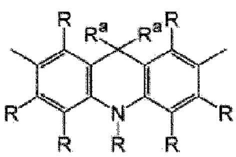
(AA-22)
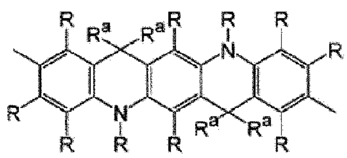
(AA-23)
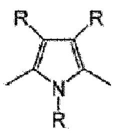
(AA-24)
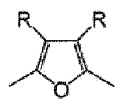
(AA-25)

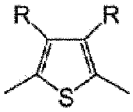
(AA-26)
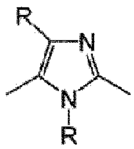
(AA-27)
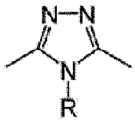
(AA-28)
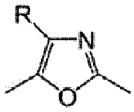
(AA-29)
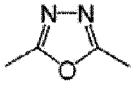
(AA-30)
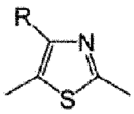
(AA-31)
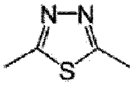
(AA-32)

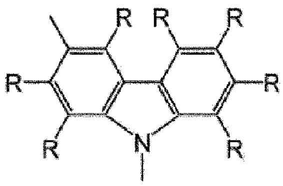
(AA-33)
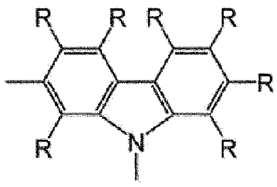
(AA-34)

In the formulas, R and $R^a$ have the same meanings as described above.

The term "crosslinking group" means a group capable of producing a new bond when subjected to heat, UV-irradiation, near-UV irradiation, visible light irradiation, infrared irradiation, a radical reaction, and the like. The crosslinking group is preferably a group represented by any of formula (B-1) to formula (B-17). These groups may have a substituent.

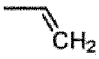
(B-1)
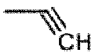
(B-2)
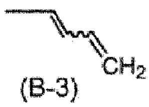
(B-3)
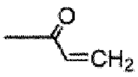
(B-4)
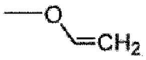
(B-5)
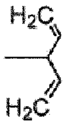
(B-6)
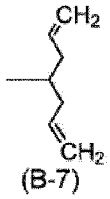
(B-7)
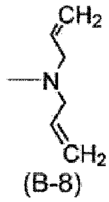
(B-8)

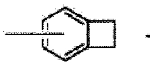
(B-9)
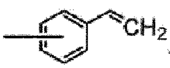
(B-10)
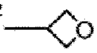
(B-11)
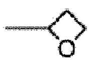
(B-12)
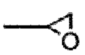
(B-13)
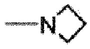
(B-14)
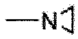
(B-15)
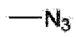
(B-16)
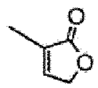
(B-17)

The term "substituent" represents a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group, or a cycloalkynyl group. The substituent may also be a crosslinking group.

As used herein, the term "metal complex having excellent stability of light emission" (or the term "light emission stability of the metal complex is excellent") means that the light emission from a triplet excited state luminance of the metal complex is hard to decrease when the metal complex is continually activated by certain excitation conditions. Examples of the method for activating the metal complex include optical pumping and current excitation.

The metal complex according to the present embodiment has excellent light emission stability, and therefore a composition, a film, and a light emitting device comprising the metal complex according to the present embodiment also have excellent light emission stability.

As used herein, the aryl group, monovalent heterocyclic group, or substituted amino group may be dendron.

The term "dendron" means a group having a regular dendritic branching structure (i.e., dendrimer structure) with branching points that are atoms or rings. Examples of a compound having a dendron (hereinafter, referred to as "dendrimer") include structures described in literature such as International Publication No. WO 2002/067343, Japanese Unexamined Patent Publication No. 2003-231692, International Publication No. WO 2003/079736, International Publication No. and WO 2006/097717.

The dendron is preferably a group represented by formula (D-A) or (D-B).

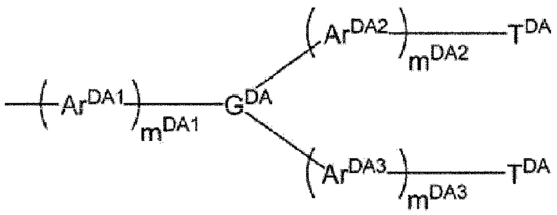

(D-A)

In the formula,
$m^{DA1}$, $m^{DA2}$, and $m^{DA3}$ each independently denote an integer of 0 or more,
$G^{DA}$ represents a nitrogen atom, an aromatic hydrocarbon group, or a heterocyclic group, and these groups may have a substituent,
$Ar^{DA1}$, $Ar^{DA2}$, and $Ar^{DA3}$ each independently represent an arylene group or a divalent heterocyclic group, and these groups may have a substituent; and when there are a plurality of $Ar^{DA1}$, $Ar^{DA2}$, and $Ar^{DA3}$, they may be the same or different, and
$T^{DA}$ represents an aryl group or a monovalent heterocyclic group, and these groups may have a substituent; and a plurality of $T^{DA}$ may be the same or different.

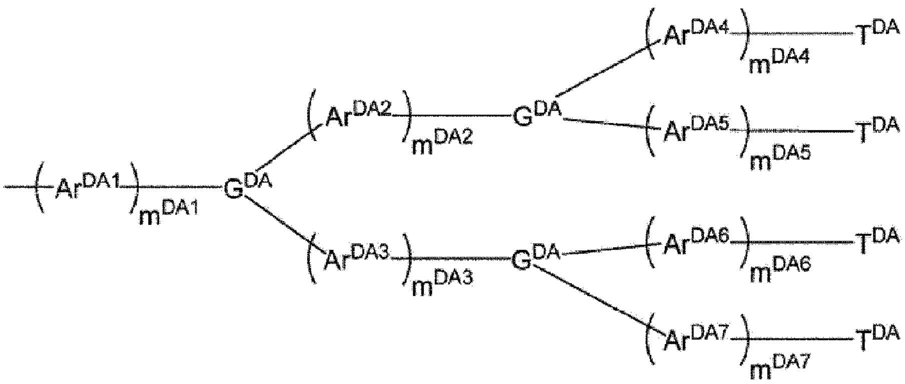

(D-B)

In the formula,
$m^{DA1}$, $m^{DA2}$, $m^{DA3}$, $m^{DA4}$, $m^{DA5}$, $m^{DA6}$, and $m^{DA7}$ each independently denote an integer of 0 or more,
$G^{DA}$ represents a nitrogen atom, an aromatic hydrocarbon group, or a heterocyclic group, and these groups may have a substituent; a plurality of $G^{DA}$ may be the same or different,
$Ar^{DA1}$, $Ar^{DA2}$, $Ar^{DA3}$, $Ar^{DA4}$, $Ar^{DA5}$, $Ar^{DA6}$, and $Ar^{DA7}$ each independently represent an arylene group or a divalent heterocyclic group, and these groups may have a substituent; and when there are a plurality of $Ar^{DA1}$, $Ar^{DA2}$, $Ar^{DA3}$, $Ar^{DA4}$, $Ar^{DA5}$, $Ar^{DA6}$, and $Ar^{DA7}$, they may be the same or different, and
$T^{DA}$ represents an aryl group or a monovalent heterocyclic group, and these groups may have a substituent; a plurality of $T^{DA}$ may be the same or different.

$m^{DA1}$, $m^{DA2}$, $m^{DA3}$, $m^{DA4}$, $m^{DA5}$, $m^{DA6}$, and $m^{DA7}$ are generally an integer of 10 or less, preferably an integer of 5 or less, and more preferably 0 or 1. It is preferable that $m^{DA2}$, $m^{DA3}$, $m^{DA4}$, $m^{DA5}$, $m^{DA6}$, and $m^{DA7}$ are the same integer. It is preferable that $m^{DA1}$, $m^{DA2}$, $m^{DA3}$, $m^{DA4}$, $m^{DA5}$, $m^{DA6}$, and $m^{DA7}$ are the same integer. It is preferable that $m^{DA1}$, $m^{DA2}$, $m^{DA3}$, $m^{DA4}$, $m^{DA5}$, $m^{DA6}$ and $m^{DA7}$ are all 0.

$G^{DA}$ is preferably a group represented by one of formulas (GDA-11) to (GDA-15) and these groups may have a substituent.

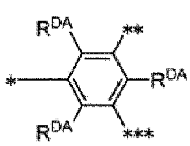
(GDA-11)

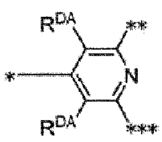
(GDA-12)

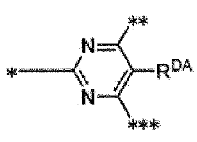
(GDA-13)

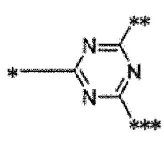
(GDA-14)

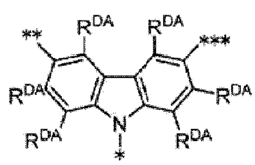
(GDA-15)

In the formula,

* represents a bond with $Ar^{DA1}$ in formula (D-A), $Ar^{DA1}$ in formula (D-B), $Ar^{DA2}$ in formula (D-B), or $Ar^{DA3}$ in formula (D-B),

** represents a bond with $Ar^{DA2}$ in formula (D-A), $Ar^{DA2}$ in formula (D-B), $ArD^{A4}$ in formula (D-B), or $Ar^{DA6}$ in formula (D-B),

*** represents a bond with $Ar^{DA3}$ in formula (D-A), $Ar^{DA3}$ in formula (D-B), $Ar^{DA5}$ in formula (D-B), or $Ar^{DA7}$ in formula (D-B), and

$R^{DA}$ represents a hydrogen atom, an alkyl group, a cycloalkyl group, an alkoxy group, a cycloalkoxy group, an aryl group, or a monovalent heterocyclic group, and these groups may further have a substituent; when there are a plurality of $R^{DA}$, they may be the same or different.

$R^{DA}$ is preferably a hydrogen atom, an alkyl group, a cycloalkyl group, an alkoxy group, or a cycloalkoxy group, more preferably a hydrogen atom, an alkyl group, or a cycloalkyl group, and these groups may have a substituent.

$Ar^{DA1}$, $Ar^{DA2}$, $Ar^{DA3}$, $Ar^{DA4}$, $Ar^{DA5}$, $Ar^{DA6}$, and $Ar^{DA7}$ are preferably a group represented by formula (ArDA-1) to (ArDA-3).

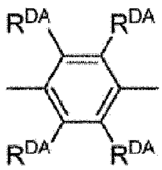

**(ArDA-1)**

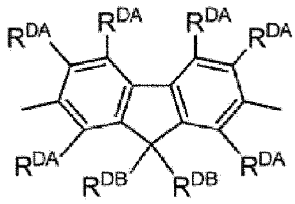

**(ArDA-2)**

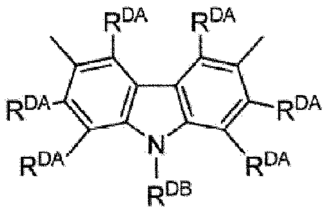

**(ArDA-3)**

In the formula,

$R^{DA}$ has the same meaning as described above,

$R^{DB}$ represents a hydrogen atom, an alkyl group, a cycloalkyl group, an aryl group, or a monovalent heterocyclic group, and these groups may have a substituent; and when there are a plurality of $R^{DB}$, they may be the same or different.

$R^{DB}$ is preferably an alkyl group, a cycloalkyl group, an aryl group, or a monovalent heterocyclic group, more preferably an aryl group or a monovalent heterocyclic group, and still more preferably an aryl group, and these groups may have a substituent.

$T^{DA}$ is preferably a group represented by formula (TDA-1) to (TDA-3).

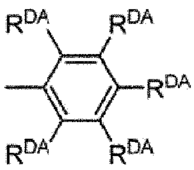

**(TDA-1)**

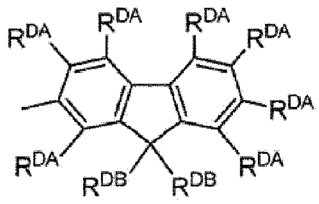

**(TDA-2)**

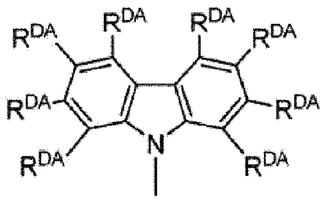

**(TDA-3)**

In the formula, $R^{DA}$ and $R^{DB}$ have the same meanings as described above.

The group represented by formula (D-A) is preferably a group represented by formula (D-A1) to (D-A3).

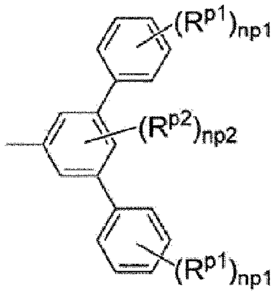

(D-A1)

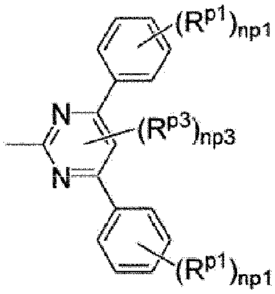

(D-A2)

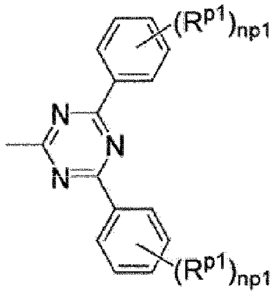

(D-A3)

In the formula,
$R^{p1}$, $R^{p2}$, and $R^{p3}$ each independently represent an alkyl group, a cycloalkyl group, an alkoxy group, a cycloalkoxy group, or a halogen atom; when there are a plurality of $R^{p1}$ and $R^{p2}$, they may be the same or different, and
np1 denotes an integer of 0 to 5, np2 denotes an integer of 0 to 3, and np3 represents 0 or 1; a plurality of np1 may be the same or different.

The group represented by formula (D-B) is preferably a group represented by formula (D-B1) to (D-B3).

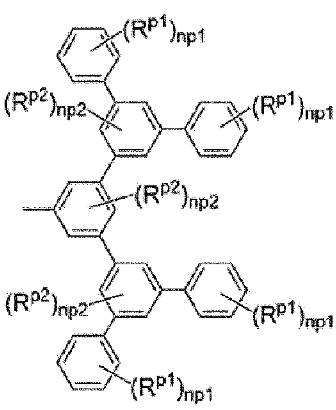

(D-B1)

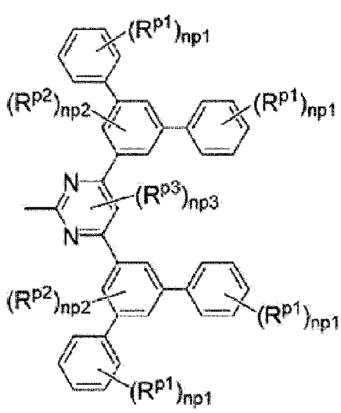

(D-B2)

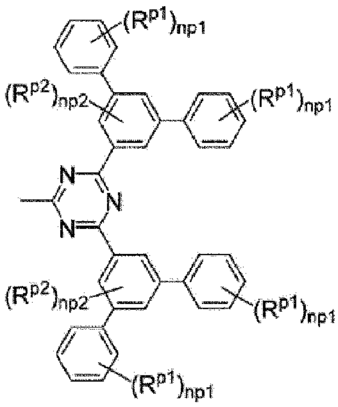

(D-B3)

In the formula,
$R^{p1}$, $R^{p2}$, and $R^{p3}$ each independently represent an alkyl group, a cycloalkyl group, an alkoxy group, a cycloalkoxy group, or a halogen atom; when there are a plurality of $R^{p1}$ and $R^{p2}$, they may be the same or different, and
np1 denotes an integer of 0 to 5, np2 denotes an integer of 0 to 3, and np3 represents 0 or 1; when there are a plurality of np1 and np2, they may be the same or different.

np1 is preferably an integer of 0 to 3, more preferably an integer of 1 to 3, and further preferably 1. np2 is preferably 0 or 1, and more preferably 0. np3 is preferably 0.

$R^{p1}$, $R^{p2}$, and $R^{p3}$ are each preferably an alkyl group or a cycloalkyl group.

<Metal Complex>

Next, the metal complex according to the present embodiment will be described. The metal complex according to the present embodiment is represented by formula (1).

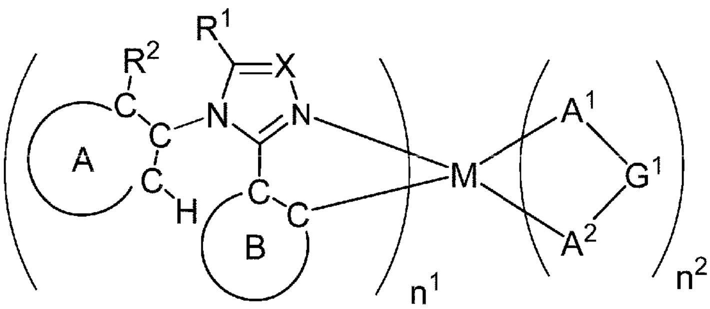

(1)

In a group represented by =C($R^X$)- that X denotes, $R^X$ is preferably a hydrogen atom, an alkyl group, a cycloalkyl group, an aryl group, a monovalent heterocyclic group, or a substituted amino group, more preferably a hydrogen atom, an alkyl group, or an aryl group, and more preferably a hydrogen atom or an alkyl group.

X is preferably a nitrogen atom.

The metal complex represented by formula (1) contains M (a rhodium atom, a palladium atom, an iridium atom, or a platinum atom), a ligand whose number is defined by the suffix $n^1$, and a ligand whose number is defined by the suffix $n^2$.

M is preferably a platinum atom or an iridium atom, and more preferably an iridium atom, because the luminescence stability of the metal complex is excellent.

When M is a rhodium atom or an iridium atom, $n^1$ is preferably 2 or 3, and more preferably 3. Moreover, when M is a palladium atom or a platinum atom, $n^1$ is preferably 2.

The number of carbon atoms in the alkyl group represented by $R^1$ is preferably 7 or more, not including the number of carbon atoms of the substituent, because the luminescence stability of the metal complex is excellent.

The number of carbon atoms in the alkyl group represented by $R^1$ is preferably 20 or less, more preferably 15 or less, further preferably 10 or less, not including the carbon atoms of the substituent, because synthesis is easy,

The number of carbon atoms in the alkyl group represented by $R^1$ is, for example, preferably 7 or more and 10 or less, not including the carbon atoms of the substituent, because the luminescence stability of the metal complex is excellent and synthesis is easy.

The substituent that $R^1$ may have is an alkoxy group, a cycloalkyl group, a cycloalkoxy group, an aryl group, a monovalent heterocyclic group, a substituted amino group, or a halogen atom, more preferably a cycloalkyl group, an aryl group, a monovalent heterocyclic group, or a substituted amino group, further preferably a cycloalkyl group or an aryl group, particularly preferably a cycloalkyl group, because the luminescence stability of the metal complex is excellent. Moreover, $R^1$ is preferably an alkyl group that has no substituent.

In the present embodiment, it is considered to contribute to the excellent luminescence stability of the metal complex that the ring A and the triazole ring are in a twisted position due to the steric hindrance of $R^1$ and $R^2$.

In $R^1$, the number of hydrogen atoms attached to the carbon atoms directly bonded to the triazole ring is preferably 0 or 1, and more preferably 0, because the luminescence stability of the metal complex is excellent.

$R^1$ is preferably a secondary alkyl group or a tertiary alkyl group, and more preferably a tertiary alkyl group, because the luminescence stability of the metal complex is excellent, and these groups may have a substituent. Examples of the secondary alkyl group include a group represented by formula (2) described later in which $n^3$ is 2 and $n^5$ is 1. Examples of the tertiary alkyl group include a group represented by formula (2) described later in which $n^3$ is 3.

At least one of $R^1$ is preferably a group represented by formula (2), because the luminescence stability of the metal complex is excellent.

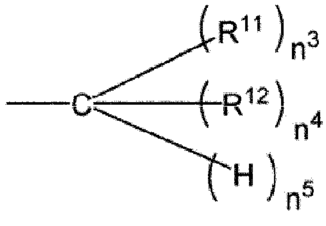

(2)

A substituent that $R^{11}$ may have is an alkoxy group, a cycloalkyl group, a cycloalkoxy group, an aryl group, a monovalent heterocyclic group, a substituted amino group, or a halogen atom, more preferably a cycloalkyl group, an aryl group, a monovalent heterocyclic group, or a substituted amino group, further preferably a cycloalkyl group or an aryl group, and particularly preferably a cycloalkyl group, because the luminescence stability of the metal complex is excellent. $R^{11}$ is particularly preferably an alkyl group having no substituent.

$R^{12}$ is preferably a cycloalkyl group, an aryl group, a monovalent heterocyclic group, or a substituted amino group, more preferably a cycloalkyl group or an aryl group, further preferably a cycloalkyl group, because the luminescence stability of the metal complex is excellent, and these groups may have a substituent.

A substituent that the $R^{12}$ may have is an alkyl group, a cycloalkyl group, an alkoxy group, a cycloalkoxy group, an aryl group, a monovalent heterocyclic group, a substituted amino group, or a halogen atom; more preferably an alkyl group, a cycloalkyl group, an aryl group, a monovalent heterocyclic group, or a substituted amino group, further preferably an alkyl group, a cycloalkyl group, or an aryl group, and particularly preferably an alkyl group or a cycloalkyl group.

$n^3$ is preferably 2 or 3, and more preferably 3 because the luminescence stability of the metal complex is excellent.

$n^4$ is preferably 0 or 1 and preferably 0, because the luminescence stability of the metal complex is excellent.

$n^5$ is preferably 0, because the luminescence stability of the metal complex is excellent.

Preferred examples of the group represented by formula (2) include groups represented by formulas (1-03) to (1-7) and (1-09) to (I-21).

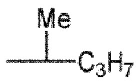
(I-03)

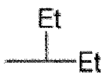
(I-04)

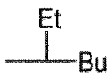
(I-05)

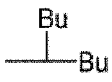
(I-06)

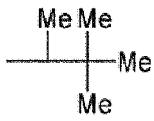
(I-07)

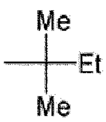
(I-09)

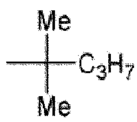
(I-10)

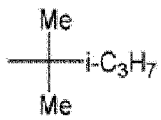
(I-11)

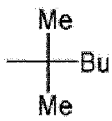
(I-12)

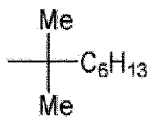
(I-13)

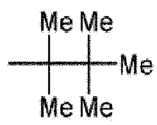
(I-14)

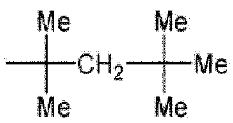
(I-15)

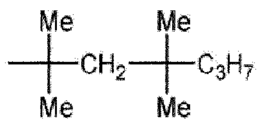
(I-16)

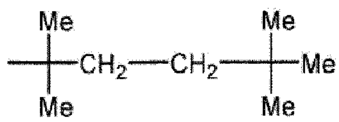
(I-17)

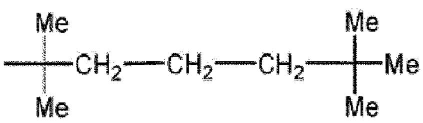
(I-18)

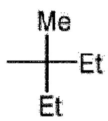
(I-19)

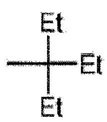
(I-20)

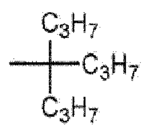
(I-21)

Among those described above, preferred examples of the group represented by formula (2) are the groups represented by formula (1-09), formula (I-10), formula (1-12), formula (1-13), formula (1-14), formula (1-15), formula (1-20), or formula (1-21), and more preferred examples are the groups represented by formula (1-12), formula (1-14), or formula (I-15).

$R^2$ is preferably an alkyl group, a cycloalkyl group, an alkoxy group, a cycloalkoxy group, an aryl group, a monovalent heterocyclic group, or a substituted amino group, more preferably an alkyl group, a cycloalkyl group, an aryl group, a monovalent heterocyclic group, or a substituted amino group, further preferably an alkyl group, a cycloalkyl group, or an aryl group, and particularly preferably an alkyl group, because the luminescence stability of the metal complex is excellent, and these groups may have a substituent. $R^2$ is particularly preferably an alkyl group having no substituent.

Examples and preferable ranges of the substituent that $R^2$ may have are the same as the examples and preferable ranges of the substituent that $R^{12}$ may have as described above.

If $R^1$ is a tertiary alkyl group, then the emission wavelength of the metal complex will be short and therefore, $R^2$ is preferably an alkyl group, a cycloalkyl group, or an aryl group, and these groups may have a substituent.

If $R^1$ is a secondary alkyl group, then the emission wavelength of the metal complex will be short and therefore, $R^2$ is preferably an alkyl group, a cycloalkyl group, or an aryl group, and more preferably a secondary alkyl group, a tertiary alkyl group, a cycloalkyl group, or an aryl group, and these groups may have a substituent.

The number of carbon atoms in the alkyl group represented by $R^2$ is preferably 6 or less and more preferably 4 or less, not including the carbon atoms of the substituent, because synthesis is easy.

If $R^1$ is a tertiary alkyl group, then the number of carbon atoms in the alkyl group represented by $R^2$ may be 1 or more, not including the carbon atoms of the substituent.

If $R^1$ is a secondary alkyl group, the number of carbon atoms in the alkyl group represented by $R^2$ is preferably 3 or more, not including the carbon atoms of the substituent.

The number of carbon atoms in the cycloalkyl group represented by $R^2$ is preferably 5 or more, and more preferably 6 or more, not including the carbon atoms of the substituent. Moreover, the number of carbon atoms in the cycloalkyl group represented by $R^2$ is preferably 10 or less, not including the carbon atoms of the substituent.

The number of carbon atoms in the aryl group represented by $R^2$ is preferably 6 or more, not including the carbon atoms of the substituent. The aryl group represented by $R^2$ is particularly preferably a phenyl group that may have a substituent.

Preferred examples of $R^2$ include groups represented by formulas (II-01) to (II-14).

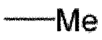 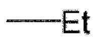 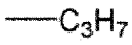 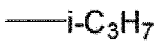 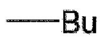 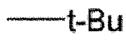

(II-01) (II-02) (II-03) (II-04) (II-05) (II-06)

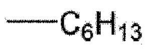 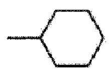 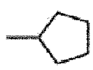 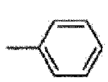 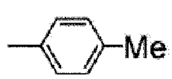 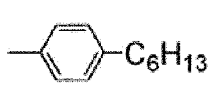

(II-07) (II-08) (II-09) (II-10) (II-11) (II-12)

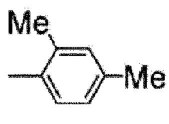 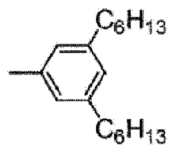

(II-13) (II-14)

Among those described above, preferred examples of $R^2$ are groups represented by formula (II-01), formula (II-02), formula (II-03), formula (II-04), formula (II-05), formula (II-06), formula (II-07), formula (II-08), or formula (II-10); more preferred examples are groups represented by formula (II-01), formula (II-02), formula (II-04), formula (II-06), or formula (II-10), and further preferred examples are groups represented by formula (II-01), formula (II-02), formula (II-04), or formula (II-06).

In the ring A, the ring having $R^2$ as a substituent is preferably a 6-membered aromatic hydrocarbon ring or a 6-membered aromatic heterocyclic ring, more preferably a 6-membered aromatic hydrocarbon ring, and these rings may have a substituent.

The ring A is preferably a monocyclic aromatic hydrocarbon ring, an aromatic hydrocarbon ring having a condensed ring, a monocyclic aromatic heterocyclic ring, or an aromatic heterocyclic ring having a condensed ring, more preferably a monocyclic aromatic hydrocarbon ring, an aromatic hydrocarbon ring having a condensed ring, or an aromatic heterocyclic ring having a condensed ring, and further preferably a monocyclic aromatic hydrocarbon ring or an aromatic hydrocarbon ring having a condensed ring, and particularly preferably a monocyclic aromatic hydrocarbon ring, and these rings may have a substituent.

A preferred example of the monocyclic aromatic hydrocarbon ring represented by ring A is a benzene ring that may have a substituent. Preferred examples of the aromatic hydrocarbon ring having a condensed ring represented by ring A are a naphthalene ring, a fluorene ring, an indene ring, and a phenanthrene ring, more preferred examples are a fluorene ring and a phenanthrene ring, and a further preferred example is a fluorene ring, and these rings may have a substituent.

Preferred examples of the monocyclic aromatic heterocyclic ring represented by ring A are a pyridine ring, a diazabenzene ring, and a triazine ring, and these rings may have a substituent. Preferred examples of the aromatic heterocyclic ring having a condensed ring represented by ring A are a dibenzofuran ring, a dibenzothiophene ring, and a carbazole ring, and these rings may have a substituent.

A substituent other than $R^2$ that ring A may have is an alkyl group, a cycloalkyl group, an aryl group, a monovalent

heterocyclic group, or a substituted amino group, more preferably an alkyl group, a cycloalkyl group, an aryl group, or a monovalent heterocyclic group, further preferably an alkyl group, a cycloalkyl group, or an aryl group, and particularly preferably an alkyl group or an aryl group, because the luminescence stability of the metal complex is excellent.

Examples of the ring A include structures represented by formulas (L-1) to (L-16). Among these, preferred examples of the ring A are structures represented by formulas (L-1) to (L-10), more preferred examples are structures represented by formulas (L-1) to (L-6), and particularly preferred examples are structures represented by formula (L-1) or (L-2). Here, the bond represents the bonding with the nitrogen atom at the adjacent position.

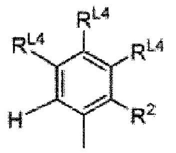
(L-1)

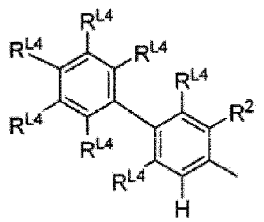
(L-2)

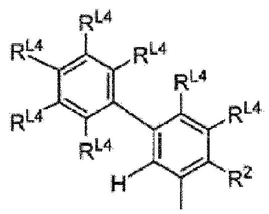
(L-3)

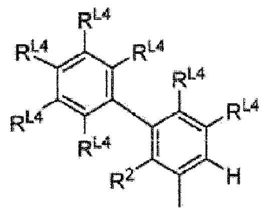
(L-4)

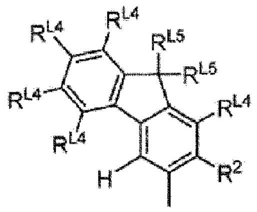
(L-5)

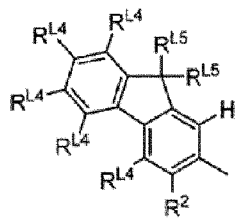
(L-6)

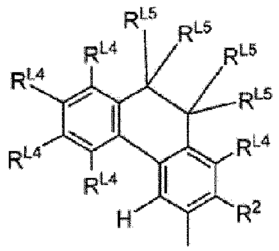
(L-7)

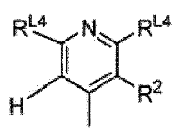
(L-8)

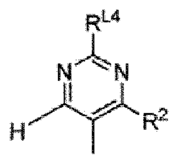
(L-9)

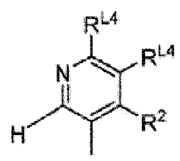
(L-10)

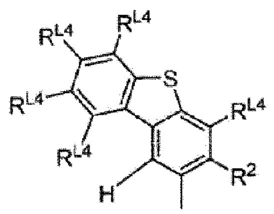
(L-11)

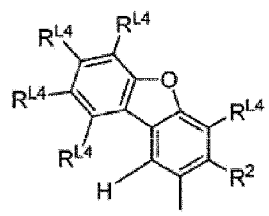
(L-12)

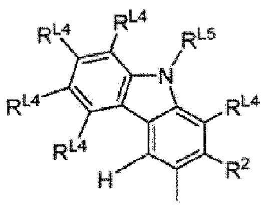
(L-13)

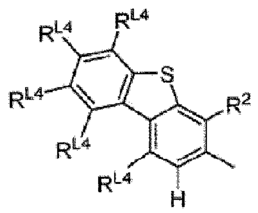
(L-14)

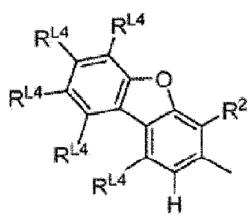
(L-15)

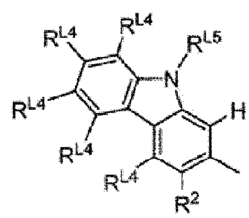
(L-16)

In the formulas,

$R^{L4}$ represents a hydrogen atom, an alkyl group, a cycloalkyl group, an aryl group, a monovalent heterocyclic group, or a substituted amino group, and these groups may have a substituent. When there are a plurality of $R^{L4}$, they may be the same or different and adjacent $R^{L4}$ may be bonded to each other to form a ring together with the carbon atoms to which they are bonded.

$R^{L5}$ represents an alkyl group, a cycloalkyl group, an aryl group, a monovalent heterocyclic group, or a substituted amino group, and these groups may have a substituent. When there are a plurality of $R^{L5}$, they may be the same or different and bonded to each other to form a ring together with the carbon atoms to which they are bonded.

$R^{L4}$ is preferably a hydrogen atom, an alkyl group, a cycloalkyl group, an aryl group, or a monovalent heterocyclic

group, preferably a hydrogen atom, an alkyl group, a cycloalkyl group, or an aryl group, and preferably a hydrogen atom, an alkyl group, or a cycloalkyl group, and these groups may have a substituent. Preferred examples of the alkyl group or cycloalkyl group represented by $R^{L4}$ are groups represented by formulas (III-01) to (III-10).

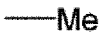
(III-01)
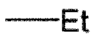
(III-02)
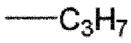
(III-03)
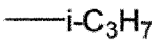
(III-04)
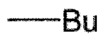
(III-05)
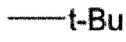
(III-06)

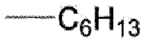
(III-07)
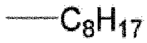
(III-08)
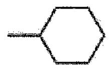
(III-09)
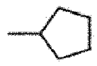
(III-10)

$R^{L5}$ is preferably an alkyl group, a cycloalkyl group, an aryl group, or a monovalent heterocyclic group, more preferably an alkyl group, a cycloalkyl group, or an aryl group, and further preferably an aryl group, and these groups may have a substituent. Preferred examples of the aryl group represented by $R^{L5}$ are groups represented by formulas (IV-01) to (IV-09).

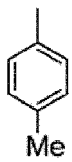
(IV-01)
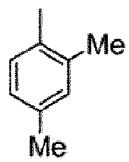
(IV-02)
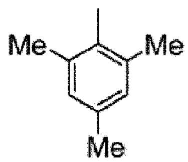
(IV-03)
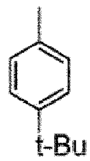
(IV-04)
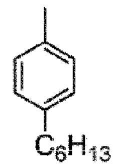
(IV-05)

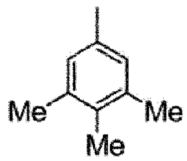
(IV-06)
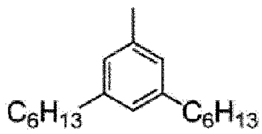
(IV-07)
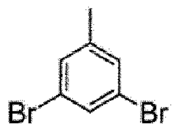
(IV-08)
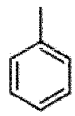
(IV-09)

In the ring B, the ring that is directly bonded to M is preferably a 6-membered aromatic hydrocarbon ring or a 6-membered aromatic heterocyclic ring, and more preferably a 6-membered aromatic hydrocarbon ring, and these rings may have a substituent.

The ring B is preferably a monocyclic aromatic hydrocarbon ring, an aromatic hydrocarbon ring having a condensed ring, a monocyclic aromatic heterocyclic ring, or an aromatic heterocyclic ring having a condensed ring, more preferably a monocyclic aromatic hydrocarbon ring, an aromatic hydrocarbon ring having a condensed ring, or an aromatic heterocyclic ring having a condensed ring, and further preferably a monocyclic aromatic hydrocarbon ring or an aromatic hydrocarbon ring having a condensed ring, and particularly preferably a monocyclic aromatic hydrocarbon ring, and these rings may have a substituent.

Examples of the ring B include a benzene ring, a naphthalene ring, a fluorene ring, an indene ring, a phenanthrene ring, a dibenzofuran ring, a dibenzothiophene ring, a carbazole ring, a pyridine ring, a diazabenzene ring, and a triazine ring. Examples of the ring B include a benzene ring, a fluorene ring, an indene ring, a phenanthrene ring, a dibenzofuran ring, a dibenzothiophene ring, a carbazole ring, a pyridine ring, a diazabenzene ring, and a triazine ring, more preferably a benzene ring, a fluorene ring, a phenanthrene ring, a dibenzofuran ring, a dibenzothiophene ring, a carbazole ring, a pyridine ring, a diazabenzene ring, or a triazine ring, further preferably a benzene ring, a fluorene ring, a dibenzofuran ring, a dibenzothiophene ring, a carbazole ring, a pyridine ring, or a pyrimidine ring, particularly preferably a benzene ring, a fluorene ring, a dibenzofuran ring, or a dibenzothiophene ring, and more particularly preferably a benzene ring. These rings may have a substituent.

A substituent that ring B may have is an alkyl group, a cycloalkyl group, an aryl group, a monovalent heterocyclic group, a substituted amino group, or a halogen atom, more preferably an alkyl group, a cycloalkyl group, an aryl group, a monovalent heterocyclic group, or a substituted amino group, further preferably an alkyl group, a cycloalkyl group, an

aryl group, or a monovalent heterocyclic group, particularly preferably an alkyl group, a cycloalkyl group, or an aryl group, and more particularly preferably an alkyl group or an aryl group, because the luminescence stability of the metal complex is excellent.

The metal complex represented by formula (1) is preferably a metal complex represented by formula (1a), because the luminescence stability of the metal complex is excellent.

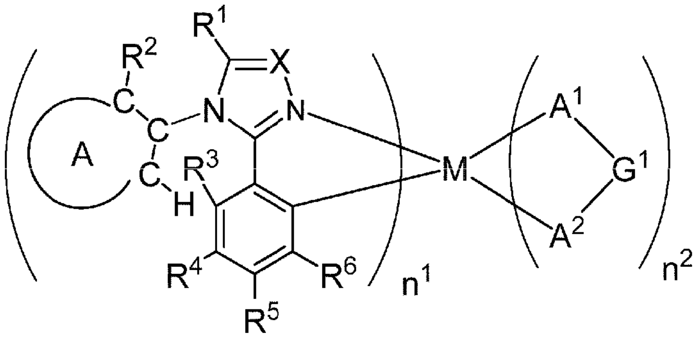
(1a)

$R^3$ and $R^6$ are preferably a hydrogen atom, an alkyl group, a cycloalkyl group, an aryl group, a monovalent heterocyclic group, a substituted amino group, or a halogen atom, more preferably a hydrogen atom, an alkyl group, a cycloalkyl group, an aryl group, or a monovalent heterocyclic group, further preferably a hydrogen atom, an alkyl group, or an aryl group, and particularly preferably a hydrogen atom, because the synthesis of the metal complex becomes easy, and these groups may have a substituent.

$R^4$ and $R^5$ are preferably a hydrogen atom, an alkyl group, a cycloalkyl group, an aryl group, a monovalent heterocyclic group, a substituted amino group, or a halogen atom, more preferably a hydrogen atom, an alkyl group, a cycloalkyl group, an aryl group, a monovalent heterocyclic group, or a substituted amino group, further preferably a hydrogen atom, an alkyl group, a cycloalkyl group, an aryl group, or a monovalent heterocyclic group, particularly preferably a hydrogen atom, an alkyl group, a cycloalkyl group, or an aryl group, and more particularly preferably a hydrogen atom, an alkyl group, or an aryl group, because the synthesis of the metal complex becomes easy, and these groups may have a substituent.

Examples and preferable ranges of the substituent that $R^3$, $R^4$, $R^5$, and $R^6$ may have are the same as the examples and preferable ranges of the substituent that $R^{12}$ may have as described above.

Because the luminescence stability of the metal complex is excellent, $R^4$ is preferably an aryl group, a monovalent heterocyclic group, or a substituted amino group, more preferably an aryl group or a monovalent heterocyclic group, further preferably an aryl group, and these groups may have a substituent.

Because the luminescence stability of the metal complex is excellent and the synthesis becomes easy, it is preferred that $R^4$ is an aryl group that may have a substituent and $R^5$ is a hydrogen atom or an alkyl group that may have a substituent.

Preferred examples of $R^4$ and $R^5$ include groups represented by formulas (II-01) to (II-17), a group represented by formula (D-A), and a group represented by formula (D-B).

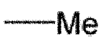
(II-01)
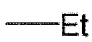
(II-02)
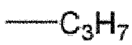
(II-03)
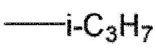
(II-04)
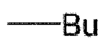
(II-05)
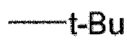
(II-06)

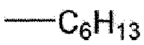
(II-07)
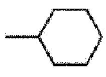
(II-08)
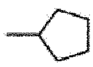
(II-09)
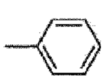
(II-10)
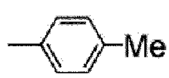
(II-11)
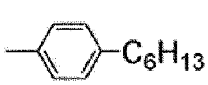
(II-12)

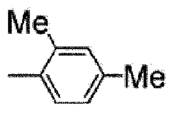
(II-13)

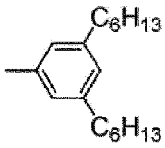
(II-14)

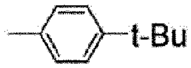
(II-15)

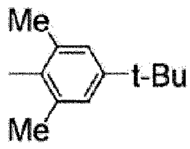
(II-16)

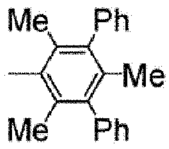
(II-17)

Preferred examples of the group represented by formula (D-A) or (D-B) in $R^4$ and $R^5$ include groups represented by formulas (II-18) to (II-25).

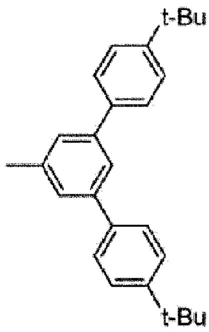
(II-18)

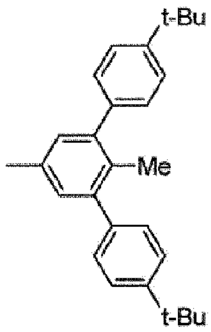
(II-19)

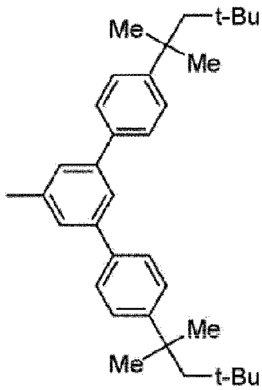
(II-20)

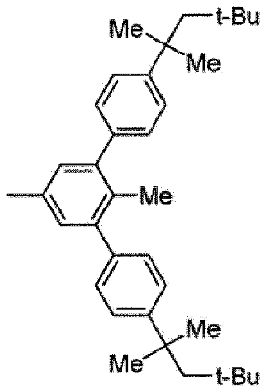
(II-21)

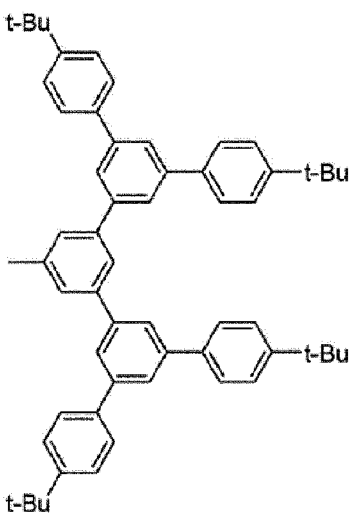
(II-22)

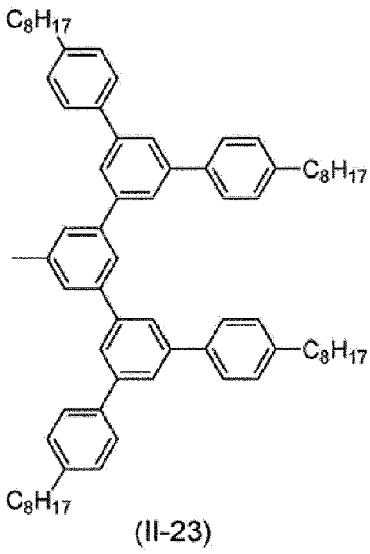
(II-23)

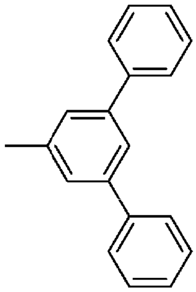

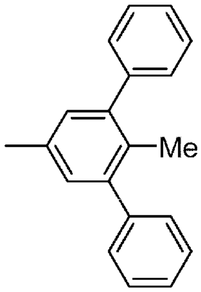

(II-24) (II-25)

Among those described above, preferable examples of $R^4$ and $R^5$ are groups represented by formula (II-01), formula (II-02), formula (II-04), formula (II-06), formula (II-10), formula (II-11), formula (II-12), formula (II-15), formula (II-16), formula (II-17), formula (II-18), formula (II-19), formula (II-21), formula (II-24), or formula (II-25) and particularly preferable examples are groups represented by formula (II-01), formula (II-02), formula (II-04), formula (II-10), formula (II-15), formula (II-16), formula (II-17), formula (II-18), formula (II-24), or formula (II-25).

In a preferred aspect, $R^3$, $R^5$, and $R^6$ may be hydrogen atoms. In this case, $R^4$ may be a hydrogen atom or a group other than a hydrogen atom.

In another preferred aspect, $R^5$ may be an alkyl group and $R^4$ may be an aryl group. In this case, $R^3$ and $R^6$ may be a hydrogen atom or a group other than a hydrogen atom.

The metal complex represented by formula (1) is preferably a metal complex represented by formula (1b), because the luminescence stability of the metal complex is excellent.

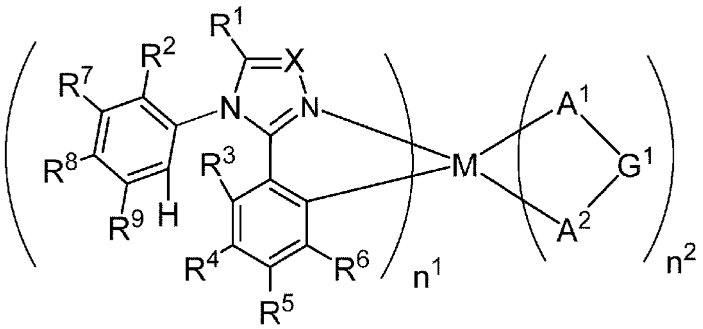

(1b)

$R^7$, $R^8$ and $R^9$ are preferably a hydrogen atom, an alkyl group, a cycloalkyl group, an aryl group, a monovalent heterocyclic group, or a substituted amino group, more preferably a hydrogen atom, an alkyl group, a cycloalkyl group, an aryl group, or a monovalent heterocyclic group, and further preferably a hydrogen atom, an alkyl group, or an aryl group, because the luminescence stability of the metal complex is excellent, and these groups may have a substituent.

Examples and preferable ranges of the substituent that $R^7$, $R^8$, and $R^9$ may have are the same as the examples and preferable ranges of the substituent that $R^{12}$ may have as described above.

Preferred examples of $R^7$, $R^8$ and $R^9$ include groups represented by formulas (II-01) to (II-17), a group represented by formula (D-A), and a group represented by formula (D-B).

Preferred examples of the group represented by formula (D-A) or (D-B) in $R^7$, $R^8$, and $R^9$ include groups represented by formulas (II-18) to (II-25).

Among those described above, preferable examples of $R^7$, $R^8$, and $R^9$ are groups represented by formula (II-01), formula (II-02), formula (II-06), formula (II-10), formula (II-11), formula (II-14), formula (II-15), formula (II-24), or formula (II-25) and particularly preferable examples are groups represented by formula (II-01), formula (II-02), formula (II-06), formula (II-10), formula (II-15), formula (II-24), or formula (II-25).

In a preferred aspect, $R^7$ may be a hydrogen atom. In this case, $R^8$ and $R^9$ may be a hydrogen atom or a group other than a hydrogen atom.

In a preferred aspect, $R^7$ and $R^9$ may be hydrogen atoms. In this case, $R^8$ may be a hydrogen atom or a group other than a hydrogen atom (preferably an alkyl group that may have a substituent or an aryl group that may have a substituent).

Examples of the anionic bidentate ligand represented by $A^1$-$G^1$-$A^2$ include ligands represented by the following

formulas.

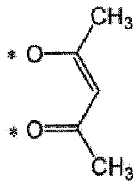 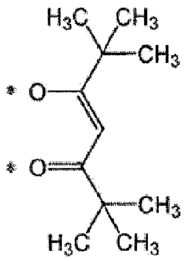 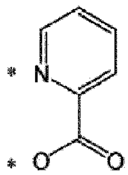 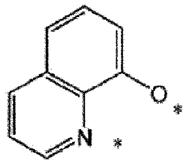 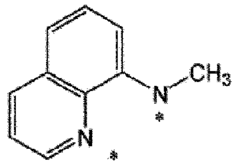

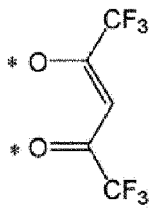 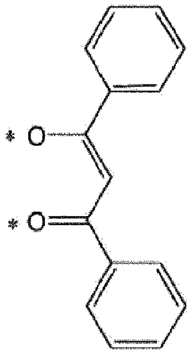 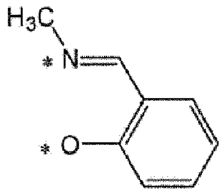 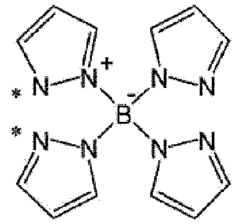

In the formulas, * represents a site that binds to M.

The anionic bidentate ligand represented by $A^1$-$G^1$-$A^2$ may be a ligand represented by the following formulas. However, the anionic bidentate ligand represented by $A^1$-$G^1$-$A^2$ is different from the ligand whose number is defined by the suffix $n^1$.

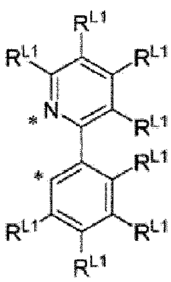 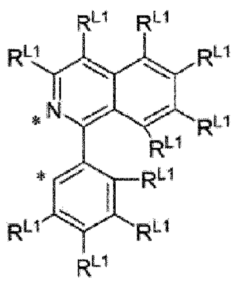 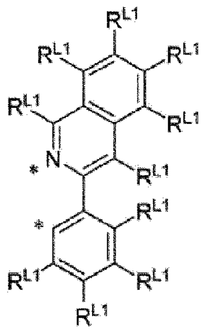 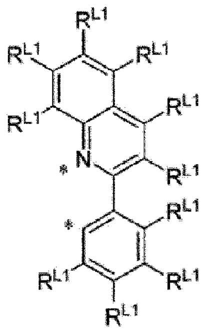

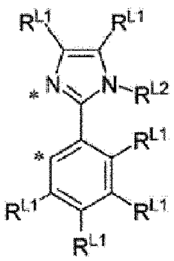 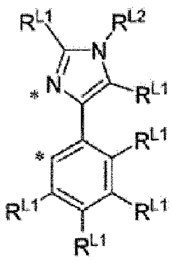 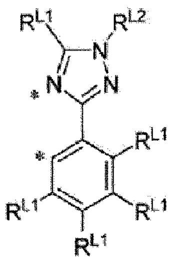 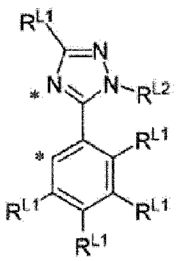 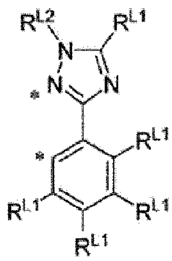 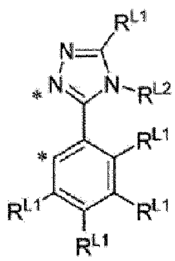

In the formula, * represents a site that binds to M,

$R^{L1}$ represents a hydrogen atom, an alkyl group, a cycloalkyl group, an aryl group, a monovalent heterocyclic group, or a halogen atom, and these groups may have a substituent. When there are a plurality of $R^{L1}$, they may be the same or different.

$R^{L2}$ represents an alkyl group, a cycloalkyl group, an aryl group, a monovalent heterocyclic group, or a halogen atom, and these groups may have a substituent.

Examples of the metal complex represented by formula (1) (X is a nitrogen atom) include the metal complexes represented by the following formulas.

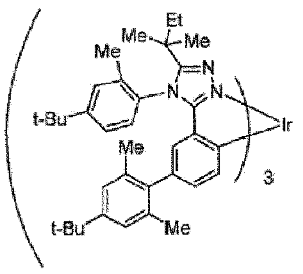
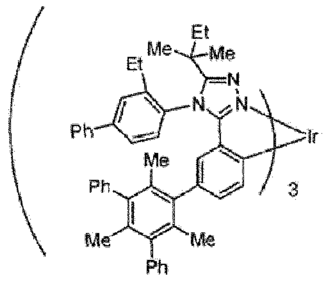
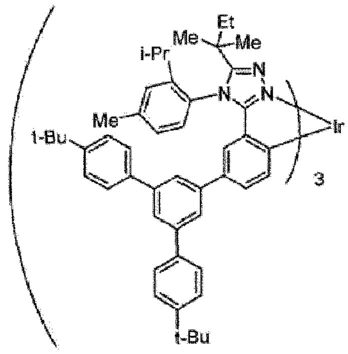

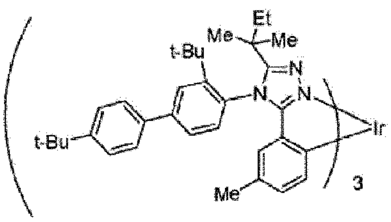
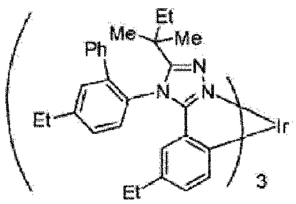
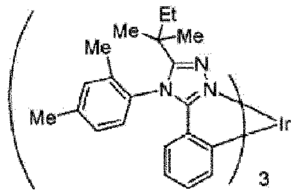

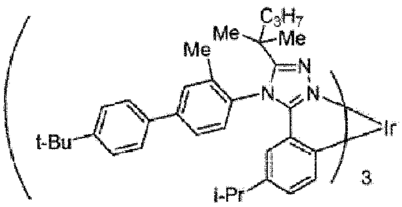
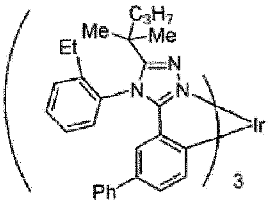
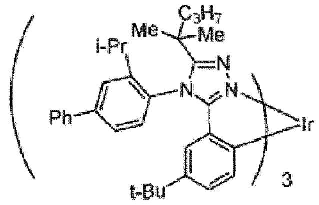

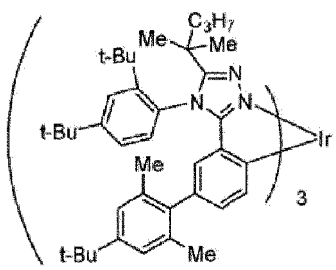
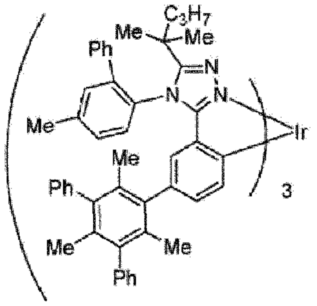

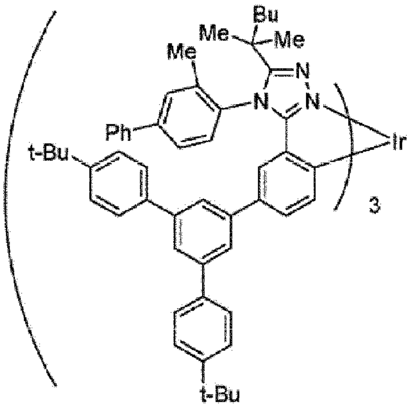

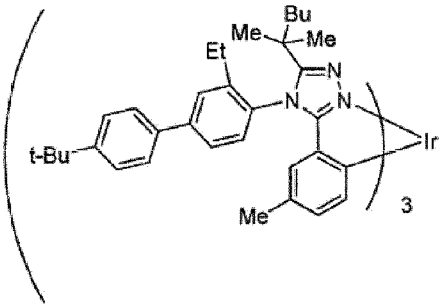

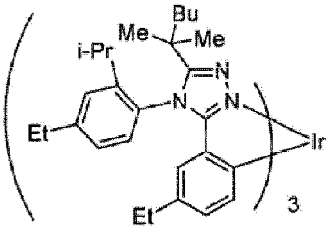

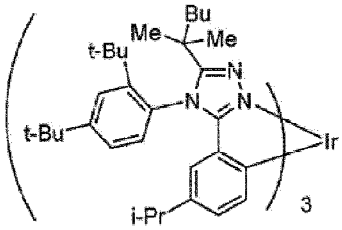

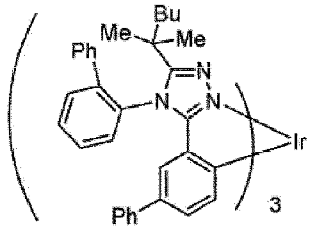

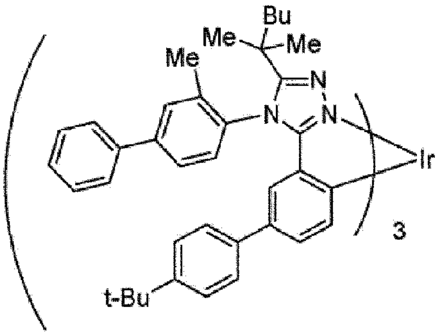

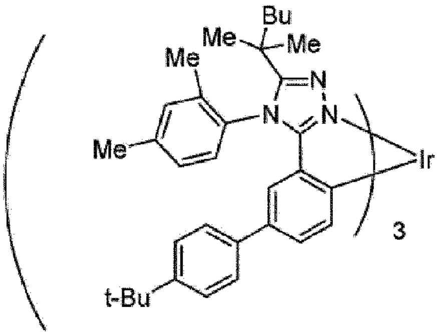

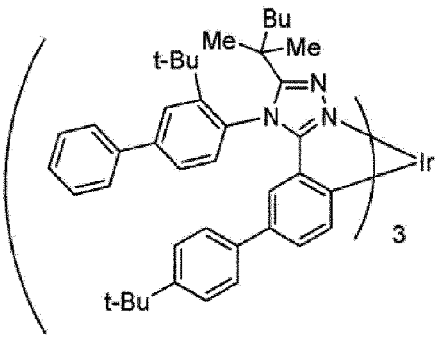

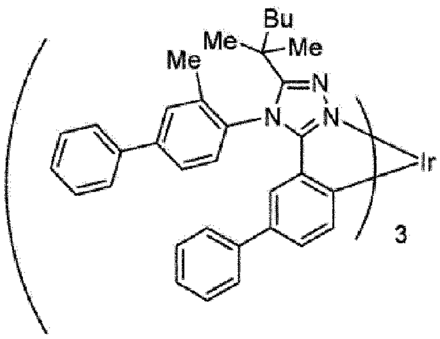

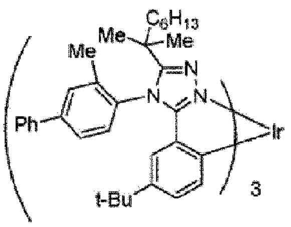

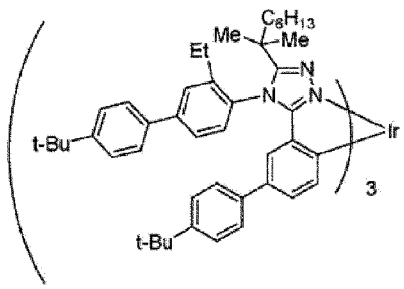

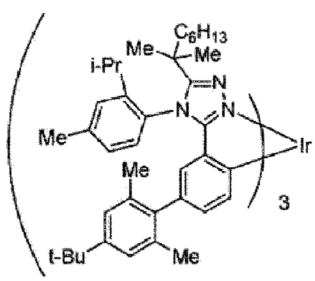

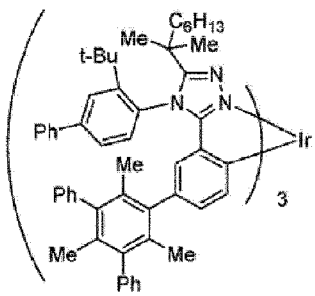

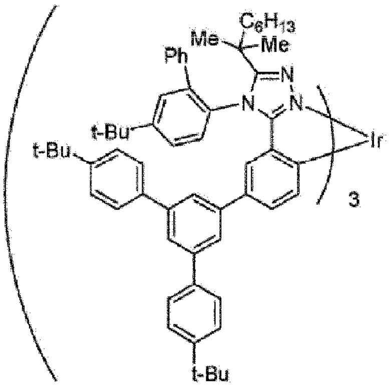

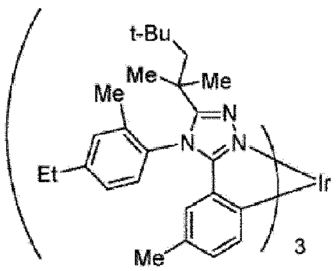

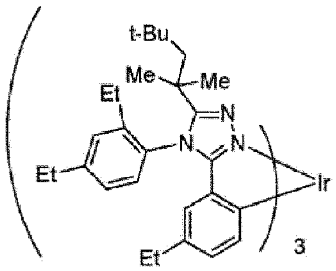

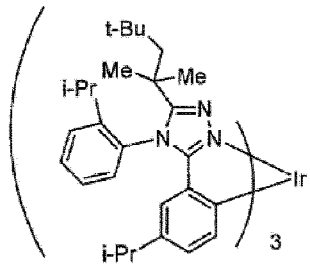

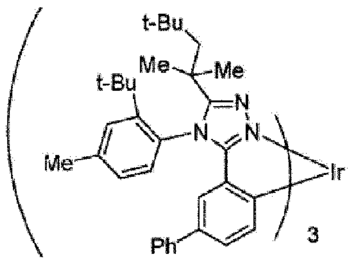

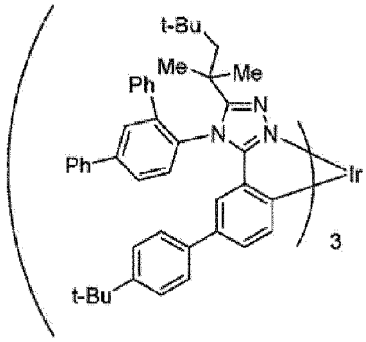

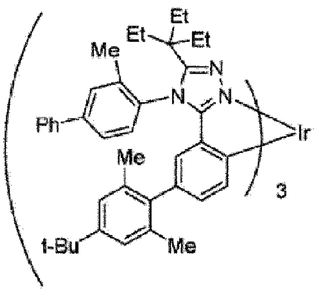

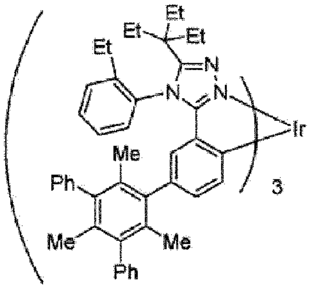

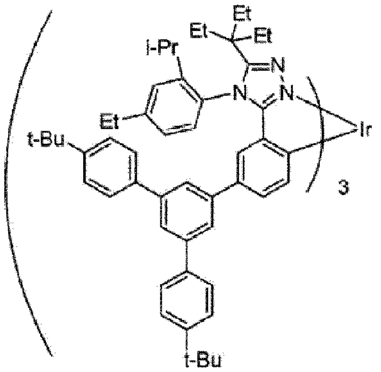

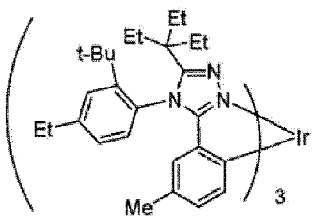

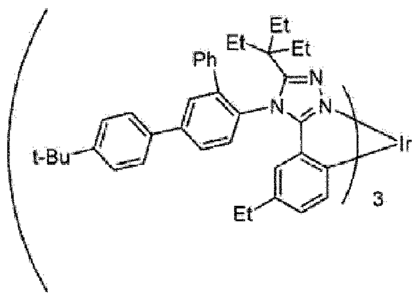

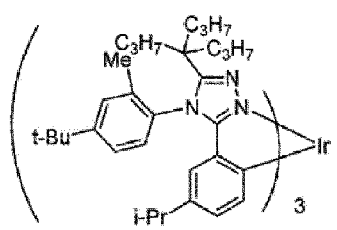

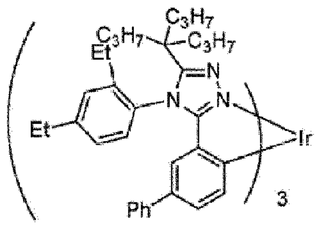

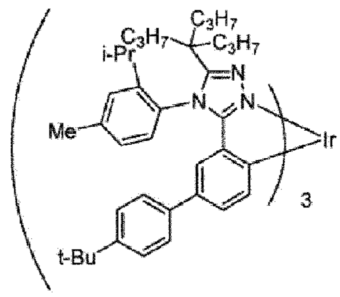

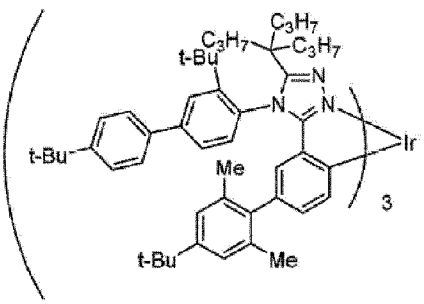

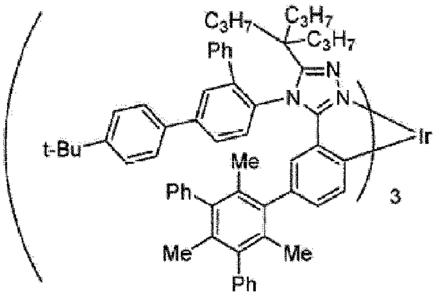

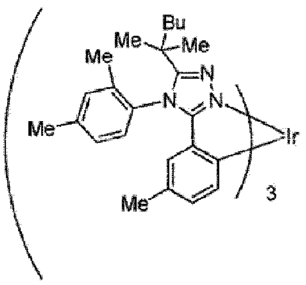

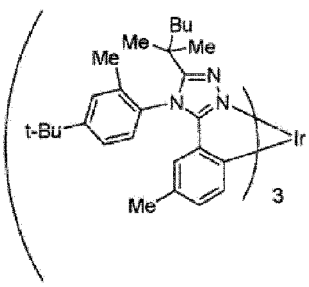

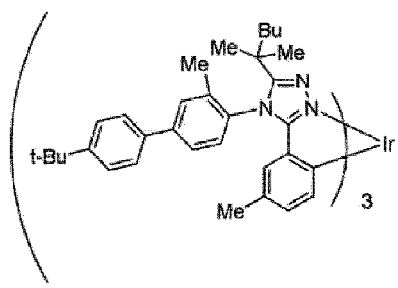

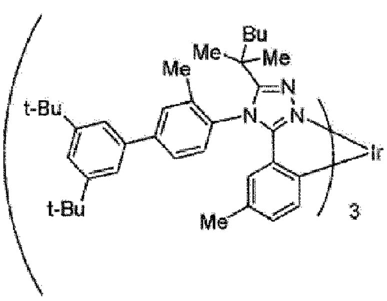

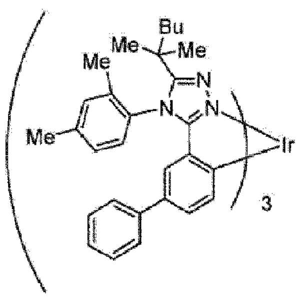

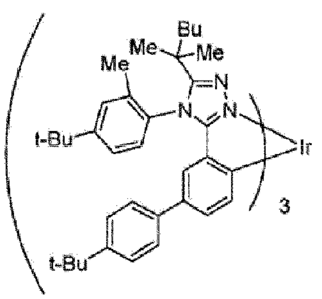

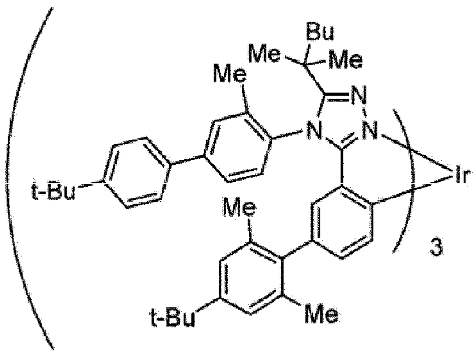

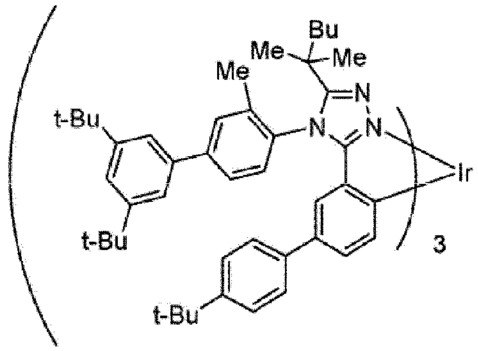

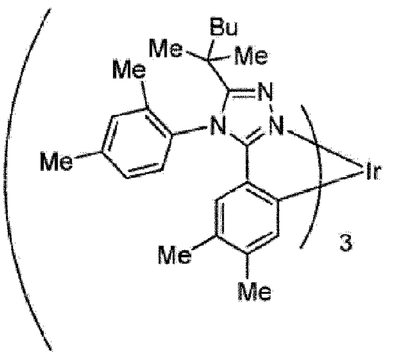

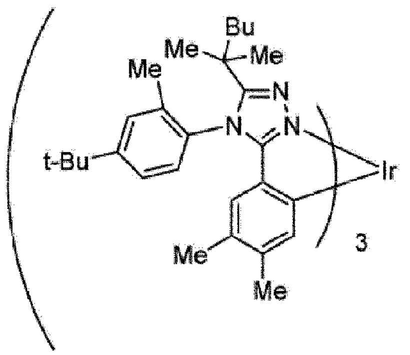

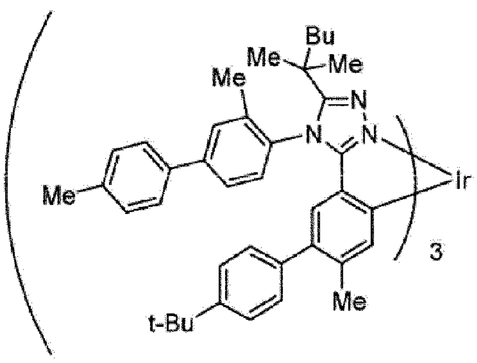

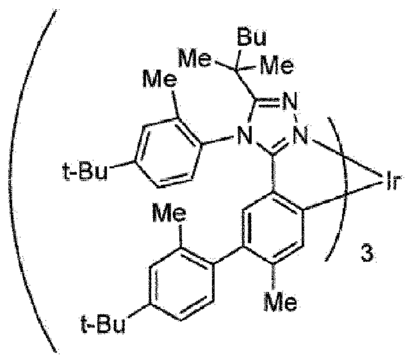

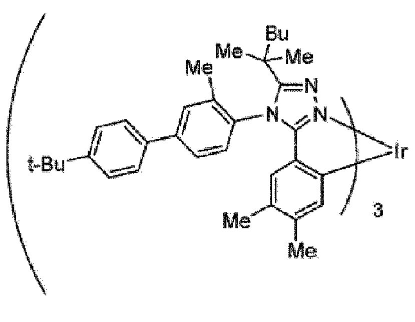

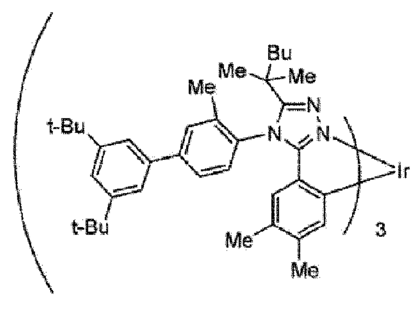

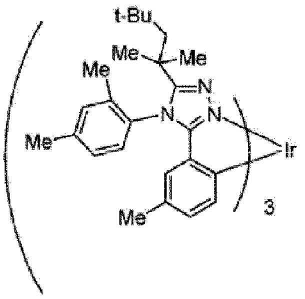
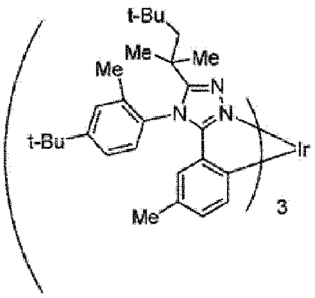
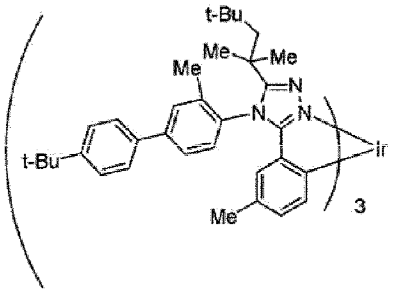

[0173]

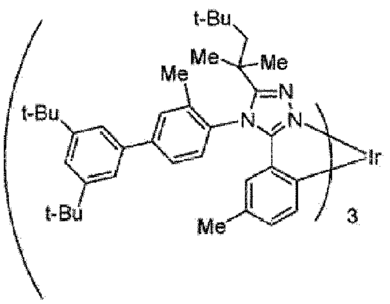
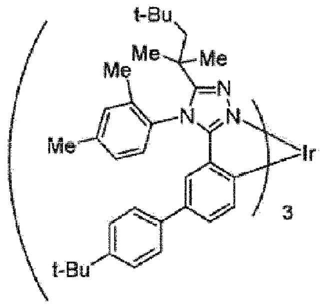
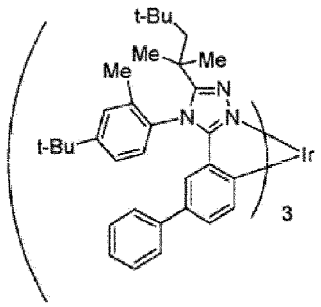

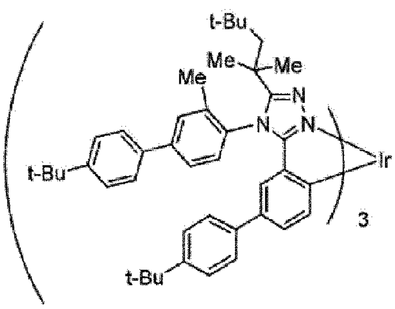
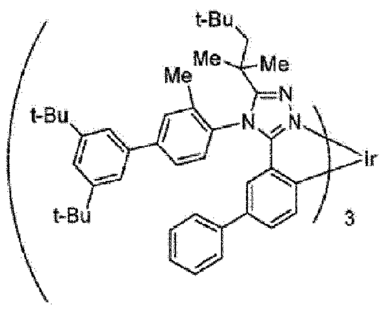

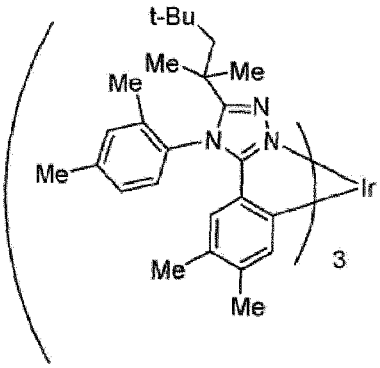
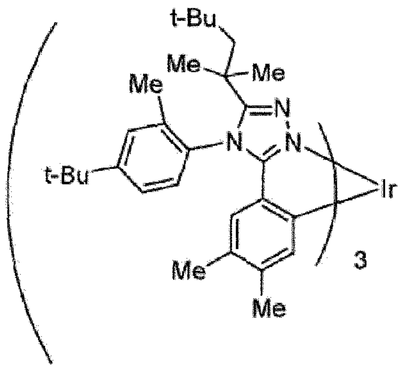

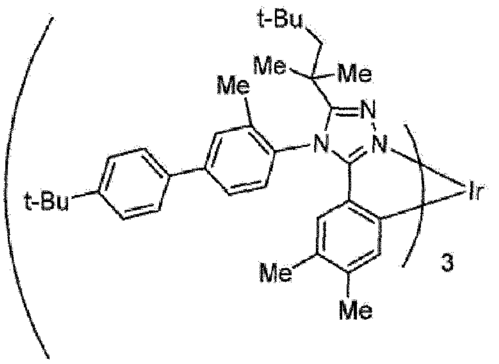
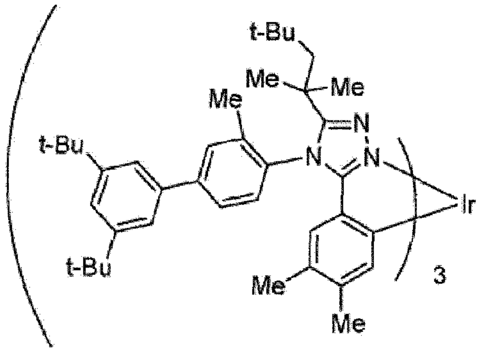
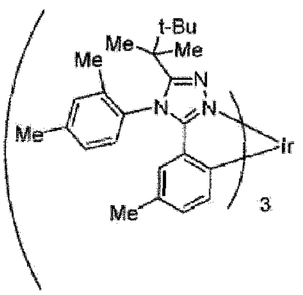
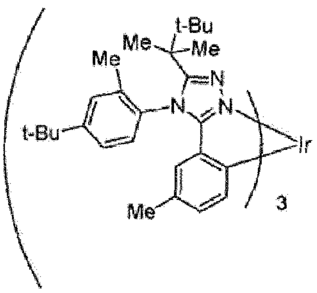
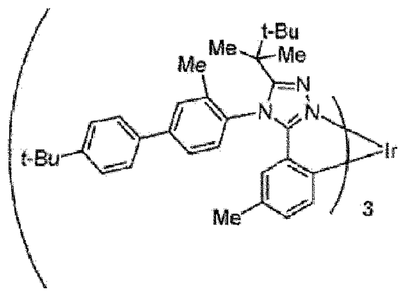
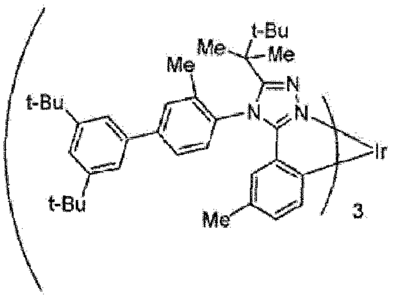
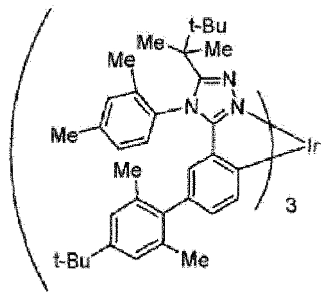
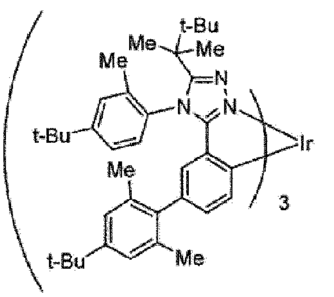
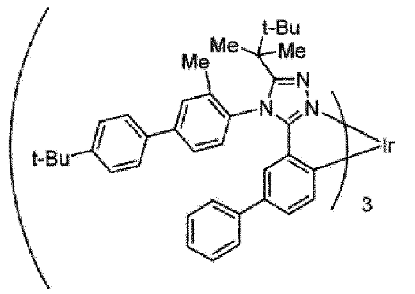
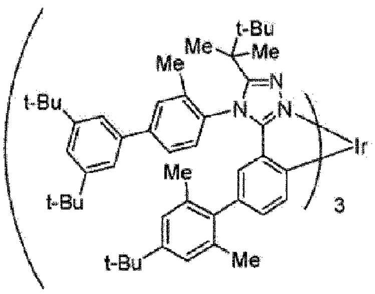
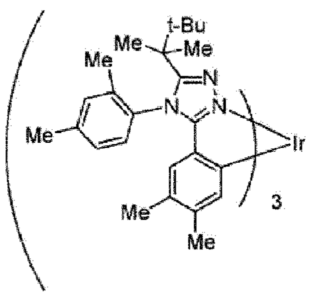
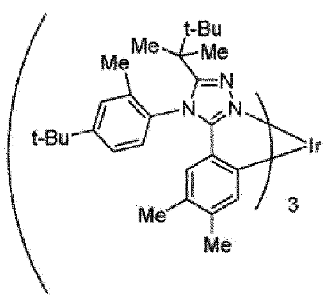

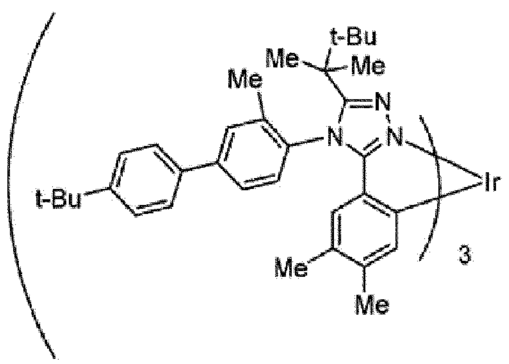

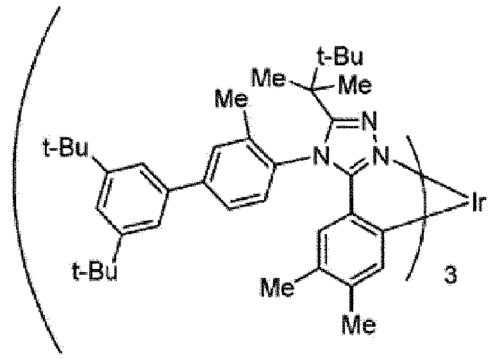

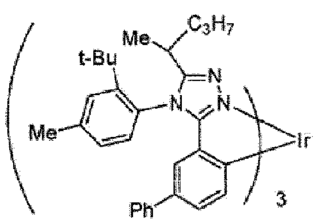

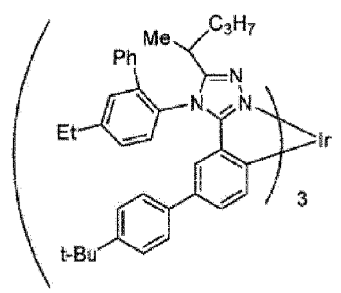

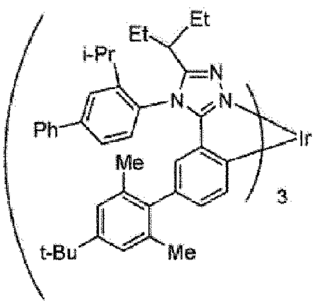

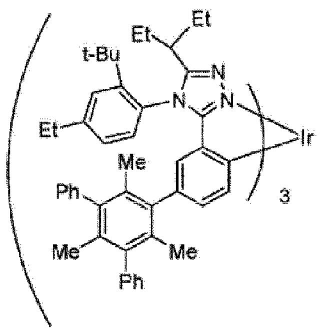

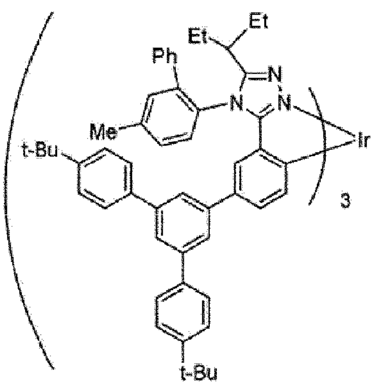

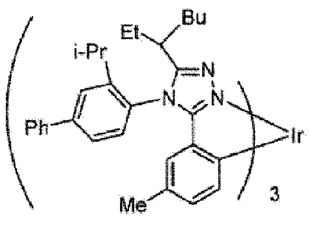

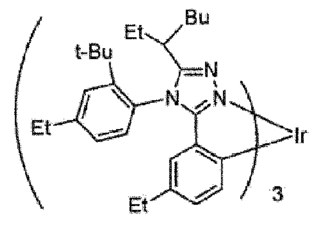

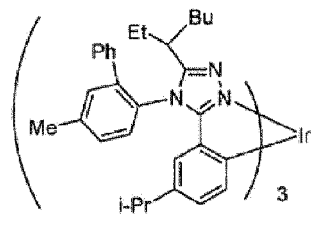

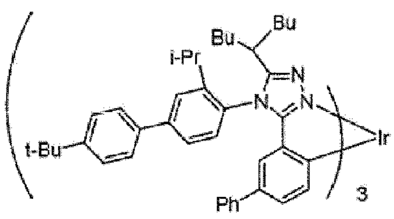

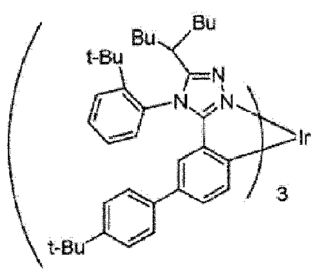

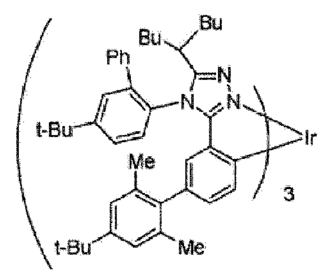

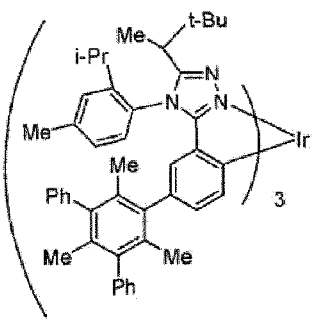

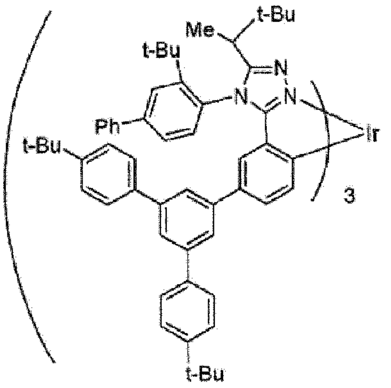

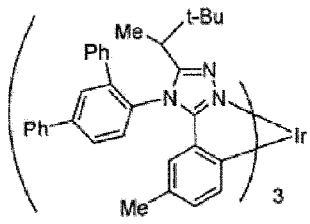

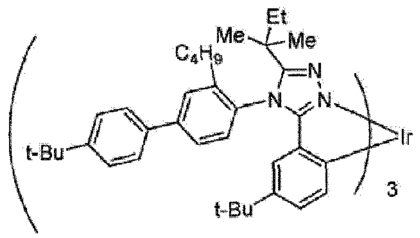

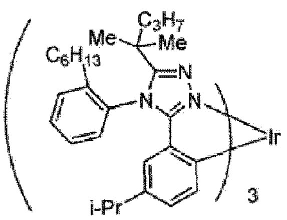

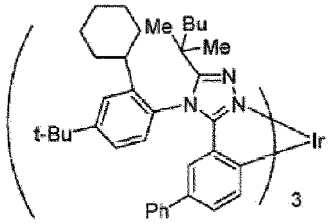

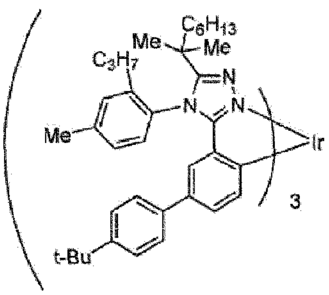

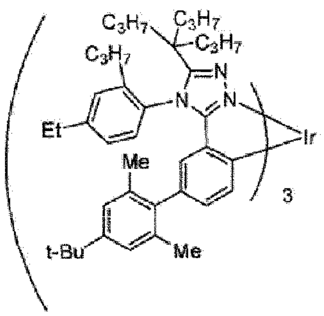

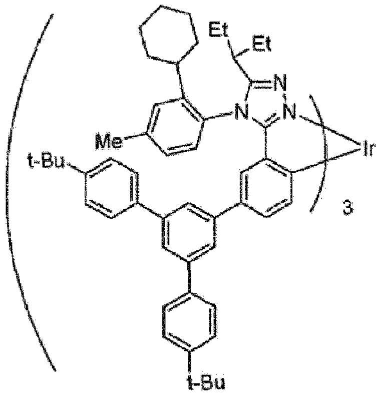

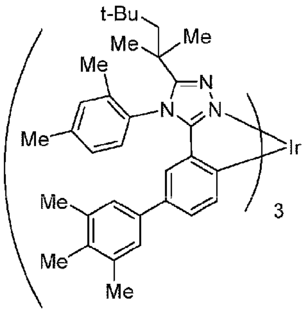

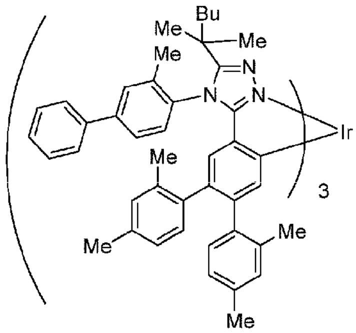

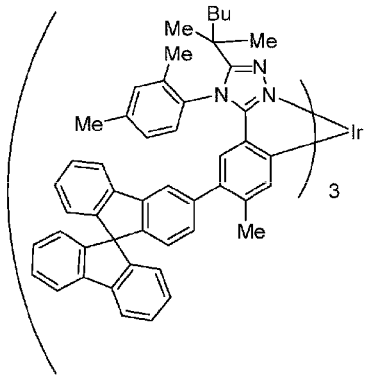

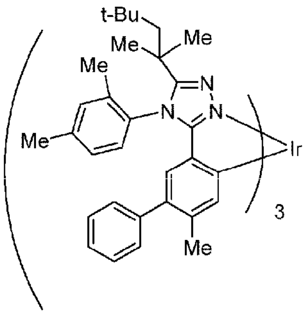

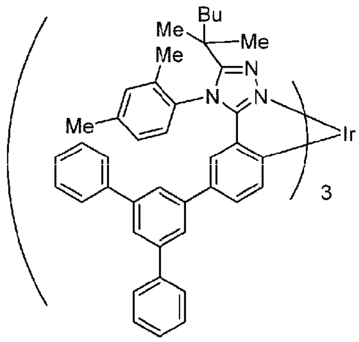

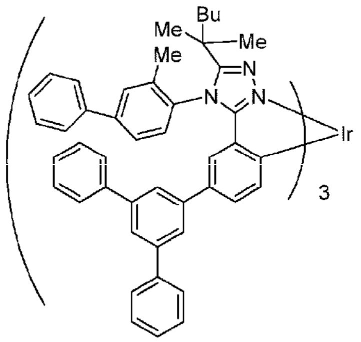

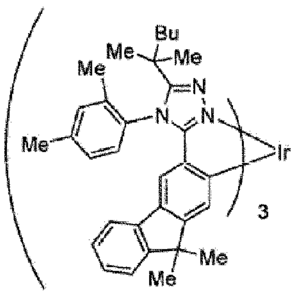

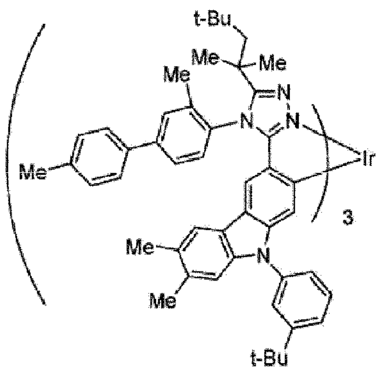

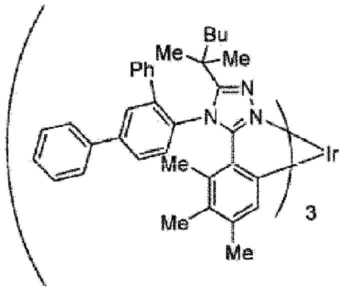

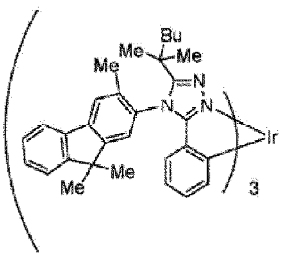

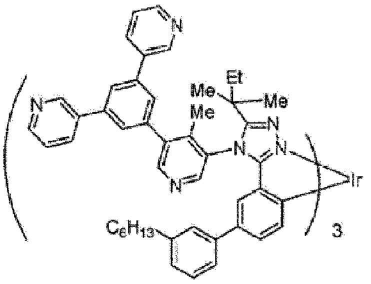

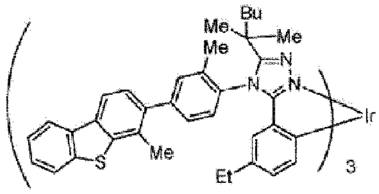

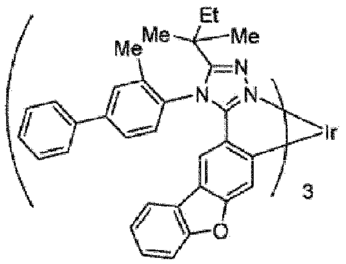
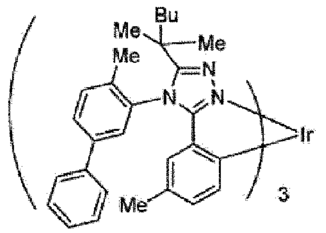
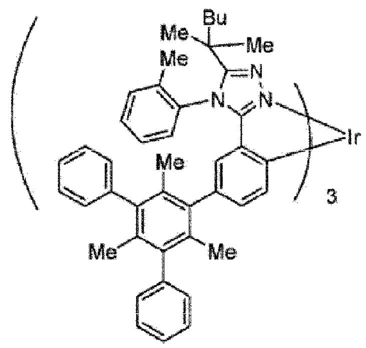

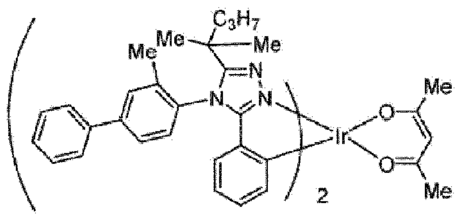
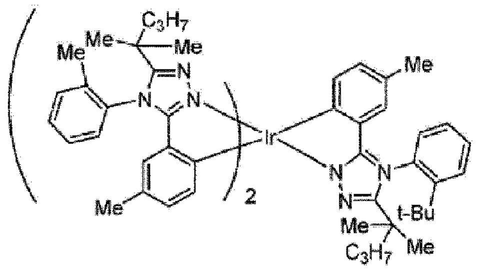

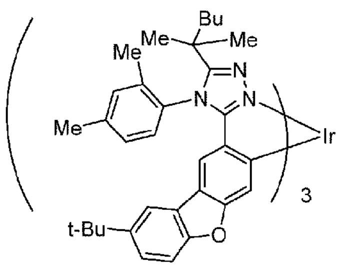
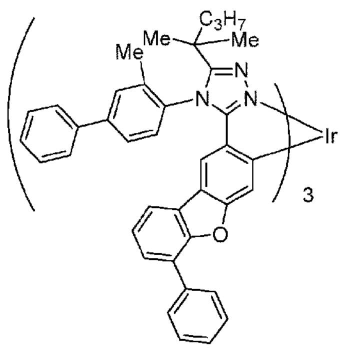
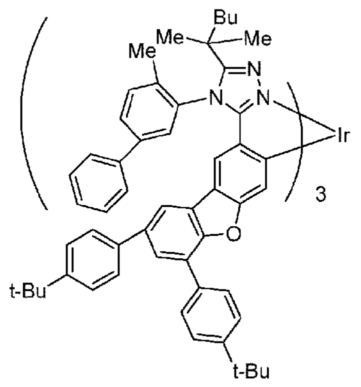

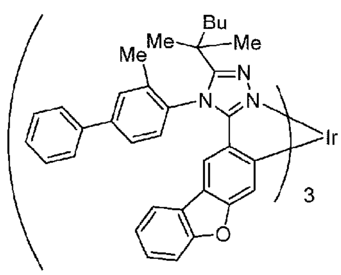
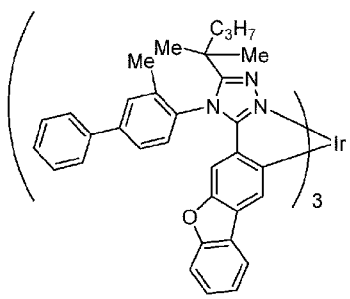
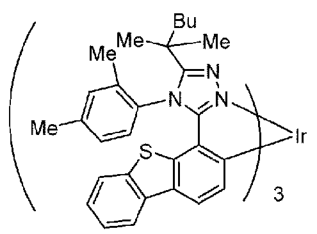

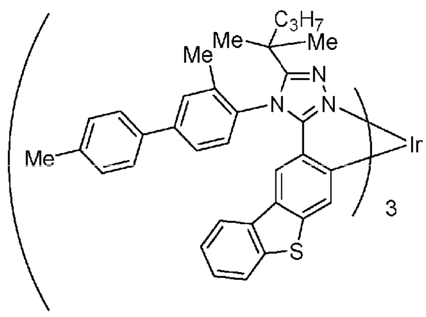

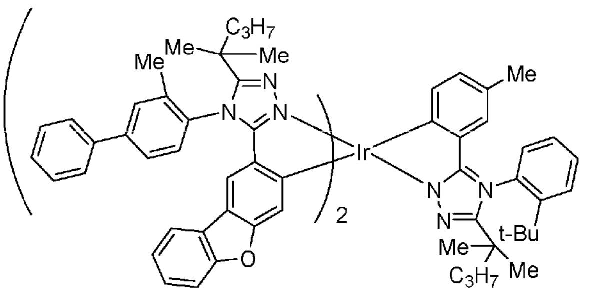

Examples of the metal complex represented by formula (1) (X is a group represented by $=C(R^X)-$) include the metal complexes represented by the following formulas.

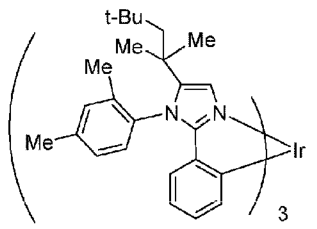

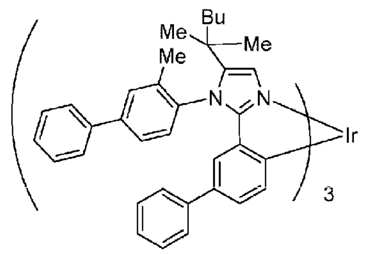

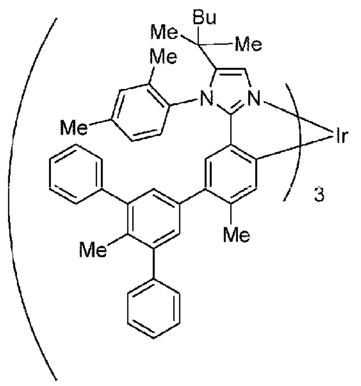

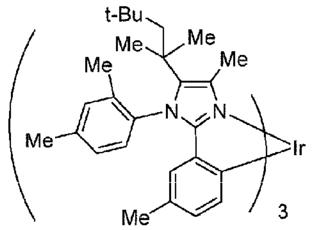

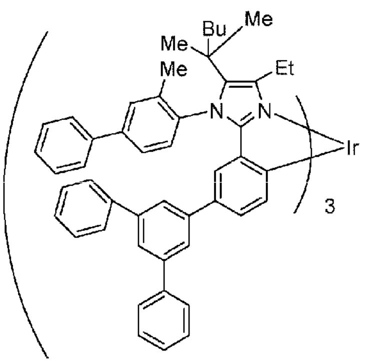

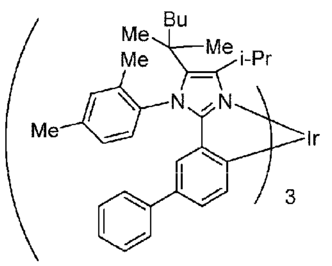

Examples of the metal complex represented by formula (1) also include a metal complex having two ligands that one of the above-mentioned metal complexes has and one ligand that another metal complex has. Moreover, examples of the metal complex represented by formula (1) also include a metal complex having one ligand that one of the above-mentioned metal complexes has, one ligand that another metal complex has, and one ligand that a further metal complex has.

Moreover, examples of the metal complex represented by formula (1) also include a metal complex in which Ir in the above-mentioned metal complex has been replaced by Rh. Moreover, examples of the metal complex represented by formula (1) also include a metal complex in which two ligands that the above-mentioned metal complex has are coordinated to Pt or Pd.

Moreover, the examples of the metal complex described above are considered to be those that illustrate a preferred form of ring A, ring B, X, $R^1$, $R^2$, $R^3$, $R^4$, $R^5$, $R^6$, $R^7$, $R^8$, $R^9$, and $A^1$-$G^1$-$A^2$ and preferred examples of ring A, ring B, X, $R^1$, $R^2$, $R^3$, $R^4$, $R^5$, $R^6$, $R^7$, $R^8$, $R^9$, and $A^1$-$G^1$-$A^2$ include the groups in the examples of the metal complex described above.

Moreover, preferred examples of the metal complex also include metal complexes having any combination of ring A, ring B, X, $R^1$, $R^2$, $R^3$, $R^4$, $R^5$, $R^6$, $R^7$, $R^8$, $R^9$, and $A^1$-$G^1$-$A^2$ in the examples of the metal complex described above.

The metal complex represented by formula (1) may have a plurality of isomers due to the twist between the

ring A and the triazole ring by the steric hindrance of $R^1$ and $R^2$ and the absolute configuration around the metal atom (M). In the present embodiment, the metal complex may be a single isomer or a mixture of 2 or more isomers among the plurality of isomers.

For example, the metal complex represented by formula (1) may have geometric isomers, facial and meridional isomers. In this case, the percentage of the facial isomer is preferably 80% by mol or more based on the total metal complex, more preferably 90% by mol or more, further preferably 99% by mol or more, and particularly preferably 100% by mol because the luminescence stability is excellent.

Moreover, the metal complex represented by formula (1) may have atropisomers, as geometric isomers, caused by steric hindrance of $R^1$ and $R^2$ and isomers due to the absolute configuration around the metal atom (delta and lambda isomers) and a plurality of enantiomers and diastereomers by combination of these. In the present embodiment, the metal complex may be one isomer or a mixture of 2 or more isomers of these isomers.

<Method of Production of Metal Complex>

- Method of Production 1

The metal complex according to the present embodiment can be produced, for example, by a method (method of production 1) involving reacting a compound to be a ligand. and a metal compound. As needed, the functional group interconversion of the ligand of the metal complex may be conducted.

A form of method of production 1 may be a method including step A of reacting a compound represented by formula (M-1) and a metal compound or a hydrate thereof to obtain a metal complex intermediate (1); and step B of reacting the metal complex intermediate (1) and a compound represented by formula (M-1) or a precursor of a ligand represented by $A^1$-$G^1$-$A^2$.

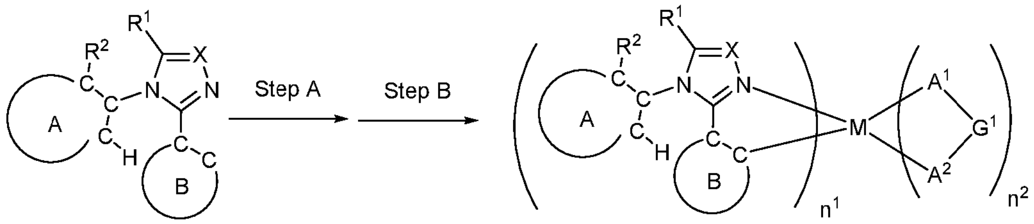


(M-1)

(1)

In the formula, M, $n^1$, $n^2$, $R^1$, $R^2$, ring A, ring B, X, and $A^1$-$G^1$-$A^2$ represent the meanings same as those described above.

In step A, examples of the metal compound include iridium compounds such as iridium chloride, tris(acetylacetonato)iridium(III), a chloro(cyclooctadiene)iridium(I) dimer, and iridium(III) acetate; platinum compounds such as potassium chloroplatinate; palladium compounds such as palladium chloride and palladium acetate; and rhodium compounds such as rhodium chloride. Examples of hydrates of metal compounds include iridium chloride trihydrate and rhodium chloride trihydrate.

Examples of the metal complex intermediary (1) include a metal complex represented by formula (M-2).

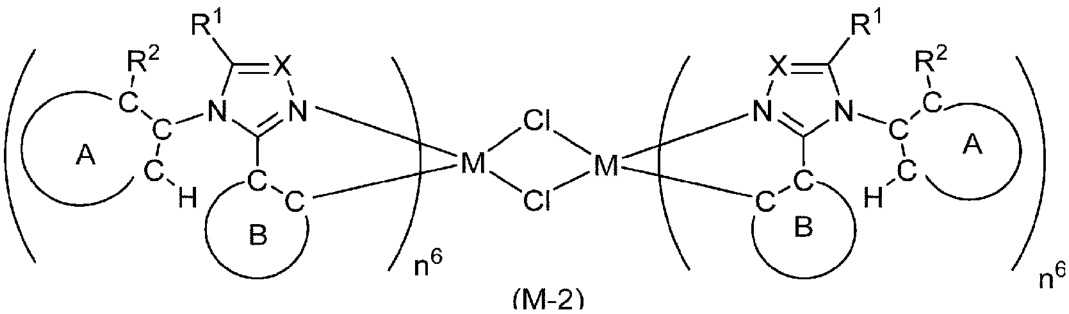

(M-2)

In the formula, M, the ring A, the ring B, $R^1$, $R^2$, and X have the same meanings as described above, and $n^6$ represents 1 or 2. When M is a rhodium atom or an iridium atom, $n^6$ is 2, and when M is a palladium atom or a platinum atom, $n^6$ is 1.

In step A, the amount of the compound represented by formula (M-1) is usually 2 to 20 moles with respect to

1 mole of the metal compound or its hydrate.

In step B, the amount of the compound represented by formula (M-1) or the precursor of the ligand represented by $A^1$-$G^1$-$A^2$ is usually 1 to 100 moles with respect to 1 mole of the metal complex intermediate (1).

Another form of method of production 1 may be a method including step F of reacting a compound represented by formula (M-1) and a metal compound or a hydrate thereof to obtain a metal complex. For example, the compound represented by formula (M-7), which is one of the embodiments of the metal complex according to the present embodiment can be obtained by reacting a compound represented by formula (M-1) and an iridium compound or a hydrate thereof.

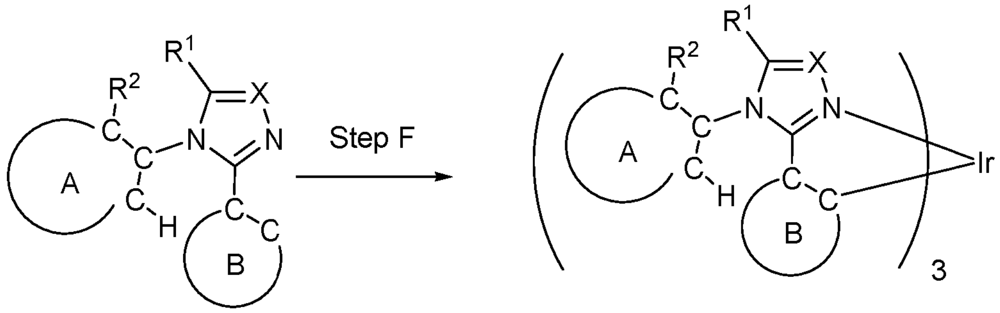


(M-1) (M-7)

In step F, examples of the metal compound include iridium compounds such as iridium chloride, tris(acetylacetonato)iridium (III), chloro(cyclooctadiene)iridium (I) dimer, iridium (III) acetate and examples of the hydrate of the metal compound include iridium(III) chloride trihydrate.

In step F, the amount of the compound represented by formula (M-1) is usually 2 to 20 mol relative to 1 mol of the metal compound or a hydrate thereof.

- Method of Production 2

The metal complex according to the present embodiment may be produced, for example, by the functional group interconversion of the ligand of the metal complex (method of production 2).

In production method 2, examples of the functional group conversion reaction include known coupling reactions that use a transition metal catalyst, such as the Suzuki reaction, Buchwald reaction, Stille reaction, Negishi reaction, and Kumada reaction.

Examples of the production method 2 may include a method including a step C of performing a coupling reaction between a metal complex represented by formula (M-3) and a compound represented by formula (M-4).

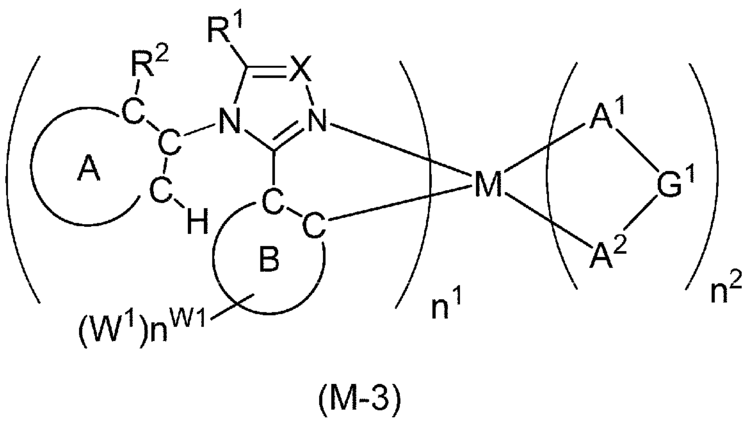

(M-3)

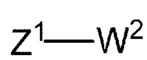

(M-4)

In the formula,

M, $n^1$, $n^2$, the ring A, the ring B, $R^1$, $R^2$, X, and $A^1$-$G^1$-$A^2$ represent the meanings same as those described above,

$n^{W1}$ denotes an integer of 1 or more and 10 or less,

$Z^1$ represents an alkyl group, a cycloalkyl group, an aryl group, or a monovalent heterocyclic group, and these groups may have a substituent, and

Among $W^1$ and $W^2$, one represents a halogen atom selected from the group consisting of a chlorine atom, a bromine

atom, and an iodine atom and the other represents a group selected from the group of substituents B.

<Group of Substituents B>

A group represented by $-B(OR^{C2})_2$ (wherein $R^{C2}$ represents a hydrogen atom, an alkyl group, a cycloalkyl group, or an aryl group, and these groups may have a substituent; and a plurality of $R^{C2}$ may be the same or different, and may be connected to each other to form a ring structure together with the oxygen atom to which they are bonded);
a group represented by $-BF_3Q'$ (wherein Q' represents Li, Na, K, Rb, or Cs);
a group represented by -MgY' (wherein Y' represents a chlorine atom, a bromine atom, or an iodine atom);
a group represented by -ZnY" (wherein Y" represents a chlorine atom, a bromine atom, or an iodine atom); and
a group represented by $-Sn(R^{C3})_3$ (wherein $R^{C3}$ represents a hydrogen atom, an alkyl group, a cycloalkyl group, or an aryl group, and these groups may have a substituent; and a plurality of $R^{C3}$ may be the same or different, and may be connected to each other to form a ring structure together with the tin atom to which they are bonded.

Examples of the group represented by $-B(OR^{C2})_2$ include groups represented by formulas (W-1) to (W-10).

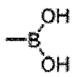 (W-1) 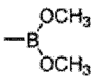 (W-2) 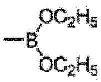 (W-3) 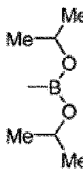 (W-4) 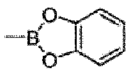 (W-5) 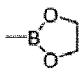 (W-6) 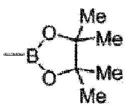 (W-7) 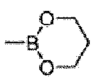 (W-8) 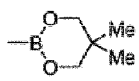 (W-9) 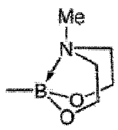 (W-10)

$n^{W1}$ is preferably an integer of 1 to 5, more preferably 1 or 2, and still more preferably 1.

$Z^1$ is preferably an aryl group or a monovalent heterocyclic group, and more preferably an aryl group, and these groups may have a substituent.

The examples and preferable ranges of the optional substituent of $Z^1$ are the same as the examples and preferable ranges of the optional substituent of $R^3$, $R^4$, $R^5$, and $R^6$.

The halogen atom in $W^1$ and $W^2$ is preferably a bromine atom or an iodine atom as this enables the coupling reaction to proceed easily.

The group selected from the group of substituents B in $W^1$ and $W^2$ is preferably a group represented by $-B(OR^{C2})_2$, and more preferably a group represented by the formula (W-7).

In a preferred aspect, $W^1$ may be a halogen atom and $W^2$ may be a group selected from the group of substituents B.

In the coupling reaction, in order to accelerate the reaction, a catalyst such as a palladium catalyst may be used. Examples of the palladium catalyst may include palladium acetate, bis(triphenylphosphine)palladium(II) dichloride, tetrakis(triphenylphosphine)palladium(0), [1,1'-bis(diphenylphosphino)ferrocene]dichloropalladium(II), and tris(dibenzylideneacetone)dipalladium(0).

The palladium catalyst may be used in combination with a phosphorus compound such as triphenylphosphine, tri(o-tolyl)phosphine, tri(tert-butyl)phosphine, tricyclohexylphosphine, and 1,1'-bis (diphenylphosphino)ferrocene.

When a palladium catalyst is used in the coupling reaction, the amount thereof is usually an effective amount, for example, with respect to 1 mole of the compound represented by formula (M-3), preferably 0.00001 to 10 moles in terms of palladium element.

In the coupling reaction, optionally, a palladium catalyst and a base may be used in combination.

The metal complex represented by formula (M-3a) and the metal complex represented by formula (M-3b), each of which is one of the embodiment of the metal complex represented by formula (M-3) can be synthesized, for example, from the metal complex represented by formula (M-5).

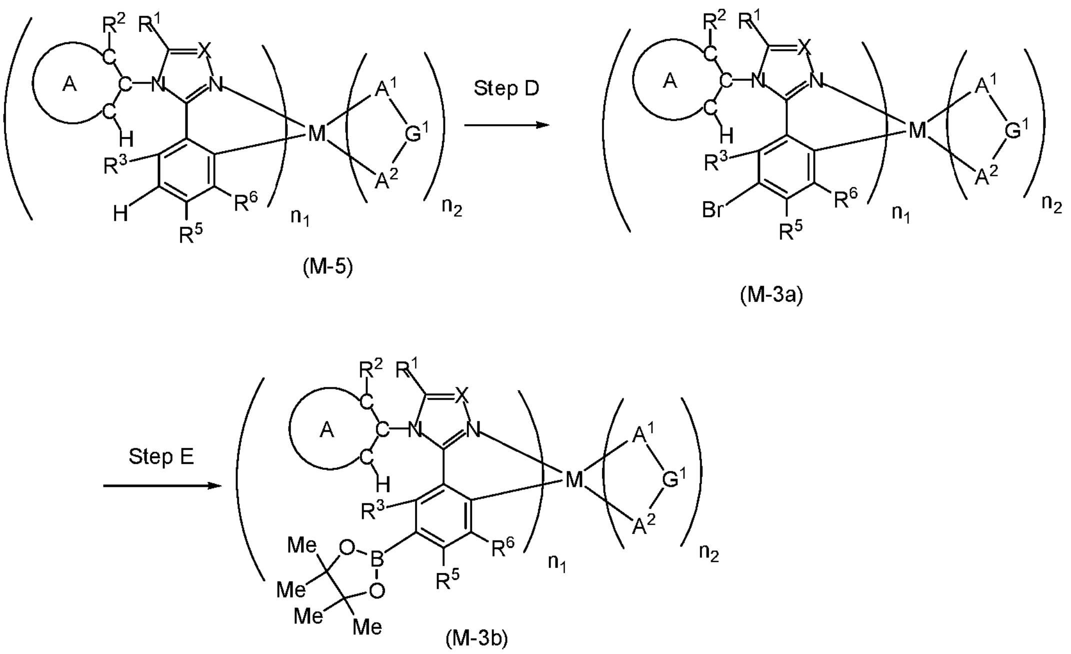


(M-5) (M-3a) (M-3b)

In the formulas, M, $R^1$, $R^2$, $R^3$, $R^5$, $R^6$, ring A, $n^1$, $n^2$, X, and $A^1$-$G^1$-$A^2$ represent the meanings same as those described above.

More particularly, the metal complex represented by formula (M-3a) can be synthesized by step D of reacting, for example, a metal complex represented by formula (M-5) and N-bromosuccinimide in an organic solvent.

Moreover, the metal complex represented by formula (M-3b) can be synthesized by step E of reacting, for example, a metal complex represented by formula (M-3a) and bis(pinacolato)diboron in an organic solvent.

In the step D, the amount of N-bromosuccinimide is usually 1 to 50 mol to 1 mol to 1 mol of the compound represented by formula (M-5).

In the step E, the amount of bis(pinacolato)diboron is usually 1 to 50 mol to 1 mol to 1 mol of the compound represented by formula (M-3a).

For the reaction of the step E, a catalyst such as palladium catalysts may be used to promote the reaction. Examples of the palladium catalyst include catalysts same as those described above.

In the step E, the palladium catalyst may be used together with a phosphorus compound such as triphenylphosphine, tri(o-tolyl)phosphine, tri(tert-butyl)phosphine, tricyclohexylphosphine, and 1,1'-bis(diphenylphosphino)ferrocene.

When a palladium catalyst is used in the step E, the amount is usually an effective amount to 1 mol of the compound represented by, for example, formula (M-3a) and preferably 0.00001 to 10 mol in terms of palladium element.

In the step E, a palladium catalyst and a base are used in combination, as needed.

Steps A, B, C, D, E, and F are usually carried out in a solvent. Examples of the solvent include alcohol solvents such as methanol, ethanol, propanol, ethylene glycol, glycerin, 2-methoxyethanol, and 2-ethoxyethanol; ether solvents such as diethyl ether, tetrahydrofuran (THF), dioxane, cyclopentyl methyl ether, and diglyme; halogen type solvents such as methylene chloride and chloroform; nitrile type solvents such as acetonitrile and benzonitrile; hydrocarbon solvents such as hexane, decalin, pentadecane, toluene, xylene, and mesitylene; amide solvents such as N,N-dimethylformamide, N,N-dimethylacetamide; acetone, dimethylsulfoxide, water, and the like.

In steps A, B, C, D, E, and F, the reaction time is usually 30 minutes to 200 hours, and the reaction temperature is usually between the melting point and the boiling point of the solvent present in the reaction system.

The compound represented by formula (M-1) (X is a nitrogen atom) can be synthesized by a method involving condensing for example, an arylhydrazide compound represented by formula (M-6) and the arylamide compound represented by formula (M-7) in the presence of a base and an acid anhydride.

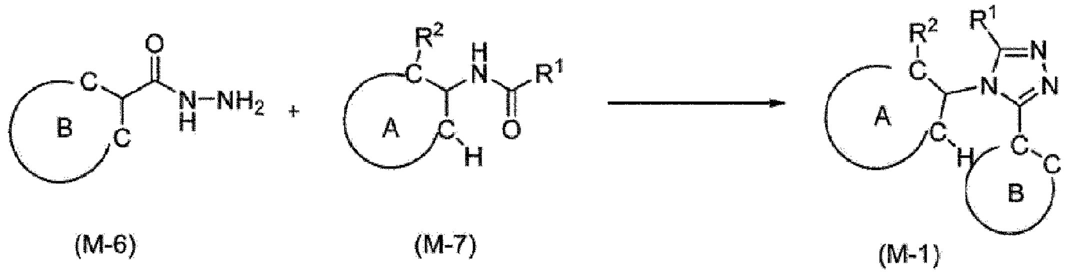

(M-6) (M-7) (M-1)

In the formulas, $R^1$, $R^2$, ring A, and ring B represent the meanings same as those described above.

This reaction is usually conducted in a solvent. Examples of the solvent include alcohol solvents such as methanol, ethanol, propanol, ethylene glycol, glycerin, 2-methoxyethanol, and 2-ethoxyethanol; ether solvents such as diethyl ether, tetrahydrofuran (THF), dioxane, cyclopentyl methyl ether, and diglyme; halogen solvents such as methylene chloride, chloroform, chlorobenzene, dichlorobenzene, and chlorobutane; nitrile solvents such as acetonitrile and benzonitrile; hydrocarbon solvents such as hexane, decalin, toluene, xylene, and mesitylene; amide solvents such as N,N-dimethylformamide and N,N-dimethylacetamide; acetone, dimethylsulfoxide, and water.

The reaction time of this reaction is usually from 30 minutes to 200 hours and the reaction temperature is usually between the melting point and the boiling point of the solvent in the reaction system.

In this reaction, the amount of the compound represented by formula (M-6) is usually 0.05 to 20 mol to 1 mol of the compound represented by formula (M-7).

The compound represented by formula (M-6) can be synthesized according to a method described in literature such as, for example, "European Journal of Medicinal Chemistry, 96, 330-339, 2015" and "Tetrahedron Letters, 54(26), 3353-3358, 2013".
The compound represented by formula (M-6) may be a salt such as hydrochloride.

The compound represented by formula (M-7) can be synthesized according to a method described in literature such as, for example, "Journal of the American Chemical Society, 130(49), 16474-16475, 2008" and "Catalysis Science & Technology, 5(2), 1181-1186, 2015".

The compound represented by formula (M-1) (X is a group represented by =C($R^X$)-) can be synthesized, for example, by the following method. First, carboxamide chloride represented by formula (M-9) is synthesized by reacting an arylamido compound represented by formula (M-8) and a chlorinating agent. Then, a dihydroimidazole compound represented by formula (M-11) is synthesized by reacting a carboxamide chloride represented by formula (M-9) and an arylamine compound represented by formula (M-10). Then, a compound represented by formula (M-1) can be synthesized by reacting a dihydroimidazole compound represented by formula (M-11) and an oxidizing agent.

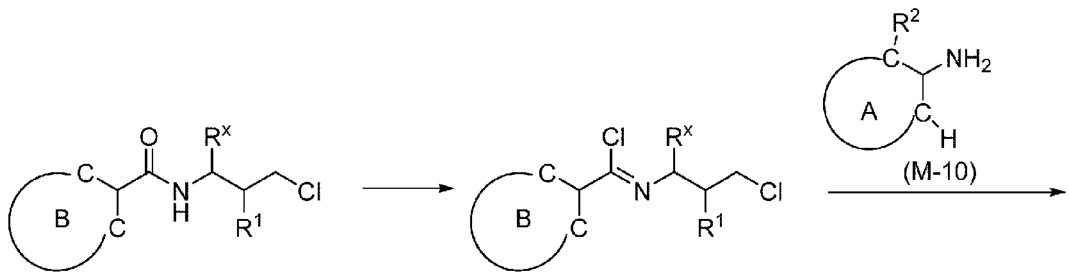

(M-8) (M-9) (M-10)

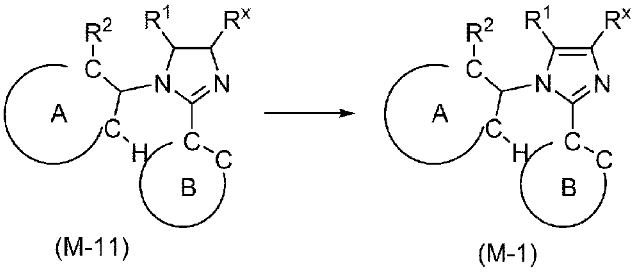

(M-11) (M-1)

In the formulas, $R^1$, $R^2$, $R^X$, ring A, and ring B represent the meanings same as those described above.

These reactions are usually conducted in a solvent. Examples of the solvent include alcohol solvents such as methanol, ethanol, propanol, ethylene glycol, glycerin, 2-methoxyethanol, and 2-ethoxyethanol; ether solvents such as diethyl ether, tetrahydrofuran (THF), dioxane, cyclopentyl methyl ether, and diglyme; halogen solvents such as methylene chloride, chloroform, chlorobenzene, dichlorobenzene, and chlorobutane; nitrile solvents such as acetonitrile and benzonitrile; hydrocarbon solvents such as hexane, decalin, toluene, xylene, and mesitylene; amide solvents such as N,N-dimethylformamide and N,N-dimethylacetamide; acetone, dimethylsulfoxide, and water.

The reaction time of these reactions is usually from 30 minutes to 200 hours and the reaction temperature is usually between the melting point of the solvent in the reaction system and the boiling point.

The amount of the compound represented by formula (M-9) in these reactions is usually 0.05 to 20 mol to 1 mol of the compound represented by formula (M-10).

The compound represented by formula (M-8) can be synthesized, for example, by condensing a corresponding carboxylic acid compound and a primary amine compound.

The compound represented by formula (M-10) can be synthesized according to a method described in literature such as, for example,
"Chemical Engineering & Technology, 39(10), 1933-1938, 2016" and "Organic & Biomolecular Chemistry, 14(38), 9046-9054, 2016".
The compound represented by formula (M-10) may be a salt such as hydrochloride.

The compounds, catalysts, and solvents used in the reactions described in <Method for Producing Metal Complex> may be used singly or in combination of two or more.

The metal complex according to the present embodiment can preferably be used as a material used in a light emitting device. In particular, the metal complex according to the present embodiment can preferably be used as a light emission material to be used in a light emitting layer of the light emitting device.

<Composition>

The composition according to the present embodiment contains a metal complex represented by formula (1).

Moreover, the composition according to the present embodiment may further contain, besides the metal complex represented by formula (1), at least one material selected from the group consisting of a hole transporting material, a hole injecting material, an electron transporting material, an electron injecting material, a light emission material (different from the metal complex represented by formula (1)), an antioxidant, and a solvent.

The composition according to the present embodiment may contain one of the metal complexes represented by formula (1) or two or more of the metal complexes.

In a preferred aspect, the composition may contain the metal complex represented by formula (1) and a host material having at least one function selected from the group consisting of the hole injectability, the hole transportability, the electronic injectability, and the electronic transportability. Such a composition is preferably used in a light emitting layer of a light emitting device. As the host material, a single compound or a combination of 2 or more compounds may be contained.

In the present aspect, the content of the metal complex represented by formula (1) is usually 0.05 to 80 parts by mass, preferably 0.1 to 50 parts by mass, and more preferably 0.5 to 40 parts by mass, based on a total of the metal complex and the host material of 100 parts by mass.

The lowest excited triplet state ($T_1$) of the host material is preferably the equal to or higher than the energy level of $T_1$ of the metal complex represented by formula (1), because in such case the external quantum efficiency of the light emitting device according to the present aspect is better.

It is preferable that the host material exhibits solubility in solvents capable of dissolving the metal complex represented by formula (1), because this enables the light emitting device obtained by using the composition according to the present aspect to be produced by a solution coating process.

The host material is classified into a low molecular weight compound and a polymer compound, and a low molecular weight compound is preferable.

[Low Molecular Weight Host]

Low molecular weight compounds (hereinafter referred to as "low molecular weight host") preferable as the host material will now be described.

The low molecular weight host is preferably a compound represented by formula (H-1).

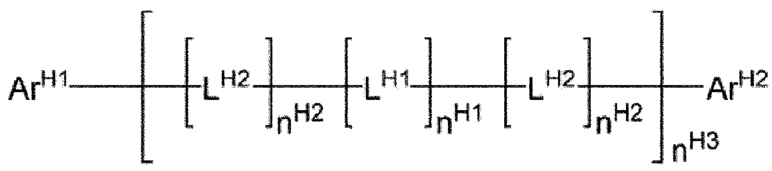

**(H-1)**

$Ar^{H1}$ and $Ar^{H2}$ are preferably a phenyl group, a fluorenyl group, a spirobifluorenyl group, a pyridyl group, a pyrimidinyl group, a triazinyl group, a quinolinyl group, an isoquinolinyl group, a thienyl group, a benzothienyl group, a dibenzothienyl group, a furyl group, a benzofuryl group, a dibenzofuryl group, a pyrrolyl group, an indolyl group, an azaindolyl group, a carbazolyl group, an azacarbazolyl group, a diazacarbazolyl group, a phenoxazinyl group, or a phenothiazinyl group, more preferably a phenyl group, a spirobifluorenyl group, a pyridyl group, a pyrimidinyl group, a triazinyl group, a dibenzothienyl group, a dibenzofuryl group, a carbazolyl group, or an azacarbazolyl group, still more preferably a phenyl group, a pyridyl group, a carbazolyl group, or an azacarbazolyl group, particularly preferably a group represented by formula (TDA-1) or (TDA-3), and especially preferably a group represented by formula (TDA-3), and these groups may have a substituent.

The optional substituent of $Ar^{H1}$ and $Ar^{H2}$ is a halogen atom, an alkyl group, a cycloalkyl group, an alkoxy group, a cycloalkoxy group, an aryl group, or a monovalent heterocyclic group, more preferably an alkyl group, a cycloalkyl group, an alkoxy group, or a cycloalkoxy group, and still more preferably an alkyl group or a cycloalkyl group is more preferable, and these groups may further have a substituent.

$n^{H1}$ is preferably 1. $n^{H2}$ is preferably 0.

$n^{H3}$ is usually an integer of 0 to 10, preferably an integer of 0 to 5, more preferably an integer of 1 to 3, and particularly preferably 1.

$n^{H11}$ is preferably an integer of 1 or more and 5 or less, more preferably an integer of 1 or more and 3 or less, and still more preferably 1.

$R^{H11}$ is preferably a hydrogen atom, an alkyl group, a cycloalkyl group, an aryl group, or a monovalent heterocyclic group, more preferably a hydrogen atom, an alkyl group, or a cycloalkyl group, and still more preferably a hydrogen atom or an alkyl group, and these groups may have a substituent.

$L^{H1}$ is preferably an arylene group or a divalent heterocyclic group.

$L^{H1}$ is a compound represented by formula (A-1) to (A-3), (A-8) to (A-10), (AA-1) to (AA-6), (AA-10) to (AA-21), or (A-24) to (AA-34), more preferably a group represented by formula (A-1), (A-2), (A-8), (A-9), (AA-1) to (AA-4), (AA-10) to (AA-15), or (A-29) to (AA-34), still more preferably a group represented by formula (A-1), (A-2), (A-8), (A-9), (AA-2), (AA-4), or (AA-10) to (AA-15), particularly preferably a group represented by formula (A-1), (A-2), (A-8), (AA-2), (AA-4), (AA-10), (AA-12), or (AA-14), and especially preferably a group represented by formula (A-1), (A-2), (AA-2), (AA-4), or (AA-14).

The optional substituent of $L^{H1}$ is a halogen atom, an alkyl group, a cycloalkyl group, an alkoxy group, a cycloalkoxy group, an aryl group, or a monovalent heterocyclic group, more preferably an alkyl group, an alkoxy group, an aryl group, or a monovalent heterocyclic group, and still more preferably an alkyl group, an aryl group, or a monovalent heterocyclic group, and these groups may further have a substituent.

$L^{H21}$ is preferably a single bond or an arylene group, and more preferably a single bond, and the arylene group may have a substituent.

The definition and examples of the arylene group or divalent heterocyclic group represented by $L^{H21}$ are the same as the definition and examples of the arylene group or divalent heterocyclic group represented by $L^{H1}$.

$R^{H21}$ is preferably an aryl group or a monovalent heterocyclic group, and these groups may have a substituent.

The definition and examples of the aryl group or the monovalent heterocyclic group represented by $R^{H21}$ are the same as the definition and examples of the aryl group or the monovalent heterocyclic group represented by $Ar^{H1}$ and $Ar^{H2}$.

The definition and examples of the optional substituent of $R^{H21}$ are the same as the definitions and examples of the optional substituent of $Ar^{H1}$ and $Ar^{H2}$.

The compound represented by formula (H-1) is preferably a compound represented by formula (H-2).

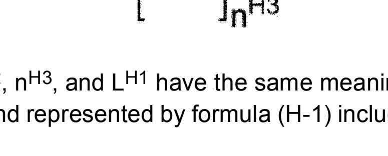

**(H-2)**

In the formula, $Ar^{H1}$, $Ar^{H2}$, $n^{H3}$, and $L^{H1}$ have the same meanings as described above.

Examples of the compound represented by formula (H-1) include the compounds represented by formulas (H-101) to (H-118).

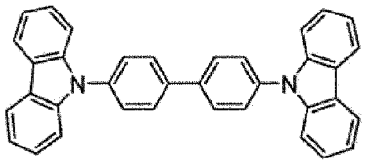
(H-101)

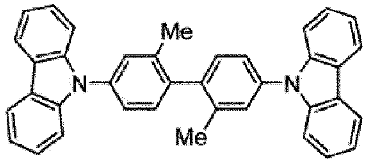
(H-102)

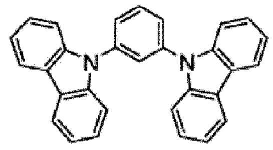
(H-103)

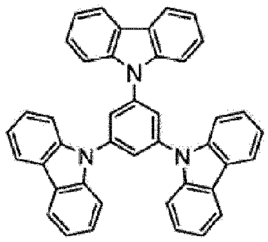
(H-104)

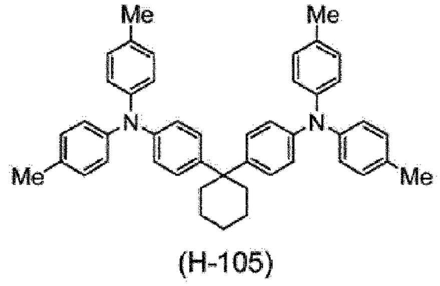
(H-105)

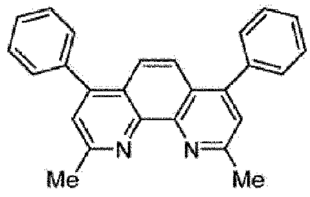
(H-106)

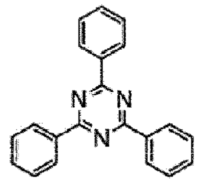
(H-107)

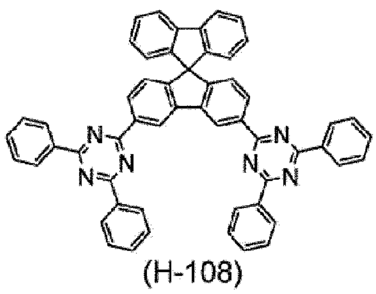
(H-108)

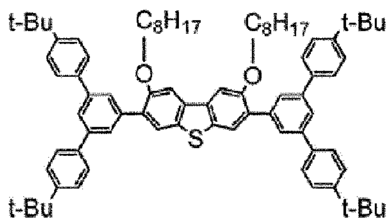
(H-109)

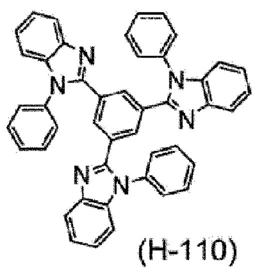
(H-110)

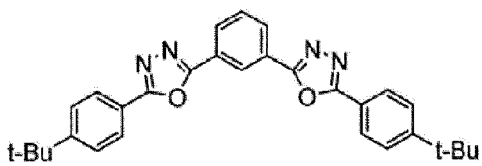
(H-111)

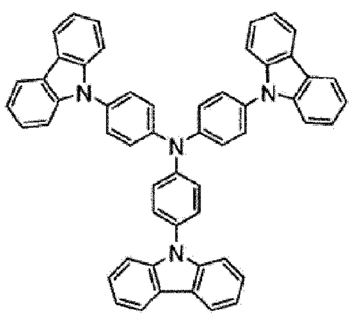
(H-112)

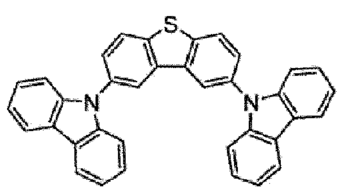
(H-113)

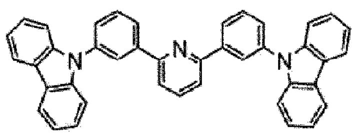
(H-114)

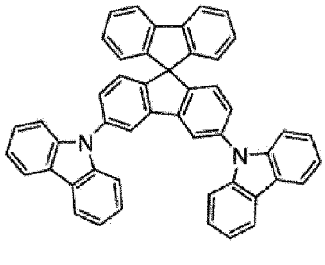
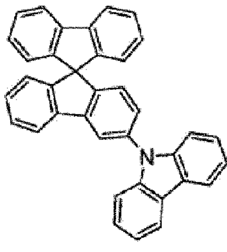
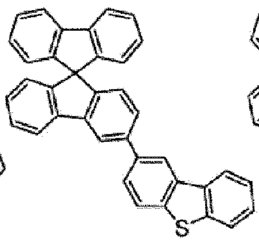
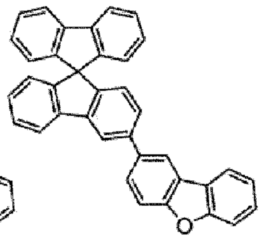

(H-115) (H-116) (H-117) (H-118)

[Polymer Host]

Polymer compound compounds that are preferable as the host compound (hereinafter referred to as "polymer host") will now be described.

The polymer host is preferably a polymer compound containing a constitutional unit represented by formula (Y).

$$-[-Ar^{Y1}-]- \qquad (Y)$$

The arylene group represented by $Ar^{Y1}$ is more preferably an arylene group represented by formula (A-1), (A-2), (A-6) to (A-10), (A-19), or (A-20), and still more preferably a group represented by formula (A-1), (A-2), (A-7), (A-9), or (A-19), and these groups may have a substituent.

More preferably, the divalent heterocyclic group represented by $Ar^{Y1}$ is a group represented by formula (AA-1) to (AA-4), (AA-10) to (AA-15), (AA-18) to (AA-21), (AA-33), or (AA-34), and still more preferably a group represented by formula (AA-4), (AA-10), (AA-12), (AA-14), or (AA-33), and these groups may have a substituent.

The more preferable range and still more preferable range of the arylene group and divalent heterocyclic group in the divalent group represented by $Ar^{Y1}$ in which at least one arylene group and at least one divalent heterocyclic group are directly bonded are respectively the same as the more preferable range and still more preferable range of the arylene group and divalent heterocyclic group represented by $Ar^{Y1}$ described above.

Examples of the "divalent group in which at least one arylene group and at least one divalent heterocyclic group are directly bonded" include groups represented by the following formulas, and these groups may have a substituent.

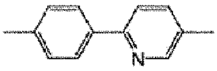
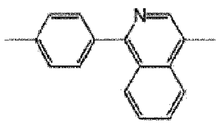
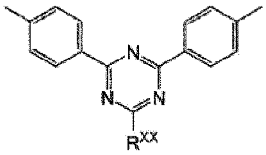
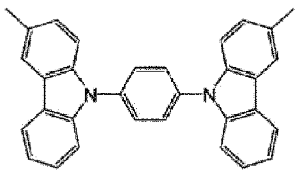

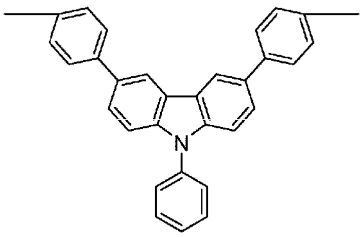

In the formulas, $R^{XX}$ represents a hydrogen atom, an alkyl group, a cycloalkyl group, an aryl group, or a monovalent heterocyclic group, and these groups may have a substituent.

$R^{XX}$ is preferably an alkyl group, a cycloalkyl group, or an aryl group, and these groups may have a substituent.

The optional substituent of the group represented by $Ar^{Y1}$ is an alkyl group, a cycloalkyl group, or an aryl group, and these groups may further have a substituent.

Examples of the constitutional unit represented by formula (Y) include constitutional units represented by formulas (Y-1) to (Y-10) and are preferably a constitutional unit represented by formulas (Y-1) to (Y-3) from the viewpoint of the luminance lifetime of the light emitting device using a composition containing a polymer host and the metal complex represented by formula (1), preferably a constitutional unit represented by formulas (Y-4) to (Y-7) from the viewpoint of electronic transportability, and preferably a constitutional unit represented by formulas (Y-8) to (Y-10) from the viewpoint

of hole transportability.

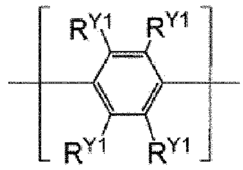

(Y-1)

In the formula, $R^{Y1}$ represents a hydrogen atom, an alkyl group, a cycloalkyl group, an alkoxy group, a cycloalkoxy group, an aryl group, or a monovalent heterocyclic group, and these groups may have a substituent; and a plurality of $R^{Y1}$ may be the same or different and adjacent $R^{Y1}$ may be bonded to each other to form a ring together with the carbon atom to which they are bonded.

$R^{Y1}$ is preferably a hydrogen atom, an alkyl group, a cycloalkyl group, or an aryl group, and these groups may have a substituent.

The constitutional unit represented by formula (Y-1) is preferably a constitutional unit represented by formula (Y-1').

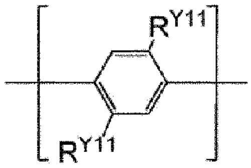

(Y-1')

In the formula, $R^{Y11}$ represents an alkyl group, a cycloalkyl group, an alkoxy group, a cycloalkoxy group, an aryl group, or a monovalent heterocyclic group, and these groups may have a substituent; and a plurality of $R^{Y11}$ may be the same or different.

$R^{Y11}$ is preferably an alkyl group, a cycloalkyl group, or an aryl group, and more preferably an alkyl group or a cycloalkyl group, and these groups may have a substituent.

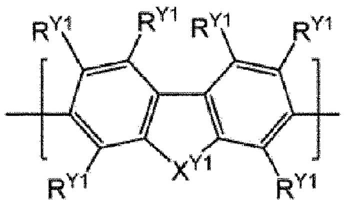

(Y-2)

In the formula,
$R^{Y1}$ has the same meaning as described above;
$X^{Y1}$ represents a group represented by $-C(R^{Y2})_2-$, $-C(R^{Y2})=C(R^{Y2})-$, or $-C(R^{Y2})_2-C(R^{Y2})_2-$; $R^{Y2}$ represents a hydrogen atom, an alkyl group, a cycloalkyl group, an alkoxy group, a cycloalkoxy group, an aryl group, or a monovalent heterocyclic group, and these groups may have a substituent; and a plurality of $R^{Y2}$ may be the same or different, and $R^{Y2}$ may be bonded to another $R^{Y2}$ to form a ring together with the carbon atom to which they are bonded.

$R^{Y2}$ is preferably an alkyl group, a cycloalkyl group, an aryl group, or a monovalent heterocyclic group, and more preferably an alkyl group, a cycloalkyl group, or an aryl group, and these groups may have a substituent.

In $X^{Y1}$, the combination of the two $R^{Y2}$ groups in the group represented by $-C(R^{Y2})_2-$ is preferably a combination in which both groups are alkyl groups or cycloalkyl groups, a combination in which both groups are aryl groups, a combination in which both groups are monovalent heterocyclic groups, or a combination in which one group is an alkyl group or a cycloalkyl group and the other group is an aryl group or a monovalent heterocyclic group, and more preferably is a combination in which one group is an alkyl group or a cycloalkyl group and the other group is an aryl group, and these groups may have a substituent. Two present $R^{Y2}$ groups may be bonded to each other to form a ring together with the atoms to which they are bonded. When $R^{Y2}$ forms a ring, the group represented by $-C(R^{Y2})_2-$ is preferably a group represented by formulas (Y-A1) to (Y-A5), and more preferably a group represented by formula (Y-A4), and these groups may have a substituent.

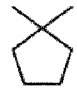

(Y-A1)

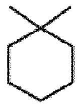

(Y-A2)

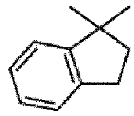

(Y-A3)

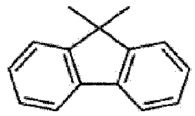

(Y-A4)

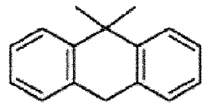

(Y-A5)

In $X^{Y1}$, the combination of the two $R^{Y2}$ groups in the group represented by $-C(R^{Y2})=C(R^{Y2})-$ is preferably a combination in which both groups are alkyl groups or cycloalkyl groups or a combination in which one group is an alkyl group or a cycloalkyl group and the other group is an aryl group, and these groups may have a substituent.

In $X^{Y1}$, the four $R^{Y2}$ in the group represented by $-C(R^{Y2})_2-C(R^{Y2})_2-$ are preferably an optionally substituted alkyl group or cycloalkyl group. A plurality of $R^{Y2}$ may be bonded to each other to form a ring together with the atoms to which they are bonded, and when $R^{Y2}$ forms a ring, a group represented by $-C(R^{Y2})_2-C(R^{Y2})_2-$ is preferably a group represented by formulas (Y-B1) to (Y-B5), and more preferably a group represented by formula (Y-B3), and these groups may have a substituent.

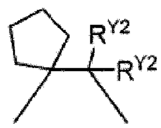

(Y-B1)

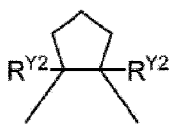

(Y-B2)

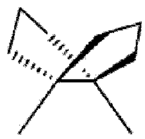

(Y-B3)

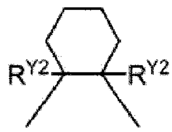

(Y-B4)

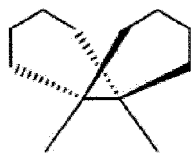

(Y-B5)

In the formula, $R^{Y2}$ has the same meaning as described above.

The constitutional unit represented by formula (Y-2) is preferably a constitutional unit represented by formula (Y-2').

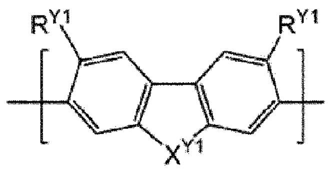

(Y-2')

In the formula, $R^{Y1}$ and $X^{Y1}$ have the same meanings as described above.

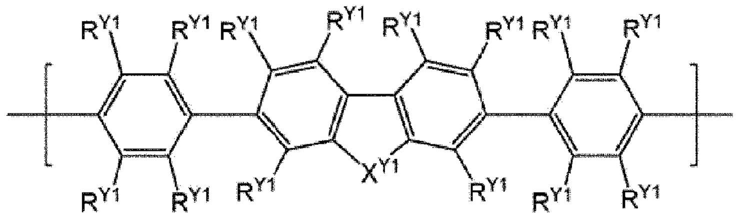

(Y-3)

In the formula, $R^{Y1}$ and $X^{Y1}$ have the same meanings as described above.

The constitutional unit represented by formula (Y-3) is preferably a constitutional unit represented by formula (Y-3').

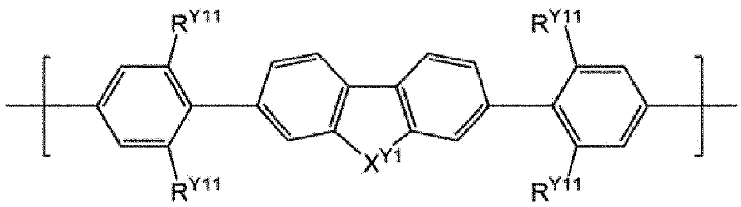

(Y-3')

In the formula, $R^{Y1}$ and $X^{Y1}$ have the same meanings as described above.

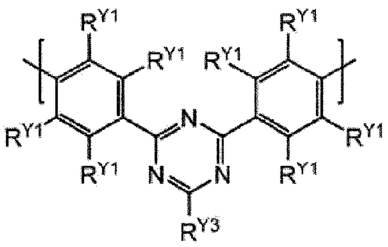

(Y-4)

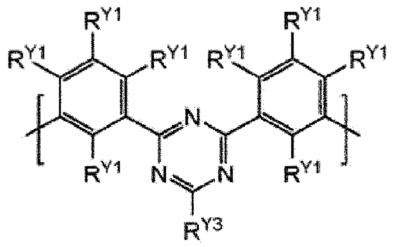

(Y-5)

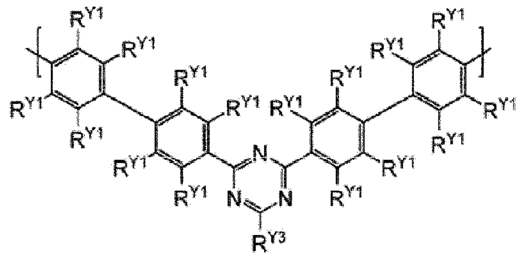

(Y-6)

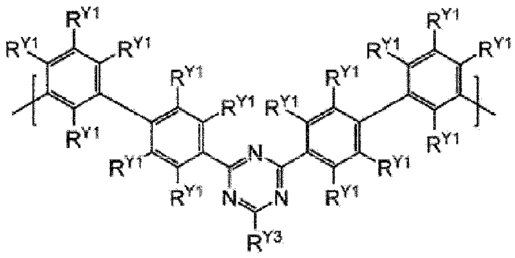

(Y-7)

In the formulas,
$R^{Y1}$ has the same meaning as described above;
$R^{Y3}$ represents a hydrogen atom, an alkyl group, a cycloalkyl group, an alkoxy group, a cycloalkoxy group, an aryl group, or a monovalent heterocyclic group, and these groups may have a substituent.

$R^{Y3}$ is preferably an alkyl group, a cycloalkyl group, an alkoxy group, a cycloalkoxy group, an aryl group, or a monovalent heterocyclic group, and more preferably an aryl group, and these groups may have a substituent.

The constitutional unit represented by formula (Y-4) is preferably a constitutional unit represented by formula (Y-4'), and the constitutional unit represented by formula (Y-6) is preferably a constitutional unit represented by formula (Y-6').

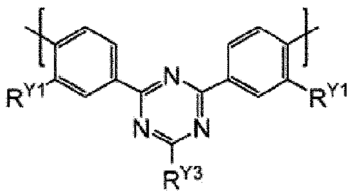

(Y-4')

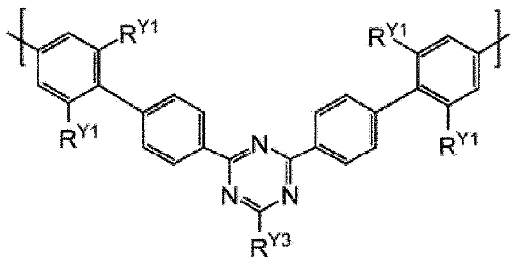

(Y-6')

In the formula, $R^{Y1}$ and $R^{Y3}$ have the same meanings as described above.

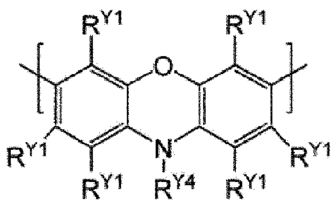

(Y-8)

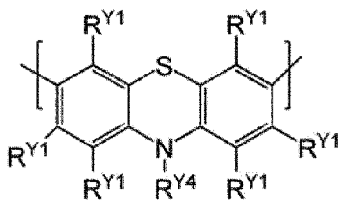

(Y-9)

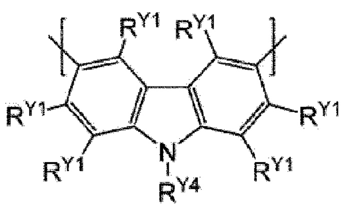

(Y-10)

In the formula,
$R^{Y1}$ has the same meaning as described above;
$R^{Y4}$ represents a hydrogen atom, an alkyl group, a cycloalkyl group, an alkoxy group, a cycloalkoxy group, an aryl group,

or a monovalent heterocyclic group, and these groups may have a substituent.

$R^{Y4}$ is preferably an alkyl group, a cycloalkyl group, an alkoxy group, a cycloalkoxy group, an aryl group, or a monovalent heterocyclic group, and more preferably an aryl group. These groups have a substituent.

Examples of the constitutional unit represented by formula (Y) include constitutional units composed of arylene groups represented by formulas (Y-101) to (Y-121), constitutional units composed of divalent heterocyclic groups represented by formulas (Y-201) to (Y-206), and constitutional units composed of a divalent group represented by formulas (Y-301) to (Y-305) in which at least one arylene group and at least one divalent heterocyclic group are directly bonded.

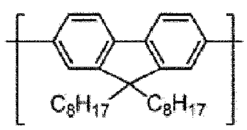
(Y-101)

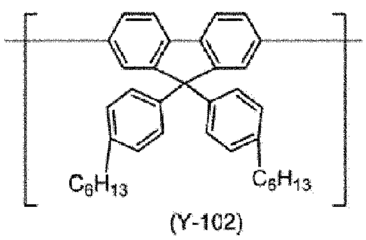
(Y-102)

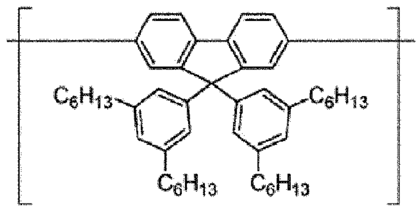
(Y-103)

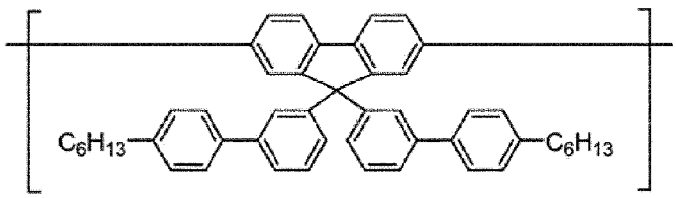
(Y-104)

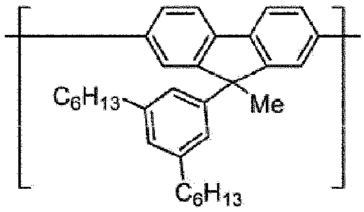
(Y-105)

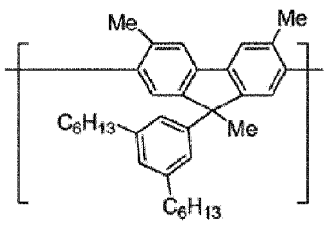
(Y-106)

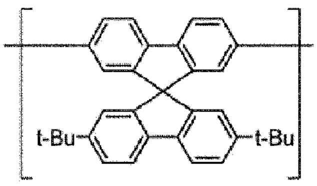
(Y-107)

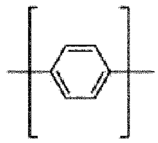
(Y-108)

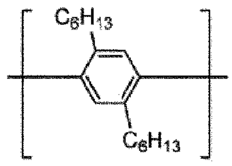
(Y-109)

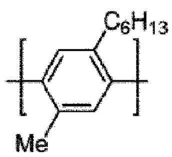
(Y-110)

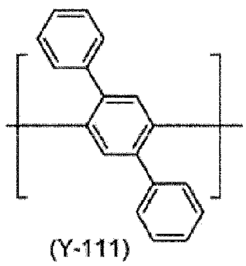
(Y-111)

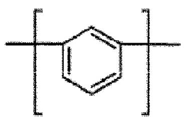
(Y-112)

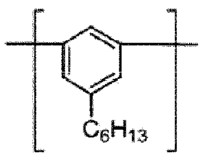
(Y-113)

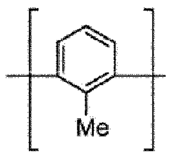
(Y-114)

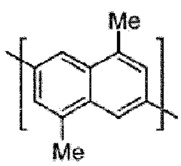
(Y-115)

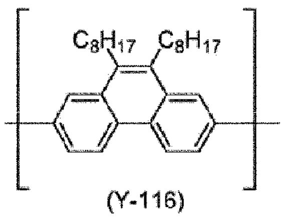
(Y-116)

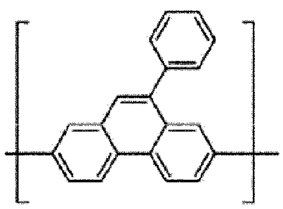
(Y-117)

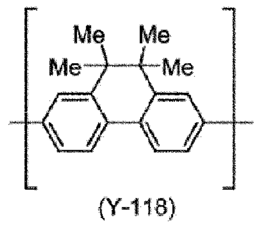
(Y-118)

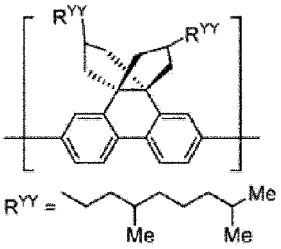
(Y-119)

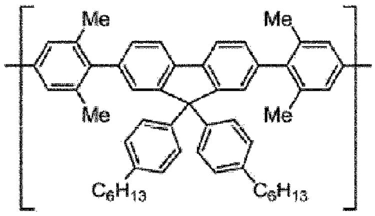
(Y-120)

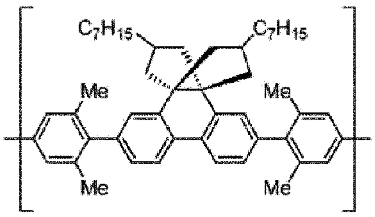
(Y-121)

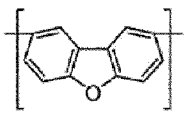
(Y-201)

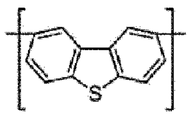
(Y-202)

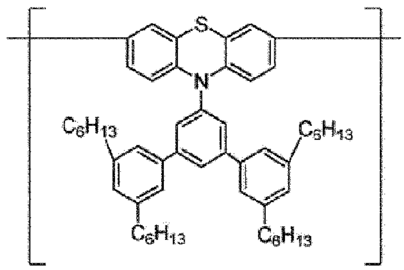
(Y-203)

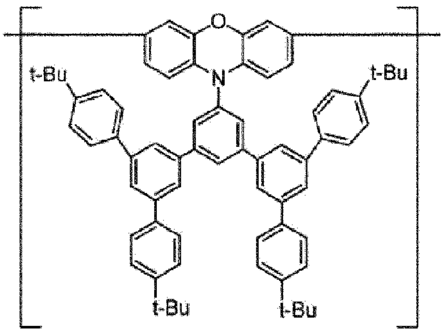
(Y-204)

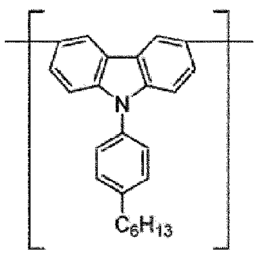
(Y-205)

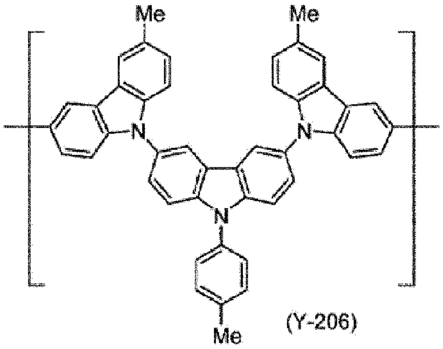
(Y-206)

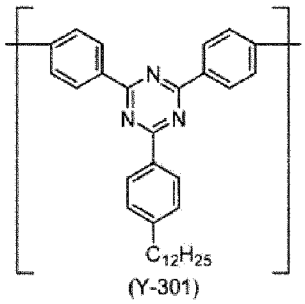
(Y-301)

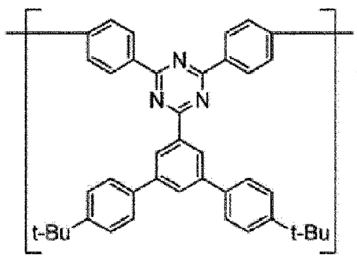
(Y-302)

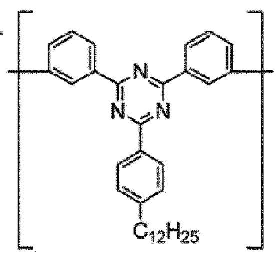
(Y-303)

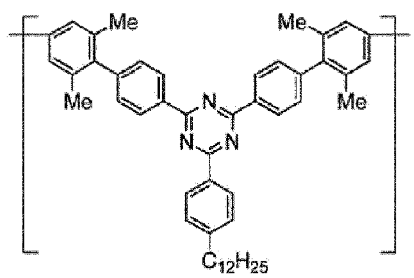
(Y-304)

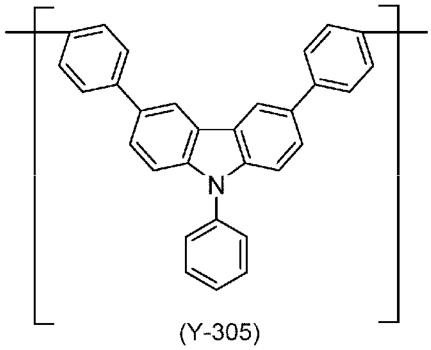

(Y-305)

The constitutional unit represented by formula (Y) in which $Ar^{Y1}$ is an arylene group is preferably 0.5 to 80% by mol and more preferably 30 to 60% by mol based on the total amount of the constitutional units contained in the polymer compound because the luminance lifetime of the light emitting device using a composition containing a polymer host and the metal complex represented by formula (1) is excellent.

The constitutional unit represented by formula (Y) in which $Ar^{Y1}$ is a divalent heterocyclic group or a divalent group in which at least one arylene group and at least one divalent heterocyclic group are directly bonded is preferably 0.5 to 30% by mol and more preferably 3 to 20% by mol based on the total amount of the constitutional units contained in the polymer compound because the charge transportability of the light emitting device using a composition containing a polymer host and the metal complex represented by formula (1) is excellent.

Only one constitutional unit represented by formula (Y) may be contained or two or more of them may be contained in the polymer host.

To achieve better hole transportability, it is preferable that the polymer host further contains a constitutional unit represented by formula (X).

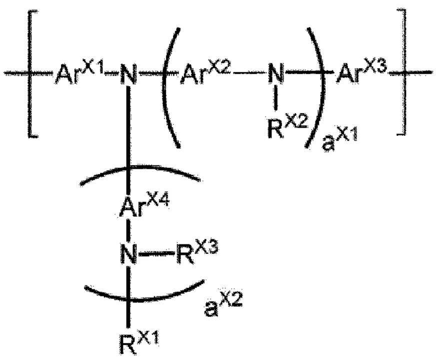

(X)

In the formula,

$a^{X1}$ and $a^{X2}$ each independently denote an integer of 0 or more,

$Ar^{X1}$ and $Ar^{X3}$ each independently represent an arylene group or a divalent heterocyclic group, and these groups may have a substituent,

$Ar^{X2}$ and $Ar^{X4}$ each independently represent an arylene group, a divalent heterocyclic group, or a divalent group in which at least one arylene group and at least one divalent heterocyclic group are directly bonded, and these groups may have a substituent; and when there are a plurality of $Ar^{X2}$ and $Ar^{X4}$, they may be the same or different,

$R^{X1}$, $R^{X2}$, and $R^{X3}$ each independently represent a hydrogen atom, an alkyl group, a cycloalkyl group, an aryl group, or a monovalent heterocyclic group, and these groups may have a substituent; and when there are a plurality of $R^{X2}$ and $R^{X3}$, they may be the same or different.

$a^{X1}$ is preferably 2 or less, and more preferably 1, because the luminance lifetime of the light emitting device using a composition containing a polymer host and the metal complex represented by formula (1) is excellent.

$a^{X2}$ is preferably 2 or less, and more preferably 0, because the luminance lifetime of the light emitting device using a composition containing a polymer host and the metal complex represented by formula (1) is excellent.

$R^{X1}$, $R^{X2}$ and $R^{X3}$ are preferably an alkyl group, a cycloalkyl group, an aryl group, or a monovalent heterocyclic group, and more preferably an aryl group, and these groups may have a substituent.

The arylene group represented by $Ar^{X1}$ and $Ar^{X3}$ is more preferably a group represented by formula (A-1) or (A-9), and still more preferably a group represented by formula (A-1), and these groups may have a substituent.

The divalent heterocyclic group represented by $Ar^{X1}$ and $Ar^{X3}$ is more preferably a group represented by formula (AA-1), (AA-2), or (AA-7) to (AA-26), and these groups may have a substituent.

$Ar^{X1}$ and $Ar^{X3}$ are preferably an arylene group which may have a substituent.

The arylene group represented by $Ar^{X2}$ and $Ar^{X4}$ is more preferably an arylene group represented by formula (A-1), (A-6), (A-7), (A-9) to (A-11), or (A-19), and these groups may have a substituent.

The more preferable range of the divalent heterocyclic group represented by $Ar^{X2}$ and $Ar^{X4}$ is the same as the more preferable range of the divalent heterocyclic group represented by $Ar^{X1}$ and $Ar^{X3}$.

The more preferable range and still more preferable range of the arylene group and the divalent heterocyclic group in the divalent group represented by $Ar^{X2}$ and $Ar^{X4}$ in which at least one arylene group and at least one divalent heterocyclic group are directly bonded are respectively the same as the more preferable range and still more preferable range of the arylene group and the divalent heterocyclic group represented by $Ar^{X1}$ and $Ar^{X3}$.

Examples of the divalent group represented by $Ar^{X2}$ and $Ar^{X4}$ in which at least one arylene group and at least one divalent heterocyclic group are directly bonded include the same divalent groups represented by $Ar^{Y1}$ of formula (Y) in which at least one arylene group and at least one divalent heterocyclic group are directly bonded.

$Ar^{X2}$ and $Ar^{X4}$ are preferably an arylene group which may have a substituent.

The optional substituent of the groups represented by $Ar^{X1}$ to $Ar^{X4}$ and $R^{X1}$ to $R^{X3}$ is preferably an alkyl group, a cycloalkyl group, or an aryl group, and these groups may further have a substituent.

The constitutional unit represented by formula (X) is preferably a constitutional unit represented by formulas (X-1) to (X-7), more preferably a constitutional unit represented by formulas (X-1) to (X-6), and still more preferably a constitutional unit represented by formulas (X-3) to (X-6).

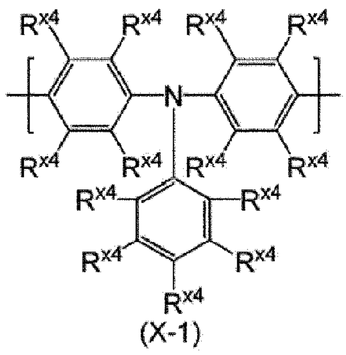

(X-1)

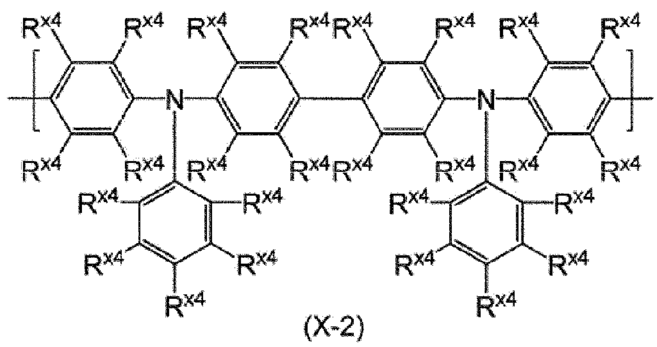

(X-2)

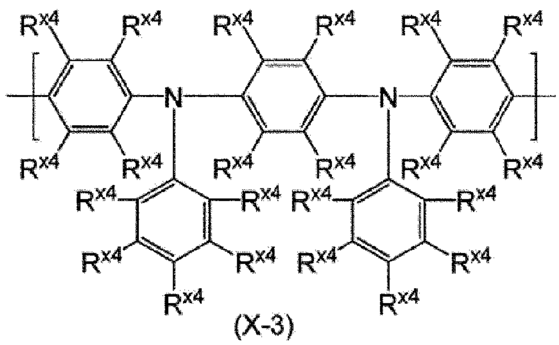

(X-3)

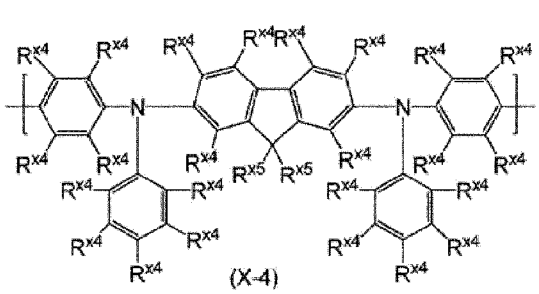

(X-4)

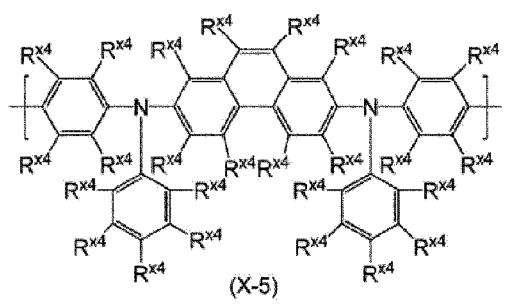

(X-5)

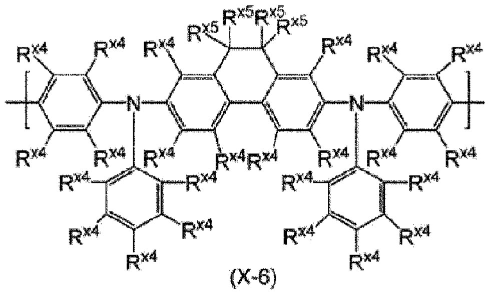

(X-6)

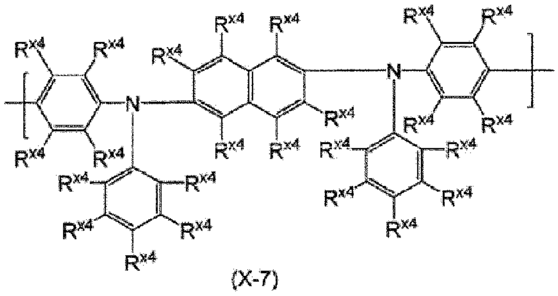

(X-7)

In the formulas,
$R^{X4}$ and $R^{X5}$ each independently represent a hydrogen atom, an alkyl group, a cycloalkyl group, an alkoxy group, a cycloalkoxy group, an aryl group, an aryloxy group, a halogen atom, a monovalent heterocyclic group, or a cyano group, and these groups may have a substituent; a plurality of $R^{X4}$ may be the same or different; and a plurality of $R^{X5}$ may be the same or different, and adjacent $R^{X5}$ may be bonded to each other to form a ring together with the carbon atom to which they are bonded.

The content of the constitutional unit represented by formula (X) is preferably 0.1 to 50% by mol, more preferably 1 to 40% by mol, and further preferably 5 to 30% by mol based on the total amount of the constitutional units contained in the polymer compound because the hole transportability is excellent.

Examples of the constitutional unit represented by formula (X) include constitutional units represented by formulas (X1-1) to (X1-11). The constitutional unit represented by formula (X) is preferably a constitutional unit represented by formulas (X1-3) to (X1-10).

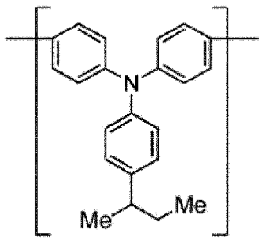

(X1-1)

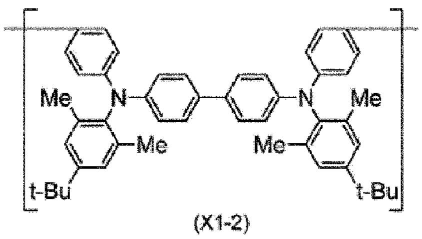

(X1-2)

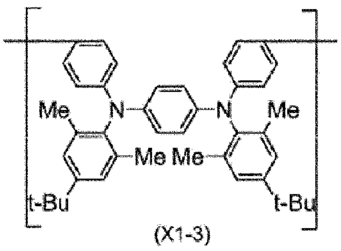

(X1-3)

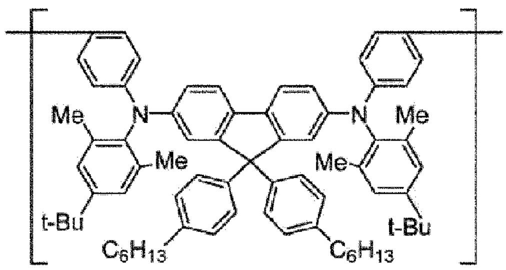

(X1-4)

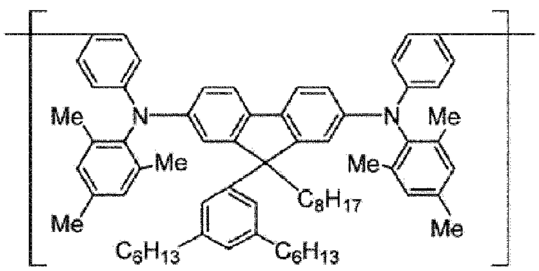

(X1-5)

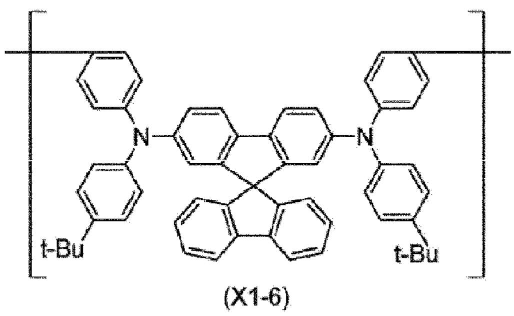

(X1-6)

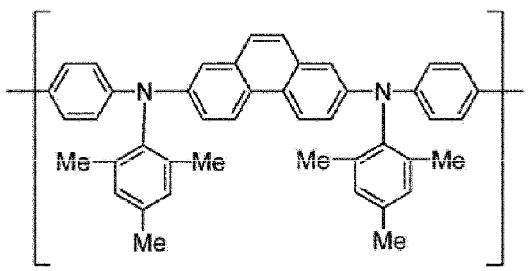

(X1-7)

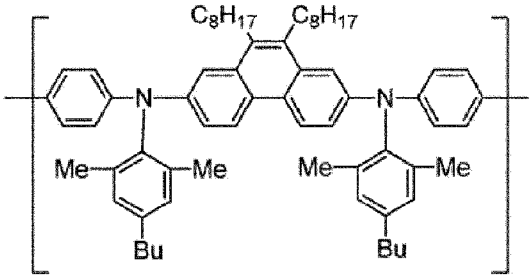

(X1-8)

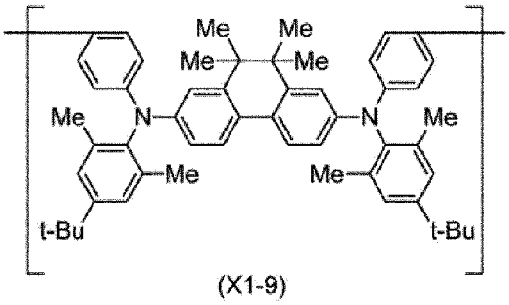

(X1-9)

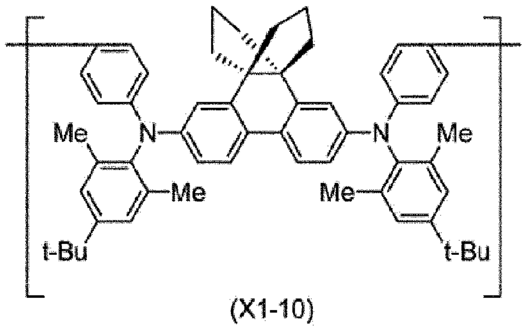

(X1-10)

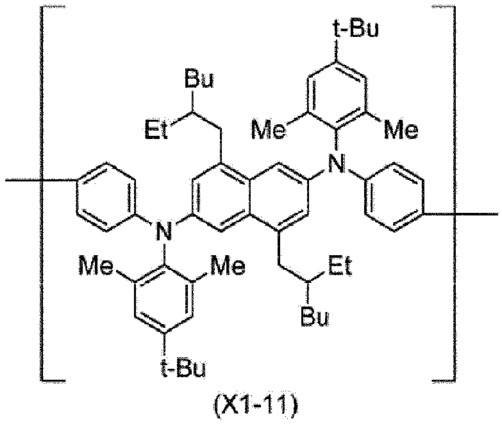

(X1-11)

In the polymer host, only one constitutional unit represented by formula (X) may be contained or two or more of them may be contained.

Examples of the polymer host include the polymer compounds (P-1) to (P-6) in Table 1. Here, the "other" constitutional unit means a constitutional unit other than the constitutional unit represented by formula (Y) and the constitutional unit represented by formula (X).

[Table 1]

| Polymer Compound | Constitutional units and Molar Ratios Thereof | | | | |
|---|---|---|---|---|---|
| | Formula (Y) | | | Formula (X) | Other |
| | (Y-1) to (Y-3) | (Y-4) to (Y-7) | (Y-8) to (Y-10) | (X-1) to (Y-7) | |
| | p | q | r | s | t |
| (P-1) | 0.1-99.9 | 0.1-99.9 | 0 | 0 | 0-30 |
| (P-2) | 0.1-99.9 | 0 | 0.1-99.9 | 0 | 0-30 |
| (P-3) | 0.1-99.8 | 0.1-99.8 | 0 | 0.1-99.8 | 0-30 |
| (P-4) | 0.1-99.8 | 0.1-99.8 | 0.1-99.8 | 0 | 0-30 |
| (P-5) | 0.1-99.8 | 0 | 0.1-99.8 | 0.1-99.8 | 0-30 |
| (P-6) | 0.1-99.7 | 0.1-99.7 | 0.1-99.7 | 0.1-99.7 | 0-30 |

In Table 1, p, q, r, s, and t represent the molar ratio of each constitutional unit, $p + q + r + s + t = 100$ and $100 \geq p + q + r + s \geq 70$.

The polymer host may be any of a block copolymer, a random copolymer, an alternating copolymer, and a graft copolymer or another aspect. The polymer host is preferably a copolymer obtained, for example, by copolymerizing a plurality of raw material monomers.

(Method of Producing Polymer Host)

The polymer host can be produced using a known method of polymerization described in Chemical Review

(Chem. Rev.), Vol. 109, p. 897-1091 (2009). Examples of the method of producing the polymer host include a method of polymerization by a coupling reaction using a transition metal catalyst, such as Suzuki reaction, Yamamoto reaction, Buchwald reaction, Stille reaction, Negishi reaction, and Kumada reaction.

In the polymerization method, examples of the method for charging the monomers may include a method in which all the monomers are charged all at once into the reaction system, a method in which a part of the monomers is charged and made to react, and then the remaining monomers are charged all at once, continuously, or in several stages, and a method in which the monomers are charged continuously or in several stages.

Examples of the transition metal catalyst include a palladium catalyst, a nickel catalyst and the like.

Workup is carried out by known methods, for example, a method in which water-soluble impurities are removed by liquid separation and a method in which a lower alcohol such as methanol is added to a reaction liquid after a polymerization reaction, and deposited sediments are filtered out and then dried, used singly or in combination. When the purity of the polymer host is low, the polymer host can be purified, for example, by a normal method such as crystallization, reprecipitation, continuous extraction with a Soxhlet extractor, and column chromatography

[Solvent]

The composition according to the present embodiment may be a liquid composition containing a metal complex and a solvent represented by formula (1) (also referred to as ink). Such an ink is suitable for the production of light emitting devices using a printing method such as ink-jet printing and nozzle printing.

The viscosity of the ink may be adjusted according to the type of printing method. However, when a solution for ink jet printing or the like is applied in a printing method that employs an ejection apparatus, the viscosity is preferably 1 to 20 mPa·s at 25C° in order to prevent clogging and curved flight during ejection.

The solvent contained in the ink is preferably a solvent capable of dissolving or uniformly dispersing the solid content in the ink. Examples of the solvent include chlorinated solvents such as 1,2-dichloroethane, 1,1,2-trichloroethane, chlorobenzene, and o-dichlorobenzene; ether solvents such as THF, dioxane, anisole, and 4-methylanisole; aromatic hydrocarbon solvents such as toluene, xylene, mesitylene, ethylbenzene, hexylbenzene, and cyclohexylbenzene; aliphatic hydrocarbon solvents such as cyclohexane, methylcyclohexane, pentane, hexane, heptane, octane, nonane, decane, dodecane, and bicyclohexyl; ketone solvents such as acetone, methyl ethyl ketone, cyclohexanone, and acetophenone; ester solvents such as ethyl acetate, butyl acetate, ethyl cellosolve acetate, methyl benzoate, and phenyl acetate; polyhydric alcohol solvents such as ethylene glycol, glycerin, and 1,2-hexanediol; alcohol solvents such as isopropyl alcohol and cyclohexanol; sulfoxide solvents such as dimethylsulfoxide; and amide solvents such as N-methyl-2-pyrrolidone and N,N-dimethylformamide. One solvent may be used alone, or two or more solvents may be used in combination.

In the ink, the amount of the solvent blended is, based on 100 parts by mass of the metal complex represented by formula (1), usually 1000 to 100000 parts by mass, and preferably 2000 to 20000 parts by mass.

[Hole Transporting Material]

The hole transporting material is classified into a low molecular weight compound and a polymer compound, and is preferably a polymer compound and more preferably a polymer compound having a cross-linking group.

Examples of the low molecular weight compounds include aromatic amine compounds such as triphenylamine and derivatives thereof, N,N'-di-1-naphthyl-N,N'-diphenylbenzidine (a-NPD), and N,N'-diphenyl-N,N'-di(m-tolyl)benzidine (TPD).

Examples of the polymer compounds include polyvinylcarbazole and derivatives thereof; and polyarylene having an aromatic amine structure in a side chain or main chain and derivatives thereof. The polymer compound may be a compound to which an electron accepting site is bound. Examples of the electron accepting moiety include fullerene, tetrafluorotetracyanoquinodimethane, tetracyanoethylene, trinitrofluorenone and the like, and fullerene is preferable.

In the composition according to the present embodiment, the amount of the hole transporting material blended is, based on 100 parts by mass of the metal complex represented by formula (1), usually 1 to 400 parts by mass, and preferably 5 to 150 parts by mass.

One hole transporting material may be used alone, or two or more hole transporting materials may be used in combination.

[Electron Transporting Material]

The electron transporting materials are classified into a low molecular weight compound and a polymer compound. The electron transporting material may have a crosslinking group.

Examples of the low molecular weight compound include metal complexes having 8-hydroxyquinoline as a

ligand, oxadiazole, anthraquinodimethane, benzoquinone, naphthoquinone, anthraquinone, tetracyanoanthraquinodimethane, fluorenone, diphenyldicyanoethylene, and diphenoquinone, and derivatives of these.

Examples of the polymer compound include polyphenylene, polyfluorene, and derivatives thereof. The polymer compound may be doped with a metal.

In the composition according to the present embodiment, the amount of the electron transporting material blended is, based on 100 parts by mass of the metal complex represented by formula (1), usually 1 to 400 parts by mass, and preferably 5 to 150 parts by mass.

One electron transporting material may be used alone, or two or more hole transporting materials may be used in combination.

[Hole Injecting Material and Electron Injecting Material]

The hole injecting material and the electron injecting material are each classified into a low molecular weight compound and a polymer compound. The hole injecting material and the electron injecting material may have a crosslinking group.

Examples of the low molecular weight compound include metal phthalocyanines such as copper phthalocyanine; carbon; metal oxides of molybdenum, tungsten, and the like; and metal fluorides such as lithium fluoride, sodium fluoride, cesium fluoride, and potassium fluoride.

Examples of the polymer compound include conductive polymers such as polyaniline, polythiophene, polypyrrole, polyphenylenevinylene, polythienylenevinylene, polyquinoline, and polyquinoxaline, and derivatives of these; and polymers containing an aromatic amine structure in the main chain or side chain.

In the composition according to the present embodiment, the amounts of the hole injecting material and the electron injecting material are respectively, based on 100 parts by mass of the metal complex represented by formula (1), usually 1 to 400 parts by mass, and preferably 5 to 150 parts by mass.

Each of the hole injecting material and the electron injecting material may be used alone, or two or more materials may be used in combination.

(Ion Doping)

When the hole injecting material or the electron injecting material comprises a conductive polymer, the electrical conductivity of the conductive polymer is preferably $1 \times 10^{-5}$ S/cm to $1 \times 10^{3}$ S/cm. The conductive polymer can be doped with an appropriate amount of ions in order to set the electrical conductivity of the conductive polymer in such a range.

The type of ion to be doped is an anion for the hole injecting material and a cation for the electron injecting material. Examples of the anion include polystyrenesulfonic acid ions, alkylbenzenesulfonic acid ions, and camphorsulfonic acid ions. Examples of the cation include lithium ions, sodium ions, potassium ions, and tetrabutylammonium ions.

One type of ion to be doped may be used alone, or two or more types of ion to be doped may be used.

[Light Emitting Material]

A light emitting material (different from the metal complex represented by formula (1)) is classified into a low molecular weight compound and a polymer compound. The light emitting material may have a crosslinking group.

Examples of the low molecular weight compound include naphthalene and derivatives thereof, anthracene and derivatives thereof, perylene and derivatives thereof, and a triplet light emitting complex having iridium, platinum, or europium as a central metal.

Examples of the polymer compound include polymer compounds containing a phenylene group, a naphthalenediyl group, a fluorenediyl group, a phenanthrenediyl group, a dihydrophenanthrenediyl group, a group represented by formula (X), a carbazolediyl group, a phenoxazinediyl group, a phenothiazinediyl group, an anthracenediyl group, a pirenediyl group, and the like.

The light emission material preferably includes a triplet luminescent complex and/or a polymer compound.

Examples of the triplet luminescent complex include metal complexes illustrated below.

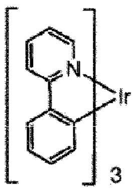
Ir(ppy)₃

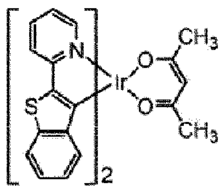
Btp₂Ir(acac)

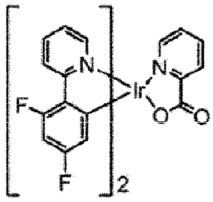
FIrpic

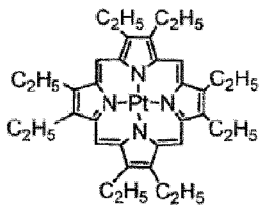
PtOEP

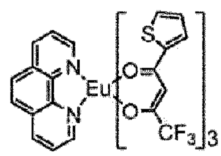
Eu(TTA)₃phen

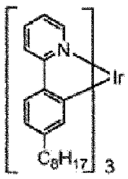
COM-1

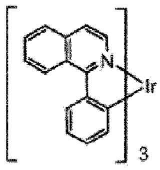
COM-2

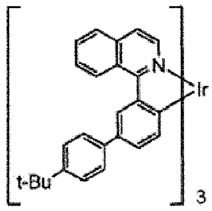
COM-3

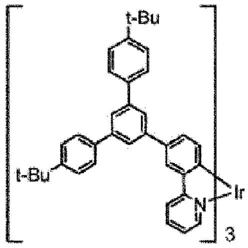
COM-4

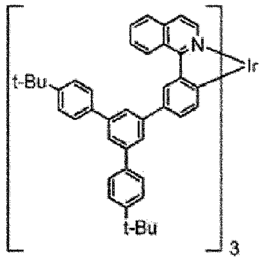
COM-5

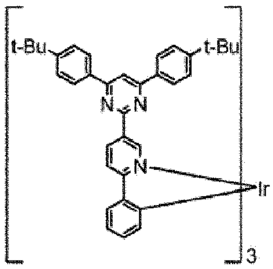
COM-6

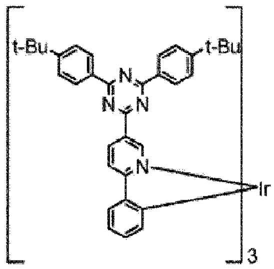
COM-7

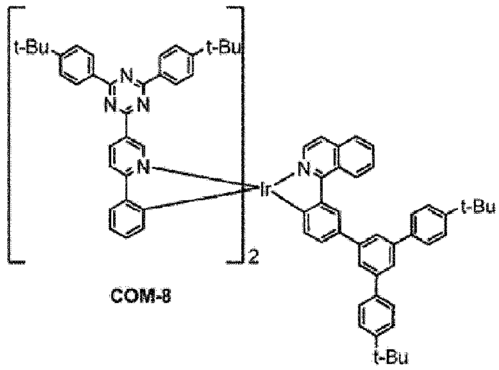
COM-8

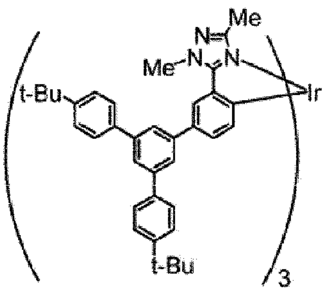
COM-9

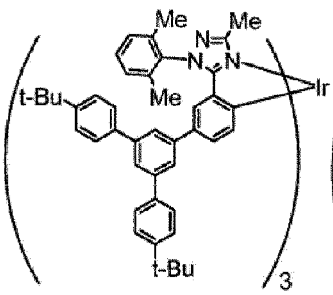
COM-10

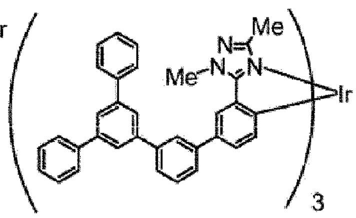
COM-11

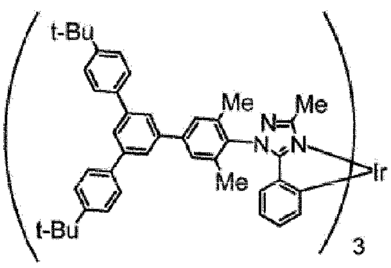
COM-12

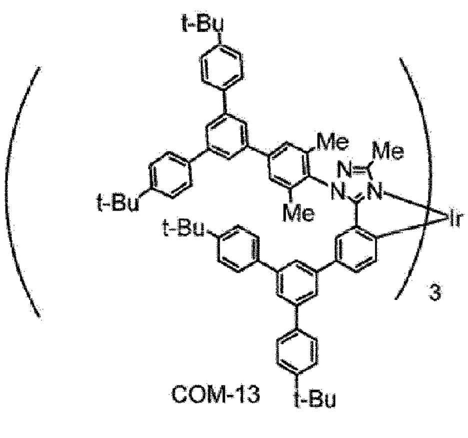
COM-13

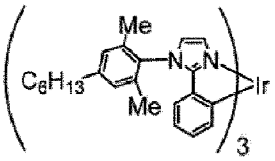
COM-14

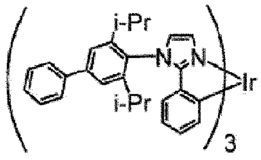
COM-15

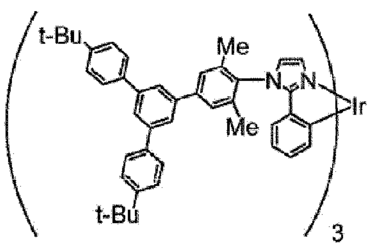
COM-16

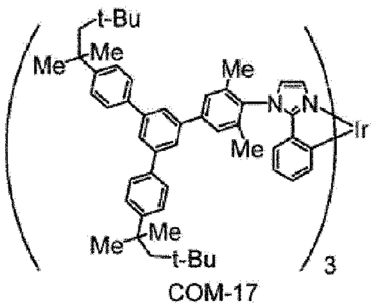
COM-17

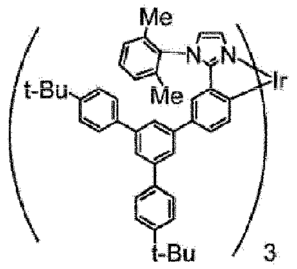
COM-18

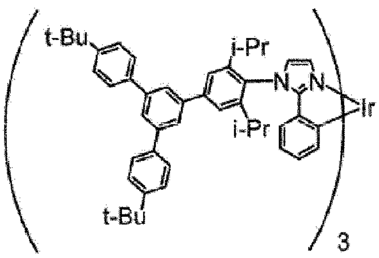
COM-19

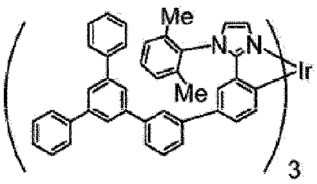
COM-20

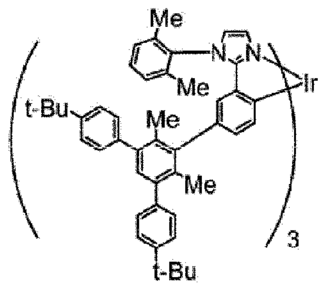
COM-21

In the composition according to the present embodiment, the content of the light emission material is usually 0.1 to 400 parts by mass based on 100 parts by mass of the metal complex represented by formula (1).

[Antioxidant]

The antioxidant is preferably a compound that is soluble in the same solvent as the metal complex represented by formula (1) and does not inhibit photoluminescence and charge transporting. Examples of the antioxidant include a phenol type antioxidant and a phosphorus type antioxidant.

In the composition according to the present embodiment, the amount of the antioxidant blended is, based on 100 parts by mass of the metal complex represented by formula (1), usually 0.001 to 10 parts by mass.

One antioxidant may be used alone, or two or more antioxidants may be used in combination.

<Film>

The film according to the present embodiment contains a metal complex represented by formula (1). The film according to the present embodiment is suitable, for example, as a light emitting layer in the light emitting device.

The film according to the present embodiment can be produced using the ink, for example, by spin coating, casting, micro gravure coating, gravure coating, bar coating, roll coating, wire bar coating, dip coating, spray coating, screen printing, flexographic printing, an offset printing method, ink jet printing, capillary coating, and nozzle coating.

The thickness of the film is usually 1 nm to 10 μm.

<Light Emitting device>

The light emitting device according to the present embodiment contains the metal complex represented by formula (1).

The light emitting device according to the present embodiment may have, for example, electrodes consisting

of an anode and a cathode; and a layer containing a metal complex represented by formula (1) provided between the electrodes.

[Layer Structure]

The layer containing the metal complex represented by formula (1) is usually one or more layers of a light emitting layer, a hole transporting layer, a hole injecting layer, an electron transporting layer, and an electron injecting layer, and preferably a light emitting layer. These layers respectively contain a light emission material, a hole transporting material, a hole injecting material, an electron transporting material, and an electron injecting material. These layers can be formed by dissolving the materials of respective layers in a solvent described above to prepare inks and using the method same as the method of producing the film described above.

The light emitting device according to the present embodiment may have a light emitting layer between the anode and the cathode. The light emitting device according to the present embodiment has preferably at least one layer of the hole injecting layer and the hole transporting layer between the anode and the light emitting layer from the viewpoint of hole injectability and hole transportability and preferably at least one layer of the electron injecting layer and the electron transporting layer between the cathode and the light emitting layer from the viewpoint of electron injectability and electron transportability.

Examples of materials of the hole transporting layer, the electron transporting layer, the light emitting layer, the hole injecting layer, and the electron injecting layer include, besides the metal complex represented by formula (1), the hole transporting material, the electron transporting material, the light emission material, the hole injecting material, and the electron injecting material described above, respectively.

The material of the hole transporting layer, the material of the electron transporting layer, and the material of the light emitting layer may have a cross-linking group and such a layer may be insolubilized by forming layers using materials having a cross-linking group and then cross-linking respective materials. By this, it can be avoided that the material of each layer is dissolved into the solvent used in the formation of an adjacent layer.

Examples of the method of formation of each of the light emitting layer, the hole transporting layer, the electron transporting layer, the hole injecting layer, and the electron injecting layer in the light emitting device according to the present embodiment include vacuum deposition from powder and methods of forming a film from a solution or a molten state when using a low molecular weight compound and methods of forming a film from a solution or a molten state when using a polymer compound.

The order and number of layers to be laminated and the thickness of each layer are adjusted in consideration of external quantum efficiency and luminance lifetime.

[Substrate/Electrode]

The substrate in the light emitting device is preferably a substrate that can form electrodes and do not change chemically when organic layers are formed. The substrate may be any substrate made of a material such as, for example, glass, plastic, or silicon. The substrate is preferably transparent or semitransparent and, in the case of an opaque substrate, the electrode that is most distant from the substrate is transparent or semitransparent.

Examples of the material of the anode include conductive metal oxides and translucent metals. The anode material is preferably indium oxide, zinc oxide, or tin oxide; a conductive compound such as indium tin oxide (ITO) or indium zinc oxide; a complex of silver, palladium, and copper (APC); NESA, gold, platinum, silver, or copper.

Examples of the material of the cathode include metals such as lithium, sodium, potassium, rubidium, cesium, beryllium, magnesium, calcium, strontium, barium, aluminum, zinc, and indium; alloys of two or more of those metals; alloys of one or more of those metals with one or more of silver, copper, manganese, titanium, cobalt, nickel, tungsten, and tin; and graphite and graphite intercalation compounds. Examples of the alloys include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

The anode and the cathode may each have a laminated structure of 2 or more layers.

[Applications]

To obtain planar light emission using a light emitting device, a planar anode and a planar cathode may be arranged so as to overlap each other. Examples of methods for obtaining patterned light emission include a method in which a mask having a patterned window is disposed on the surface of a planar light emitting device, a method in which a layer that is not intended to emit light is formed very thickly so as to substantially prevent light emission, and a method in which the anode or the cathode, or both electrodes, are formed in a pattern shape. By forming a pattern by any of these methods and arranging such that several electrodes can be independently switched ON/OFF, a segment type

display device capable of displaying numerals, letters, and the like is obtained. To obtain a dot matrix display device, the anodes and the cathodes are formed in a striped shape so as to be orthogonal to each other. Partial color display and multi-color display can be achieved by a method in which a plurality of polymer compounds having different emission colors are used for separate paining or a method in which a color filter or a fluorescence conversion filter are used. A dot matrix display device can be driven passively, or can be driven actively in combination with TFT and the like. These display devices can be used as a display in computers, television sets, mobile terminals, and the like. A planar light emitting device can be suitably used as a planar light source for a backlight in a liquid crystal display or as a planar illumination light source. When a flexible substrate is used, the light emitting device can also be used as a curved light source and a curved display.

Preferred embodiments of the present invention have been described in the foregoing, but the present invention is not limited to the embodiments described above.

## Examples

The present invention will now be described in more detail by the following Examples, but the present invention is not limited to these Examples. Any Examples relating solely to compounds falling outside the scope of the claims are included for reference only and are not part of the present invention.

LC-MS was measured by the following method.

The measurement sample was dissolved in chloroform or tetrahydrofuran so as to have a concentration of about 2 mg/mL, and about 1 μL was injected into an LC-MS (trade name: 1100 LC-MSD, manufactured by Agilent). The LC-MS mobile phase was flowed at a rate of 0.2 mL/min while varying the ratio of acetonitrile and tetrahydrofuran. An L-column 2 ODS (3 μm) (manufactured by the Chemicals Evaluation and Research Institute, inner diameter: 2.1 mm, length: 100 mm, particle diameter 3 μm) was used for the column.

NMR was measured by the following method.

A measurement sample of 5 to 10 mg was dissolved in about 0.5 mL of deuterated chloroform ($CDCl_3$), heavy tetrahydrofuran, heavy dimethyl sulfoxide, heavy acetone, heavy N,N-dimethylformamide, heavy toluene, heavy methanol, heavy ethanol, heavy 2-propanol, or heavy methylene chloride, and measured using an NMR apparatus (trade name: INOVA 300 or MERCURY 400 VX, manufactured by Agilent, or trade name: ECZ 400S, manufactured by JEOL Ltd.).

As an index of the purity of the compound, the value of the high-performance liquid chromatography (HPLC) area percentage was used. Unless noted otherwise, this value is the value at UV=254 nm in the HPLC apparatus (product name: LC-20A, manufactured by Shimadzu Corporation). At this time, the compound to be measured was dissolved in tetrahydrofuran or chloroform so as to have a concentration of 0.01 to 0.2% by mass, and 1 to 10 μL was injected into the HPLC apparatus in accordance with the concentration. For the HPLC mobile phase, the ratio of acetonitrile/tetrahydrofuran was varied between 100/0 to 0/100 (volume ratio) while flowing at a flow rate of 1.0 mL/min. As the column, a Kaseisorb LC ODS 2000 (manufactured by Tokyo Chemical Industry) or an ODS column having equivalent performance was used. For the detector, a photodiode array detector (trade name: SPD-M20A, manufactured by Shimadzu Corporation) was used.

As an index of the purity of the compound, the value of gas chromatography (GC) area percentage was used. Unless noted otherwise, this value is the value in a GC (manufactured by Agilent Technologies Inc., trade name: Agilent 7820). At this time, the compound to be measured was dissolved in tetrahydrofuran or chloroform so as to have a concentration of 0.01 to 0.2% by mass and 1 to 10 μL, depending on the concentration, was injected into a GC. Helium was used as a carrier and flowed at a rate of 1.0 mL/min. The column oven was used at changing temperatures of 50°C to 300°C. The heater temperature was 280°C at the injection port and 320°C at the detector. The column used was BPX-5 (30 m × 0.25 mm × 0.25 μm) manufactured by SGE.

TLC-MS was measured by the following method.

The measurement sample was dissolved in a solvent of either toluene, tetrahydrofuran, or chloroform at an arbitrary concentration, and the solution was coated on a TLC plate for DART (trade name: YSK5-100, manufactured by Techno Applications), and then measurement was carried out using TLC-MS (trade name: JMS-T100TD (The AccuTOF TLC), manufactured by JEOL Ltd.). The helium gas temperature during the measurement was adjusted in the range of 200 to 400°C.

<Example 1> Synthesis of Metal Complex 1

Metal complex 1 was synthesized by the following method.

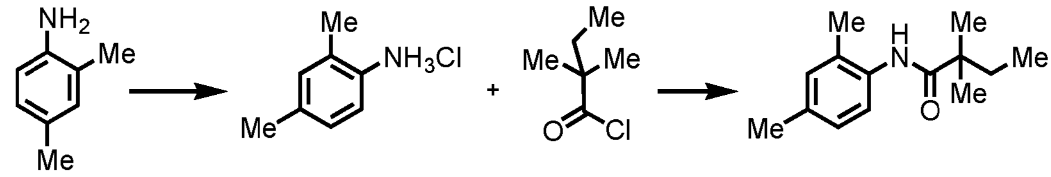

Compound 1a Compound 1b

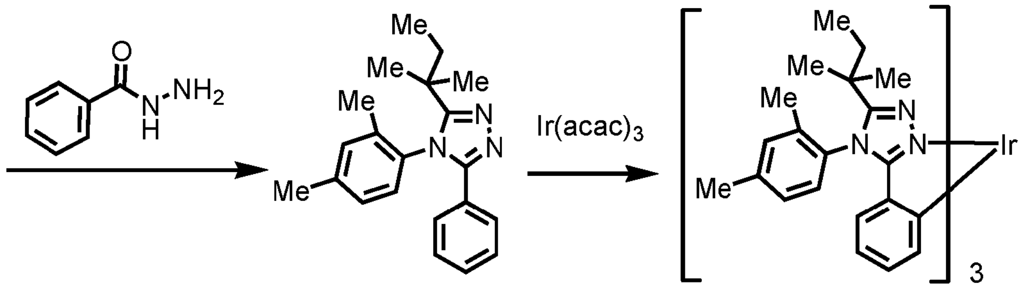


Compound 1c Metal Complex 1

The atmosphere within a reaction vessel was replaced with nitrogen gas, then the reaction vessel was charged with 2,4-dimethylaniline (200 g) and cyclopentylmethyl ether (400 mL) and the mixture was stirred. Then, the reaction vessel was cooled in an ice bath and a 16% by mass hydrogen chloride solution (357 g) in cyclopentyl methyl ether was added dropwise thereto. After the dropwise addition, the mixture was further stirred for 1 hour at room temperature and a deposited solid was filtered out and the obtained solid was washed with hexane (150 mL). The obtained solid was recrystallized from 2-propanol and dried under reduced pressure at room temperature to obtain compound 1a (220 g, a lightly red solid).

The atmosphere within a reaction vessel was replaced with nitrogen gas, then the reaction vessel was charged with compound 1a (140 g), chloroform (2100 mL), and triethylamine (267 mL) and the mixture was stirred. Then, the reaction vessel was placed in an ice bath to cool and 2,2-dimethylbutyryl chloride (113 mL) was added dropwise. After the dropwise addition, the mixture was further stirred for 1 hour at room temperature, then saturated aqueous sodium carbonate solution (400 mL) was added, and the mixture was stirred at room temperature. The obtained mixture was separated into two phases and the obtained organic layer was washed with saturated aqueous sodium carbonate solution and ion-exchanged water. The obtained washing solution was separated into two phases and the obtained organic layer was dried over magnesium sulfate and then filtered. The obtained filtrate was concentrated, then heptane was added, and the mixture was stirred and the obtained solid was filtered out. The obtained solid was dried under reduced pressure at 40°C to obtain compound 1b (164 g, a white solid). The HPLC area percentage value of compound 1b was 99.5% or more.

The result of NMR measurement of compound 1b was as follows.

$^1$H-NMR ($CDCl_3$, 400 MHz) $\delta$ (ppm): 0.94 (3H, t), 1.29 (6H, s), 1.67 (2H, q), 2.21 (3H, s), 2.28 (3H, s), 6.99 (1H, s), 7.00 (1H, d), 7.12 (1H, br), 7.65 (1H, d).

The atmosphere within a reaction vessel was replaced with argon gas, then the reaction vessel was charged with compound 1b (60 g), monochlorobenzene (480 mL), 2-fluoropyridine (26 mL), and trifluoromethanesulfonic acid anhydride (50 mL), and the mixture was stirred at room temperature for 30 minutes. Then, the reaction vessel was charged with benzhydrazide (41 g) and the mixture was stirred at 90°C for 3 hours. Then, the reaction vessel was charged with an aqueous sodium hydrogen carbonate solution (500 mL), the organic layer was extracted, and the obtained organic layer was washed with ion-exchanged water. The obtained organic layer was concentrated under reduced pressure to obtain a solid. The obtained solid was purified by silica gel column chromatography (mixed solvent of chloroform and tetrahydrofuran) and recrystallized from a mixed solvent of 2-propanol and heptane. The obtained solid was dried under reduced pressure at 50°C to obtain compound 1c (70 g, yield 80%) as a white solid. The HPLC area percentage value of compound 1c was 99.5% or more.

The result of LC-MS and NMR measurement of compound 1c was as follows.

LC-MS (APCI, positive): m/z = 320 $[M+H]^+$

$^1$H-NMR (600 MHz, $CD_2Cl_2$) $\delta$ (ppm): 7.42-7.37 (m, 2H), 7.35-7.31 (m, 2H), 7.29-7.25 (m, 2H), 7.19 (d, 1H), 7.07 (s, 1H), 2.40 (s, 3H), 1.79-1.72 (m, 4H), 1.57-1.45 (m, 1H), 1.34 (s, 3H), 1.15 (s, 3H), 0.89 (t, 3H).

The atmosphere within a reaction vessel was replaced with argon gas, then the reaction vessel was charged with trisacetylacetonatoiridium (0.96 g), compound 1c (2.50 g), and pentadecane (6.25 mL) and the mixture was stirred under reflux for 51 hours. Then, the reaction vessel was charged with toluene and the mixture was filtered with a filter

lined with silica gel. Then, the obtained silica gel was extracted with a mixed solvent of toluene and ethyl acetate to obtain a yellow solution containing metal complex 1. The obtained solution was concentrated under reduced pressure to obtain a solid and then the obtained solid was purified by preparative silica gel column chromatography (a mixed solvent of toluene and ethyl acetate) to obtain metal complex 1. 4 isomers of metal complex 1 were found in the purification. A mixture of isomer 1, isomer 2, isomer 3, and isomer 4 was obtained as a product.

The obtained isomer 1 was further recrystallized from a mixed solvent of toluene and acetonitrile. The obtained solid was dried under reduced pressure at 50°C to obtain a yellow solid (0.18 g, yield 8%). The HPLC area percentage value of isomer 1 was 99.4%.

The results of LC-MS and NMR measurement of isomer 1 were as follows.

LC-MS (APCI, positive): m/z = 1149 $[M+H]^+$

$^1$H-NMR (400 MHz, $CD_2Cl_2$) δ (ppm) = 7.29 (d, 3H), 7.21-7.14 (m, 6H), 7.04 (d, 3H), 7.65 (t, 3H), 7.41 (t, 3H), 5.91 (d, 3H), 2.43 (s, 9H), 2.03 (s, 9H), 1.66-1.56 (m, 3H), 1.43-1.31 (m, 3H), 1.17-1.07 (m, 18H), 0.87 (t, 9H).

The obtained isomer 2 was further recrystallized from a mixed solvent of toluene and acetonitrile. The obtained solid was dried under reduced pressure at 50°C to obtain a yellow solid (0.40 g, yield 18%). The HPLC area percentage value of isomer 2 was 99.3%.

The results of LC-MS and NMR measurement of isomer 2 were as follows.

LC-MS (APCI, positive): m/z = 1149 $[M+H]^+$

$^1$H-NMR (400 MHz, $CD_2Cl_2$) δ (ppm) = 7.27-7.13 (m, 9H), 6.83 (d, 1H), 6.75-6.67 (m, 2H), 6.63-6.53 (m, 3H), 6.46-6.33 (m, 3H), 5.99-5.86 (m, 3H), 2.47-2.40 (m, 9H), 2.05 (s, 6H), 1.78 (s, 3H), 1.59-1.43 (m, 4H), 1.42-1.27 (m, 2H), 1.23 (s, 3H), 1.20-1.16 (m, 6H), 1.14 (s, 3H), 1.10 (s, 3H), 1.03 (s, 3H), 0.78 (t, 3H), 0.72-0.62 (m, 6H).

A mixture of isomers 3 and 4 was further purified by silica gel column chromatography (a mixed solvent of toluene and ethyl acetate) and then recrystallized in a mixed solvent of toluene and acetonitrile. The obtained solid was dried under reduced pressure at 50°C to obtain a yellow solid (0.62 g, yield 28%). The HPLC area percentage values of the mixture of isomers 3 and 4 were 24% for isomer 3 and 75% for isomer 4.

The results of LC-MS and NMR measurement of isomers 3 and 4 were as follows.

LC-MS (APCI, positive): m/z = 1149 [M+H]+

$^1$H-NMR (400 MHz, $CD_2Cl_2$) δ (ppm) = 7.29 (t, 9H), 7.23-7.10 (m, 27H), 6.67-6.48 (m, 24H), 6.46-6.34 (m, 12H), 5.98-5.86 (m, 12H), 2.45 (s, 9H), 2.44-2.40 (m, 27H), 2.08 (s, 9H), 1.83 (s, 9H), 1.80-1.74 (m, 18H), 1.73-1.62 (m, 6H), 1.57-1.40 (m, 9H), 1.39-1.27 (m, 18H), 1.24 (s, 9H), 1.22-1.14 (m, 27H), 1.08 (s, 9H), 1.05 (s, 18H), 0.79 (t, 9H), 0.69 (t, 9H), 0.64 (t, 18H).

<Example 2> Synthesis of Metal Complex 2

Metal complex 2 was synthesized by the following method.

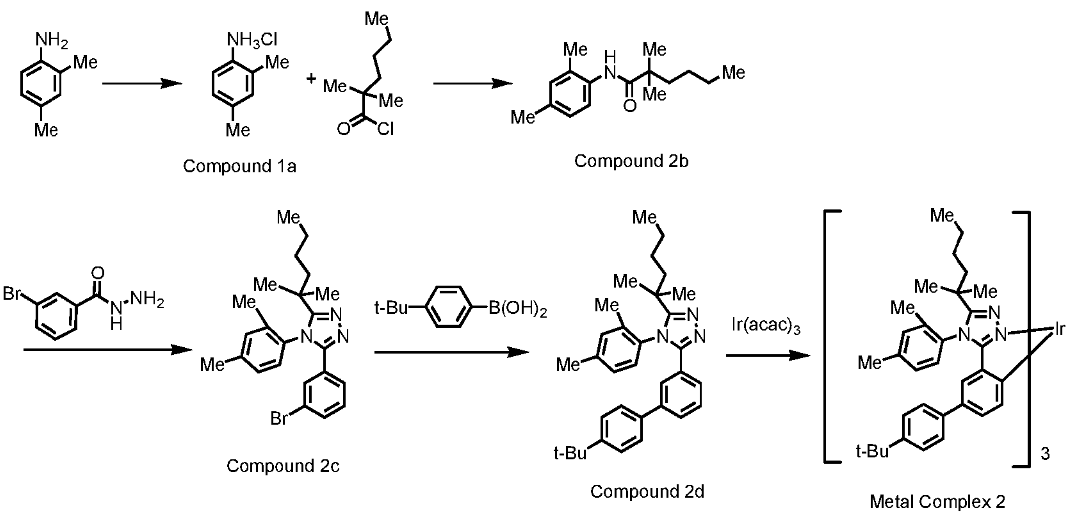


Compound 1a

Compound 2b

Compound 2c

Compound 2d

Metal Complex 2

The atmosphere within a reaction vessel was replaced with argon gas, then the reaction vessel was charged with 2,2'-dimethylhexanoic acid (40 g), chloroform (240 mL), N,N'-dimethylformamide (0.21 mL), and thionyl chloride (20 mL) and the mixture was stirred at 45°C for 3 hours. Then, the reaction vessel was placed in a water bath to cool and a reaction solution containing 2,2'-dimethylhexanoyl chloride was obtained.

The atmosphere within a separately-prepared reaction vessel was replaced with argon gas, then the reaction

vessel was charged with compound 1a (41.5 g), chloroform (400 mL), and triethylamine (75 mL) and placed in an ice bath to cool. Then, the reaction solution containing 2,2'-dimethylhexanoyl chloride obtained as described above was added dropwise thereto. After the dropwise addition, the mixture was further stirred for 1 hour at room temperature, then a 2 mol/L aqueous sodium carbonate solution (280 mL) was added, and the mixture was stirred at room temperature. The obtained mixture was separated into two phases and an organic layer was obtained. The obtained organic layer was washed with ion-exchanged water (280 mL). The obtained organic layer was dried over anhydrous magnesium sulfate and then concentrated under reduced pressure to obtain compound 2b (60 g, yield 88%) as a light yellow oily substance. The HPLC area percentage value of compound 2b was 99.5% or more.

The result of TLC-MS measurement of compound 2b was as follows.
TLC-MS (DART, positive): m/z = 248 $[M+H]^+$

The atmosphere within a reaction vessel was replaced with argon gas, then the reaction vessel was charged with compound 2b (40 g), monochlorobenzene (320 mL), 2-fluoropyridine (14 mL), and trifluoromethanesulfonic acid anhydride (27 mL) and the mixture was stirred at room temperature for 30 minutes. Then, the reaction vessel was charged with 3-bromobenzhydrazide (35 g) and the mixture was stirred at 90°C for 7 hours. Then, a 2 mol/L aqueous sodium hydrogen carbonate solution (160 mL) was added thereto and stirred, then the organic layer was extracted, and the obtained organic layer was washed with ion-exchanged water. The obtained organic layer was concentrated under reduced pressure to obtain an oily substance. The obtained oily substance was purified by silica gel column chromatography (a mixed solvent of chloroform and ethanol) and then recrystallized from heptane. The obtained solid was dried under reduced pressure at 50°C to obtain compound 2c (48 g, yield 77%) as a white solid. The HPLC area percentage value of compound 2c was 99.5% or more.

The results of LC-MS and NMR measurement of compound 2c were as follows.
LC-MS (APPI, positive): m/z = 426 $[M+H]^+$
$^1$H-NMR (400 MHz, $CD_2Cl_2$) $\delta$ (ppm) = 7.60-7.55 (m, 1H), 7.41 (d, 1H), 7.25 (d, 1H), 7.21-7.13 (m, 2H), 7.09-7.03 (m, 2H), 2.36 (s, 3H), 1.76-1.59 (m, 4H), 1.43-1.07 (m, 11H), 0.84 (t, 3H).

The atmosphere within a reaction vessel was replaced with argon gas, then the reaction vessel was charged with compound 2c (2.2 g), 4-tert-butylphenylboronic acid (1.0 g), toluene (22 mL), and (di-tert-butyl(4-dimethylaminophenyl)phosphine)dichloropalladium (II) (18 mg) and the temperature was increased to 80°C. Then, the reaction vessel was charged with a 20% by mass aqueous tetrabutylammonium hydroxide solution (16 mL) and the mixture was stirred under reflux for 18 hours. The obtained reaction mixture was cooled to room temperature. Then, toluene was added, and the organic layer was extracted. The obtained organic layer was washed with ion-exchanged water, dried over anhydrous magnesium sulfate and then filtered through a filter lined with silica gel and Celite, and the obtained filtrate was concentrated under reduced pressure to obtain a solid. The obtained solid was purified by silica gel column chromatography (a mixed solvent of chloroform and ethanol) and then recrystallized from heptane. The obtained solid was dried under reduced pressure at 50°C to obtain compound 2d (2.2 g, yield 85%) as a white solid. The HPLC area percentage value of compound 2d was 99.5% or more.

The results of LC-MS and NMR measurement of compound 2d were as follows.
LC-MS (APPI, positive): m/z = 480 $[M+H]^+$
$^1$H-NMR (400 MHz, $CD_2Cl_2$) $\delta$ (ppm) = 7.53-7.48 (m, 1H), 7.46-7.39 (m, 2H), 7.40-7.37 (m, 2H), 7.34-7.29 (m, 2H), 7.26-7.19 (m, 3H), 7.07 (s, 1H), 2.40 (s, 3H), 1.74 (s, 3H), 1.70-1.61 (m, 1H), 1.47-1.36 (m, 1H), 1.34-1.30 (m, 12H), 1.29-1.14 (m, 4H), 1.12 (s, 3H), 0.86 (t, 3H)

The atmosphere within a reaction vessel was replaced with argon gas, then the reaction vessel was charged with trisacetylacetonatoiridium (1.0 g), compound 2d (2.0 g), and pentadecane (3 mL) and the mixture was stirred under reflux for 46 hours. Then, the reaction vessel was charged with toluene and the mixture was filtered through a filter lined with silica gel. Then, the obtained silica gel was extracted with a mixed solvent of toluene and ethyl acetate to obtain a yellow solution containing metal complex 2. The obtained solution was concentrated under reduced pressure to obtain a solid and then the obtained solid was washed with acetonitrile and heptane and purified by silica gel column chromatography (a mixed solvent of toluene and ethyl acetate). The obtained solid was recrystallized from a mixed solvent of toluene and acetonitrile and then dried under reduced pressure at 50°C to obtain metal complex 2 (1.0 g) as a yellow solid. The HPLC area percentage value of metal complex 2 was 98.8%.

The results of LC-MS and NMR measurement of metal complex 2 were as follows.
LC-MS (APCI, positive): m/z = 1629 $[M+H]^+$
$^1$H-NMR (400 MHz, $CD_2Cl_2$) $\delta$ (ppm) = 7.41-7.16 (m, 15H), 7.10-6.64 (m, 12H), 6.19-6.04 (m, 3H), 2.54-2.43 (m, 9H), 2.16-1.67 (m, 9H), 1.62-1.03 (m, 63H), 0.85-0.63 (m, 9H).

<Example 3> Synthesis of Metal Complex 3

Metal complex 3 was synthesized by the following method.

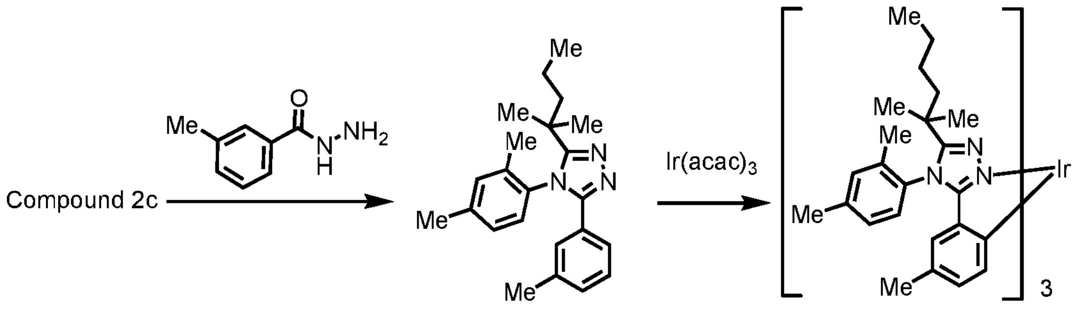


Compound 3a    Metal Complex 3

The atmosphere within a reaction vessel was replaced with argon gas, then the reaction vessel was charged with compound 2c (10.0 g), monochlorobutane (80 mL), 2-fluoropyridine (4 mL), and trifluoromethanesulfonic acid anhydride (7 mL), and the mixture was stirred at room temperature for 30 minutes. Then, the reaction vessel was charged with 3-methyl benzhydrazide (6.4 g) and the mixture was stirred at 85°C for 5 hours. Then, the reaction vessel was charged with a 2 mol/L aqueous sodium hydrogen carbonate solution (43 mL), the mixture was stirred, then the organic layer was extracted, and the obtained organic layer was washed with ion-exchanged water. The obtained organic layer was concentrated under reduced pressure to obtain an oily substance. The obtained oily substance was purified by silica gel column chromatography (a mixed solvent of chloroform and ethanol) and then the obtained solid was recrystallized from heptane. The obtained solid was dried under reduced pressure at 50°C to obtain compound 3a (5.5 g) as a white solid. The HPLC area percentage value of compound 3a was 99.5% or more.

The results of LC-MS and NMR measurement of compound 3a were as follows.
LC-MS (APPI, positive): m/z = 362 $[M+H]^+$
$^1$H-NMR (400 MHz, $CD_2Cl_2$) $\delta$ (ppm) = 7.28-7.22 (m, 2H), 7.16-6.95 (m, 5H), 2.34 (s, 3H), 2.22 (s, 3H), 1.71 (s, 3H), 1.68-1.57 (m, 1H), 1.43-1.33 (m, 1H), 1.32-1.07 (m, 10H), 0.86 (t, 3H).

The atmosphere within a reaction vessel was replaced with argon gas, then the reaction vessel was charged with trisacetylacetonatoiridium (1.9 g), compound 3a (5.0 g), and pentadecane (10 mL), and the mixture was stirred under reflux for 36 hours. Then, the reaction vessel was charged with toluene and the mixture was filtered through a filter lined with silica gel. Then, the obtained silica gel was extracted with a mixed solvent of toluene and ethyl acetate to obtain a yellow solution containing metal complex 3. The obtained solution was concentrated under reduced pressure to obtain a solid and then the obtained solid was purified by silica gel column chromatography (a mixed solvent of toluene and ethyl acetate). The obtained solid was recrystallized from a mixed solvent of ethyl acetate and heptane and then dried under reduced pressure at 50°C to obtain metal complex 3 (2.4 g) as a yellow solid. The HPLC area percentage value of the metal complex 3 was 92.6%.

The results of LC-MS and NMR measurement of metal complex 3 were as follows.
LC-MS (APCI, positive): m/z = 1629 $[M+H]^+$
$^1$H-NMR (400 MHz, $CD_2Cl_2$) $\delta$ (ppm) = 7.33-7.01 (m, 9H), 6.75-6.31 (m, 6H), 5.80-5.59 (m, 3H), 2.50-2.39 (m, 9H), 2.13-1.72 (m, 18H), 1.61-0.90 (m, 36H), 0.85-0.62 (m, 9H).

<Example 4> Synthesis of Metal Complex 4

Metal complex 4 was synthesized by the following method.

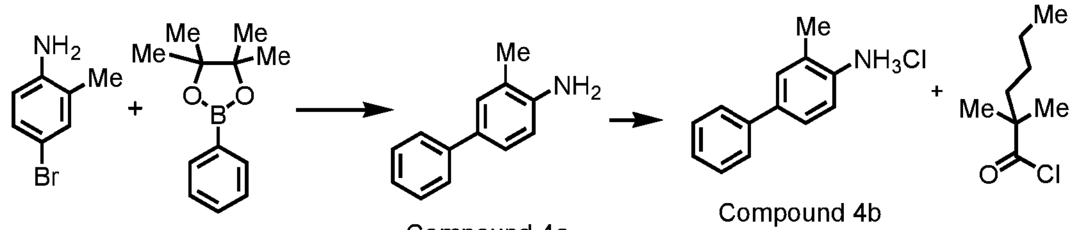

Compound 4a

Compound 4b

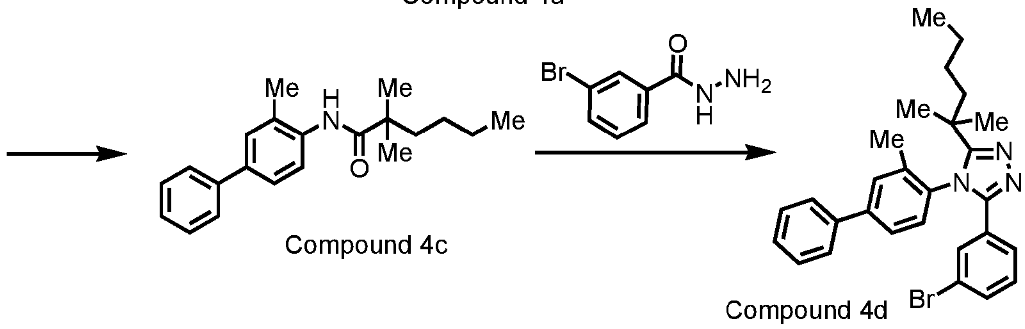

Compound 4c

Compound 4d

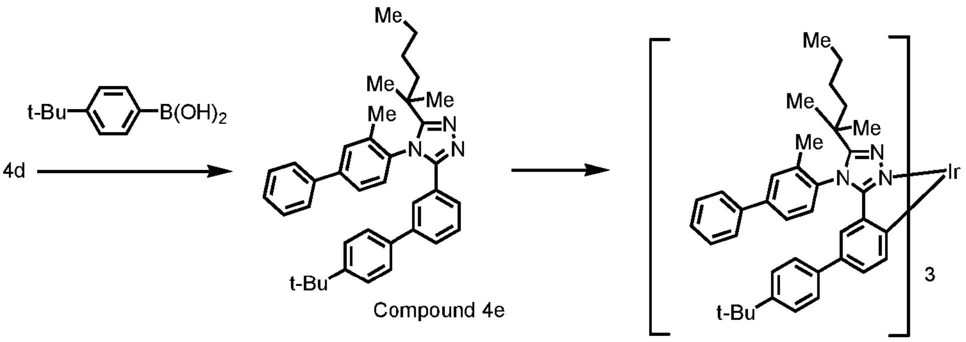

Compound 4d

Compound 4e

Metal Complex 4

The atmosphere within a reaction vessel was replaced with argon gas, then the reaction vessel was charged with 2-phenyl-4,4,5,5-tetramethyl-1,3,2-dioxaborolane (50 g), 2-methyl-4-bromoaniline (46 g), tris(dibenzylideneacetone)dipalladium (0) (3 g), 2-dicyclohexylphosphino-2',6'-dimethoxybiphenyl (4 g), and toluene (1L) and the mixture was stirred at room temperature. Then, a 20% by mass aqueous tetraethylammonium hydroxide solution was added dropwise thereto and the mixture was stirred at 70°C for 5 hours. The obtained reaction mixture was cooled to room temperature and then separated into two phases and the obtained organic layer was washed with ion-exchanged water. The obtained washing solution was separated into two phases, the obtained organic layer was dried over magnesium sulfate and filtered, and the obtained filtrate was concentrated. Then, a procedure involving adding tetrahydrofuran and activated clay to the concentrated filtrate, stirring the mixture at room temperature for 30 minutes, and then filtering the mixture through a filter lined with Celite was repeated twice. The obtained filtrate was concentrated under reduced pressure, toluene and active carbon were added to the concentrated filtrate, the mixture was stirred at room temperature for 30 minutes and then filtered through a filter lined with Celite, and the obtained filtrate was concentrated. This procedure was repeated to obtain compound 4a (92 g, reddish brown oil). The GC area percentage value of compound 4a was 99.5% or more.

The atmosphere within a reaction vessel was replaced with nitrogen gas, then the reaction vessel was charged with compound 4a (92 g) and cyclopentyl methyl ether (214 mL) and the mixture was stirred. Then, the reaction vessel was placed in an ice bath to cool and a cyclopentyl methyl ether solution (114 g) of 16% by mass hydrogen chloride and then heptane (649 mL) were added dropwise. After the dropwise addition, the mixture was further stirred for 1 hour at room temperature, a deposited solid was filtered out and the obtained solid was washed with heptane and acetone. The obtained solid was recrystallized a plurality of times from 2-propanol, methanol, ethanol, and heptane and dried under reduced pressure at room temperature to obtain compound 4b (37 g, a lightly red solid). This procedure was repeated to obtain a required amount.

The result of the NMR measurement of compound 4b was as follows.

$^1$H-NMR (400 MHz, $CDCl_3$) $\delta$ (ppm) = 7.33-7.65 (8H, m), 4.85 (3H, s), 2.46 (3H, s).

The atmosphere within a reaction vessel was replaced with argon gas, then the reaction vessel was charged

with 2,2'-dimethylhexanoic acid (29 g), chloroform (174 mL), and N,N'-dimethylformamide (0.14 g), and the mixture was stirred at 50°C. Then, thionyl chloride (24 g) was added dropwise thereto and the mixture was stirred at 50°C for 4 hours to obtain 2,2'-dimethylhexanoyl chloride.

The atmosphere within a separately-prepared reaction vessel was replaced with nitrogen gas, then the reaction vessel was charged with compound 4b (39 g), chloroform (290 mL), and triethylamine (47 mL), and the mixture was stirred. Then, the reaction vessel was placed in an ice bath to cool and 2,2'-dimethyl hexanoyl chloride prepared as described above was added dropwise. After the dropwise addition, the mixture was further stirred for 2 hours at room temperature, then saturated aqueous sodium carbonate solution (300 mL) was added, and the mixture was stirred at room temperature. The obtained mixture was separated into two phases and the obtained organic layer was washed with saturated aqueous sodium carbonate solution and ion-exchanged water. The obtained washing solution was separated into two phases and the obtained organic layer was dried over magnesium sulfate and then filtered. The obtained filtrate was concentrated under reduced pressure and then purified by preparative silica gel column chromatography (a mixed solvent of hexane and ethyl acetate) to obtain an oily compound. Hexane was added to the obtained oily compound and the mixture was stirred for 1 hour while cooling the reaction vessel in acetone bath containing dry ice and the obtained solid was filtered out. The obtained solid was dried under reduced pressure at 50°C to obtain compound 4c (40 g, a white solid). The HPLC area percentage value of compound 4c was 99.5% or more.

The result of NMR measurement of compound 4c was as follows.

$^1$H-NMR (400 MHz, $CDCl_3$) δ (ppm) = 7.98 (1H, d), 7.55 (1H, d), 7.42 (1H, t), 7.41 (4H, m), 7.31 (1H, t), 2.32 (3H, s), 1.62 (2H, s), 1.35 (10H, s), 0.91 (3H, s).

The atmosphere within a reaction vessel was replaced with argon gas, then the reaction vessel was charged with compound 4c (30 g), monochlorobenzene (300 mL), 2-fluoropyridine (9 mL), and trifluoromethanesulfonic acid anhydride (18 mL), and the mixture was stirred at room temperature for 30 minutes. Then, the reaction vessel was charged with 2-bromobenzoylhydrazine (23 g) and the mixture was stirred at 90°C for 3 hours. Then, an aqueous sodium hydrogen carbonate solution (300 mL) was added thereto, the organic layer was extracted, and the obtained organic layer was washed with ion-exchanged water. The obtained organic layer was concentrated under reduced pressure to obtain a solid. Hexane was added to the obtained solid and the solid was washed. The washed solid was recrystallized from 2-propanol, heptane, and acetonitrile plural times. The obtained solid was dried under reduced pressure at 50°C to obtain compound 4d (31 g) as a white solid. The HPLC area percentage value of compound 4d was 99.5% or more.

The results of LC-MS and NMR measurement of compound 4 were as follows.

LC-MS (APCI, positive): m/z = 488 $[M+H]^+$

$^1$H-NMR (400 MHz, $CDCl_3$) δ (ppm) = 7.57-7.64 (m, 4H), 7.38-7.49 (m, 6H), 7.28-7.30 (d, 1H), 7.07 (t, 1H), 1.85 (3H, s), 1.67-1.74 (2H, m), 1.42-1.50 (1H, m), 1.39 (3H, s), 1.14-1.36 (3H, m), 1.17 (3H, s), 0.88 (3H, t).

The atmosphere within a reaction vessel was replaced with argon gas, then the reaction vessel was charged with compound 4d (10 g), 4-tert-butylphenylboronic acid (4 g), and toluene, and the mixture was stirred at room temperature. Then, the reaction vessel was charged with bis(di-tert-butyl(4-dimethylaminophenyl)phosphine)dichloropalladium (72 mg) and the mixture was heated to 90°C. Then, a 20% by mass aqueous tetrabutylammonium hydroxide solution (64 g) was added dropwise thereto and the mixture was stirred at 90°C for 3 hours. Then, the reaction vessel was cooled to room temperature and the obtained mixture was separated into two phases. The obtained organic layer was washed with ion-exchanged water. The obtained washing solution was separated into two phases and the obtained organic layer was washed with ion-exchanged water. The obtained washing solution was separated into two phases and the obtained organic layer was dried over magnesium sulfate and then filtered. Active carbon was added to the obtained filtrate and the mixture was stirred at room temperature for 30 minutes and then filtered through a filter lined with Celite. The obtained filtrate was concentrated under reduced pressure, then hexane was added, and the obtained solid was filtered out. The obtained solid was recrystallized from hexane and 2-propanol a plurality of times and the obtained solid was dried under reduced pressure at 50°C to obtain compound 4e (9 g, a white solid). The HPLC area percentage value of compound 4e was 99.5% or more.

The results of LC=MS and NMR measurement of compound 4e were as follows.

LC-MS (APCI, positive): m/z = 542 $[M+H]^+$

$^1$H-NMR (400 MHz, $CDCl_3$) δ (ppm) = 7.63-7.68 (m, 4H), 7.31-7.52 (m, 8H), 7.25 (d, 2H), 7.15-7.17 (d, 2H), 1.88 (s, 3H), 1.43 (s, 3H), 1.28 (s, 9H), 1.21 (s, 3H), 1.45-1.78 (m, 1H), 1.17-1.39 (m, 5H), 0.88 (3H, t)

The atmosphere within a reaction vessel was replaced with argon gas, then the reaction vessel was charged with trisacetylacetonatoiridium (1.1 g), compound 4e (5.0 g), and pentadecane (13 mL), and the mixture was stirred under reflux for 48 hours. Then, the reaction vessel was charged with toluene and the mixture was filtered through a filter lined with silica gel. Then, a yellow solution containing metal complex 4 was extracted from the obtained silica gel with a mixed solvent of toluene and ethyl acetate. The obtained solution was concentrated under reduced pressure to obtain a solid and then the obtained solid was purified by silica gel column chromatography (a mixed solvent of toluene and ethyl acetate) to obtain a solid. The obtained solid was recrystallized from a mixed solvent of toluene and acetonitrile as well as from a mixed solvent of toluene and hexane, each repeated a plurality of times. The obtained solid was dried

under reduced pressure at 50°C to obtain metal complex 4 (1.7 g, a yellow solid). The HPLC area percentage value of metal complex 4 was 98.3%.

The result of the NMR measurement of metal complex 4 was as follows.

$^1$H-NMR (400 MHz, $CD_2Cl_2$) δ (ppm) = 7.42-7.73 (24H, m), 6.97-7.11 (18H, m), 6.13-6.26 (3H, m), 2.23-2.27 (4H, m), 2.01 (1H, s) 1.94 (1H, s), 0.97-1.89 (34H, m), 1.88 (2H, d), 1.56 (3H, s), 1.20 (27H, s), 0.70-0.84 (9H, m)

<Example 5> Synthesis of Metal Complex 5

Metal complex 5 was synthesized by the following method.

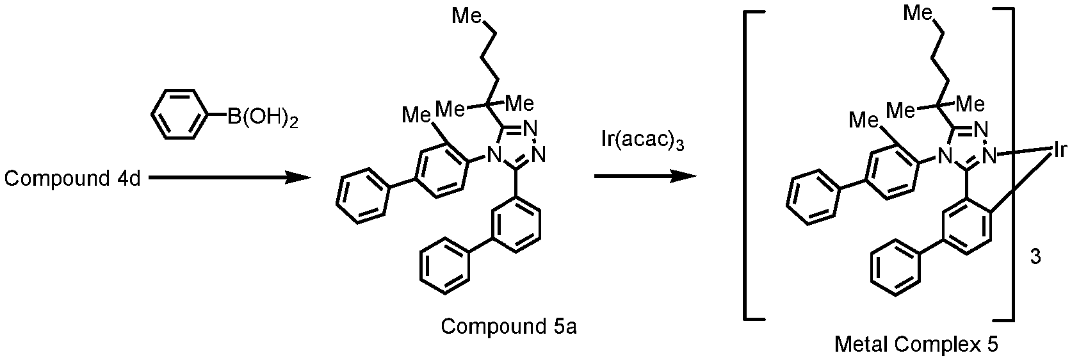


Compound 5a

Metal Complex 5

The atmosphere within a reaction vessel was replaced with argon gas, then the reaction vessel was charged with compound 4d (10.0 g), phenylboronic acid (2.6 g), and toluene (150 mL) and the mixture was stirred at room temperature. Then, the reaction vessel was charged with bis(di-tert-butyl(4-dimethylaminophenyl)phosphine)dichloropalladium (72 mg) and the mixture was heated to 90°C. Then, a 20% by mass aqueous tetrabutylammonium hydroxide solution (64 g) was added dropwise thereto and the mixture was stirred at 90°C for 3 hours. Then, the reaction vessel was cooled to room temperature and the obtained mixture was separated into two phases. The obtained organic layer was washed with ion-exchanged water. The obtained washing solution was separated into two phases and the obtained organic layer was washed with ion-exchanged water. The obtained washing solution was separated into two phases and the obtained organic layer was dried over magnesium sulfate and then filtered. Active carbon was added to the obtained filtrate and the mixture was stirred at room temperature for 30 minutes and then filtered through a filter lined with Celite. The obtained filtrate was concentrated under reduced pressure, then hexane was added, and the obatined solid was filtered out. The obtained solid was recrystallized from hexane and 2-propanol a plurality of times and then the obtained solid was dried under reduced pressure at 50°C to obtain compound 5a (6.3 g, a white solid). The HPLC area percentage value of compound 5a was 99.5% or more.

The results of LC=MS and NMR measurement of compound 5a were as follows.

LC-MS (APCI, positive): m/z = 486 $[M+H]^+$

$^1$H-NMR (400 MHz, $CDCl_3$) δ (ppm) = 7.61-7.66 (m, 4H), 7.41-7.52 (m, 7H), 7.34 (t, 1H), 7.21-7.29 (m, 5H), 1.88 (3H, s), 1.58-1.78 (2H, m), 1.45-1.52 (1H, m), 1.42 (3H, s), 1.17-1.39 (3H, m), 1.21 (3H, s), 0.88 (3H, t)

The atmosphere within a reaction vessel was replaced with argon gas, then the reaction vessel was charged with trisacetylacetonatoiridium (1.1 g), compound 5a (5.0 g), and pentadecane (12.5 mL), and the mixture was stirred under reflux for 40 hours. Then, the reaction vessel was charged with toluene and the mixture was filtered through a filter lined with silica gel. Then, a yellow solution containing metal complex 5 was extracted from the obtained silica gel with a mixed solvent of toluene and ethyl acetate. The obtained solution was concentrated under reduced pressure to obtain a solid and then the obtained solid was purified by preparative silica gel column chromatography (a mixed solvent of toluene and ethyl acetate) to obtain a solid. The obtained solid was recrystallized from a mixed solvent of toluene and acetonitrile as well as from a mixed solvent of toluene and hexane, each repeated a plurality of times. The obtained solid was dried under reduced pressure at 50°C to obtain metal complex 5 (1.8 g, a yellow solid). The HPLC area percentage value of metal complex 5 was 98.6%.

The result of the NMR measurement of metal complex 5 was as follows.

$^1$H-NMR (400 MHz, $CD_2Cl_2$) δ (ppm) = 7.43-7.73 (24H, m), 6.76-7.11 (21H, m), 6.21-6.30 (3H, m), 2.26 (6H, q), 1.91-2.02 (4H, m), 1.56 (3H, s), 0.91-1.82 (32H, m), 0.67-0.83 (9H, m).

<Example 6> Synthesis of Metal Complex 8

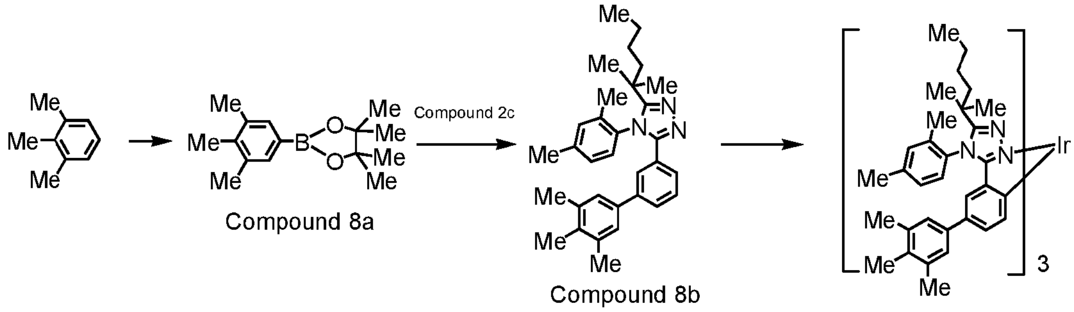


Compound 8a

Compound 8b

Metal Complex 8

The atmosphere within a reaction vessel was replaced with nitrogen gas, then the reaction vessel was charged with 1,2,3-trimethylbenzene (168 g), bispinacolatodiboron (384 g), (1,5-cyclooctadiene)(methoxy)iridium (I) (dimer) (8 g); cyclopentyl methyl ether (1,681 mL) and the mixture was stirred. Then, the reaction vessel was charged with (1,5-cyclooctadiene)(methoxy)iridium (I) (dimer) (10 g) and the mixture was further stirred at 95°C for 6 hours. Then, the reaction vessel was cooled to room temperature to obtain a reaction mixture. The atmosphere within a reaction vessel was replaced with nitrogen gas, then the reaction vessel was charged with methanol (2,391 g), cooled in an ice bath, and, after stirring, charged with the reaction mixture obtained as described above. Then, the reaction vessel was charged with activated clay (336 g) and the mixture was stirred for 30 minutes and then filtered through a filter. The obtained solution was concentrated to obtain a solid. The obtained solid was purified by preparative silica gel column chromatography (a mixed solvent of toluene and hexane). The obtained solid was recrystallized from acetonitrile. The obtained solid was dried under reduced pressure at 50°C to obtain compound 8a (165 g, a white solid).

The result of $^1$H-NMR measurement of compound 8a was as follows.

$^1$H-NMR (400 MHz, $CDCl_3$) $\delta$ (ppm) = 7.46 (s, 2H), 2.29 (s, 6H), 2.19 (s, 3H), 1.34 (s, 12H).

The atmosphere within a reaction vessel was replaced with argon gas, then the reaction vessel was charged with compound 2c (9.0 g), compound 8a (6.2 g), a 40% by mass aqueous tetrabutylammonium hydroxide solution (32.9 g), ion-exchanged water (32.9 g), and toluene (108.0 g) and the mixture was stirred at room temperature. Then, the reaction vessel was charged with bis(di-tert-butyl(4-dimethylaminophenyl)phosphine)dichloropalladium (0.2 g) and the mixture was stirred at 80°C for 2 hours. Then, the reaction vessel was cooled to room temperature and the obtained mixture was separated into two phases. The obtained organic layer was washed with ion-exchanged water (91.0 g). The obtained washing solution was separated into two phases and the obtained organic layer was washed with ion-exchanged water (91.0 g). The obtained washing solution was separated into two phases and the obtained organic layer was dried over magnesium sulfate and then filtered. Active carbon (1.6 g) was added to the obtained filtrate and the mixture was stirred at room temperature for 1 hour and then filtered through a filter lined with Celite. The obtained filtrate was concentrated under reduced pressure to obtain a toluene solution.

The atmosphere within a reaction vessel was replaced with argon gas, then the reaction vessel was charged with the toluene solution (49.9 g) obtained as described above, compound 8a (5.2 g), a 40% by mass aqueous tetrabutylammonium hydroxide solution (32.9 g), ion-exchanged water (32.9 g), and toluene (108.0 g) and the mixture was stirred at room temperature. Then, the reaction vessel was charged with bis(di-tert-butyl(2-butenyl)phosphine)dichloropalladium (0.2 g) and the mixture was stirred at 80°C for 27 hours. Then, the reaction solution was cooled to room temperature and the obtained mixture was separated into two phases. The obtained organic layer was washed with ion-exchanged water. The obtained washing solution was separated into two phases and the obtained organic layer was washed with ion-exchanged water. The obtained washing solution was separated into two phases and the obtained organic layer was dried over magnesium sulfate and then filtered. Active carbon was added to the obtained filtrate and the mixture was stirred at room temperature for 1 hour and then filtered through a filter lined with Celite. The obtained filtrate was concentrated, then heptane was added, and the mixture was stirred for 1 hour and filtered to obtain a solid. The obtained solid was recrystallized from a mixed solvent of toluene and heptane and the obtained solid was dried under reduced pressure at 50°C to obtain compound 8b (6.2 g, a white solid). The HPLC area percentage value of compound 8b was 99.5% or more.

The results of LC-MS and NMR measurement of compound 8b were as follows.

LC-MS (APCI, positive): m/z = 466 $[M+H]^+$

$^1$H-NMR ($CD_2Cl_2$, 400 MHz): $\delta$ (ppm) = 7.51-7.45 (m, 2H), 7.40 (t, 1H), 7.35-7.28 (m, 2H), 7.24-7.19 (m, 1H), 7.09-7.06 (m, 1H), 6.91 (s, 2H), 2.40 (s, 3H), 2.28 (s, 6H), 2.16 (s, 3H), 1.75 (s, 3H), 1.70-1.61 (m, 1H), 1.45-1.35 (m, 1H), 1.33 (s, 3H), 1.30-1.16 (m, 4H), 1.11 (s, 3H), 0.89-0.83 (m, 3H).

The atmosphere within a reaction vessel was replaced with argon gas, then the reaction vessel was charged with trisacetylacetonatoiridium (1.6 g), compound 8b (6.0 g), and pentadecane (14.2 g), and the mixture was stirred under reflux for 45 hours. Then, the reaction vessel was charged with toluene (31.6 g) and the mixture was filtered

through a filter lined with silica gel (18.9 g). Then, a yellow solution containing metal complex 8 was extracted from the obtained silica gel with a mixed solvent of toluene and ethyl acetate. The obtained solution was concentrated under reduced pressure to obtain a solid and then the obtained solid was purified by preparative silica gel column chromatography (a mixed solvent of toluene and ethyl acetate) to obtain a solid. The obtained solid was recrystallized from toluene and acetonitrile and the obtained solid was dried under reduced pressure at 50°C to obtain metal complex 8 (3.2 g, a yellow solid). The HPLC area percentage value of metal complex 8 was 99.1%.

The results of LC-MS and NMR measurement of metal complex 8 were as follows.

LC-MS (APCI, positive): m/z = 1585 $[M+H]^+$

$^1$H-NMR (CD2Cl2, 400 MHz): $\delta$ (ppm) = 7.42-7.16 (m, 9H), 6.99-6.62 (m, 12H), 6.31-6.12 (m, 3H), 2.53-2.41 (m, 9H), 2.31-2.00 (m, 36H), 1.86-1.77 (m, 3H), 1.44-0.98 (m, 33H), 0.85-0.62 (m, 9H).

<Example 7> Synthesis of Metal Complex 9

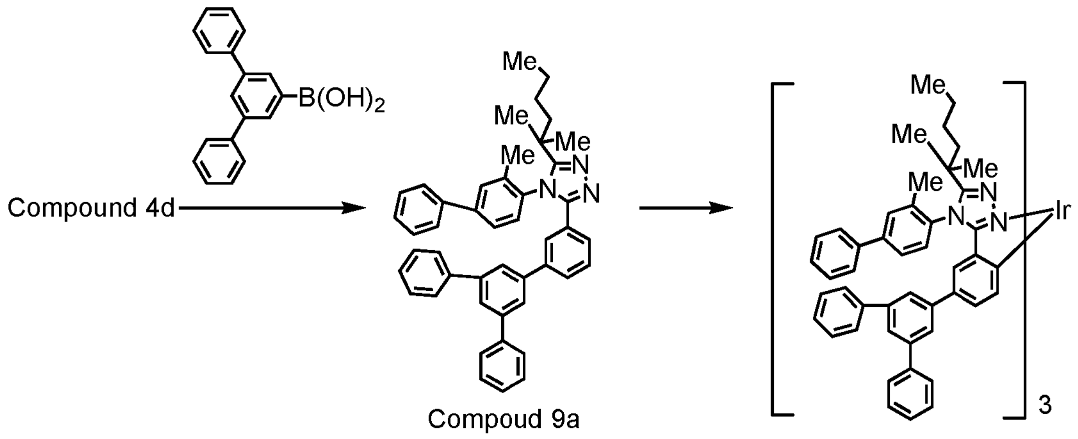

Compound 4d

Compoud 9a

Metal Complex 9

The atmosphere within a reaction vessel was replaced with argon gas, then the reaction vessel was charged with compound 4d (7.4 g), 5'-m-terphenylboronic acid (3.0 g), bis(di-tert-butyl(4-dimethylaminobiphenyl)phosphine)dichloropalladiu m (0.04 g), and toluene (25 mL) and the mixture was stirred at room temperature. Then, the reaction vessel was charged with a 40 mass% aqueous tetrabutylammonium hydroxide solution (17 mL) and then the mixture was stirred at 90°C for 23 hours. Then, the reaction vessel was cooled to room temperature and the obtained mixture was separated into two phases. The obtained organic layer was washed with ion-exchanged water (50 mL). The obtained washing solution was separated into two phases and the obtained organic layer was washed with ion-exchanged water (50 mL). The obtained washing solution was separated into two phases and the obtained organic layer was dried over magnesium sulfate and then filtered. Active carbon (5.0 g) was added to the obtained filtrate and the mixture was stirred at room temperature for 1 hour and then filtered through a filter lined with Celite. The obtained filtrate was concentrated. The obtained solid was purified by preparative silica gel column chromatography (a mixed solvent of chloroform and tetrahydrofuran as well as chloroform) a plurality of times. The obtained solid was dried under reduced pressure at 50°C to obtain compound 9a (4.7 g, a white solid). The HPLC area percentage value of compound 9a was 99.5% or more.

The result of the NMR measurement of compound 9a was as follows.

$^1$H-NMR (400 MHz, $CD_2Cl_2$) $\delta$ (ppm) = 7.74-7.33 (m, 25H), 1.92-1.83 (s, 3H), 1.77-1.56 (m, 2H), 1.50-1.14 (m, 10H), 0.86 (t, 3H).

The atmosphere within a reaction vessel was replaced with argon gas, then the reaction vessel was charged with trisacetylacetonatoiridium (0.9 g), compound 9a (4.5 g), and pentadecane (22 mL), and the mixture was stirred under reflux for 38 hours. Then, the reaction vessel was cooled to room temperature and charged with 2-propanol (120 mL). The mixture was filtered to obtain a deposited solid and the obtained solid was washed with 2-propanol and heptane to obtain a yellow solid containing metal complex 9. The obtained solid was purified by preparative silica gel column chromatography (a mixed solvent of dichloromethane and toluene). The obtained solid was recrystallized from toluene and acetonitrile and the obtained solid was dried under reduced pressure at 50°C to obtain metal complex 9 (1.7 g, a yellow solid). The HPLC area percentage value of metal complex 9 was 99.5% or more.

The results of LC-MS and NMR measurement of metal complex 9 were as follows.

LC-MS (APCI, positive): m/z = 2104 $[M+H]^+$

$^1$H-NMR (400 MHz, $CD_2Cl_2$) δ (ppm) = 7.66-6.96 (m, 69H), 6.73-6.54 (m, 3H), 2.39-2.22 (m, 7H), 2.12-1.94 (m, 2H), 1.64-1.05 (m, 36H), 0.87-0.67 (m, 9H).

<Example 8> Synthesis of Metal Complex 10

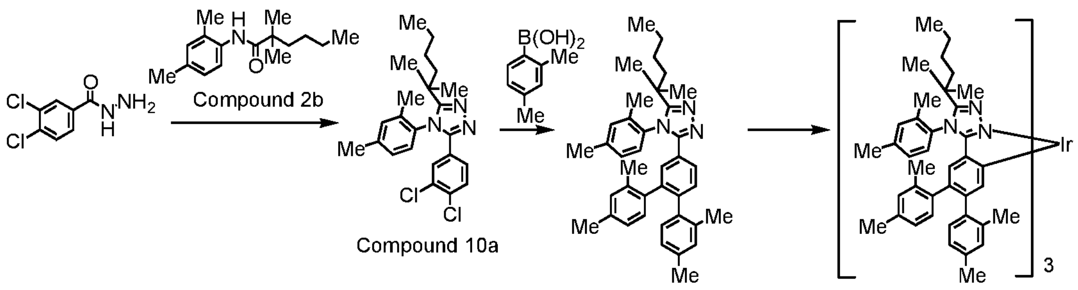


Compound 10a

Compound 10b

Metal Complex 10

The atmosphere within a reaction vessel was replaced with argon gas, then the reaction vessel was charged with compound 2b (28.0 g), monochlorobenzene (360 mL), 2-fluoropyridine (11 mL), and a trifluoromethanesulfonic acid anhydride (21 mL) and the mixture was stirred at 90°C. Then, the reaction vessel was charged with 3,4-dichlorobenzenecarbohydrazide (25.5 g) and the mixture was stirred at 90°C for 9 hours. Then, the reaction vessel was charged with an aqueous sodium hydrogen carbonate solution (200 mL), the organic layer was extracted, and the obtained organic layer was washed with ion-exchanged water (100 mL). The obtained organic layer was dried over magnesium sulfate and then filtered, and the obtained filtrate was concentrated under reduced pressure. The obtained solid was washed with hexane. The obtained solid was recrystallized from acetonitrile. The obtained solid was dried under reduced pressure at 50°C to obtain compound 10a (37.8 g) as a white solid. The HPLC area percentage value of compound 10a was 99.5% or more.

The result of NMR measurement of compound 10a was as follows.
$^1$H-NMR (400 MHz, $CDCl_3$) δ (ppm) = 0.86 (t, 3H), 1.04-1.50 (m, 11H), 1.58-1.90 (m, 4H), 2.40 (s, 3H), 6.98-7.36 (m, 5H), 7.50 (s, 1H).

The atmosphere within a reaction vessel was replaced with argon gas, then the reaction vessel was charged with compound 10a (35.0 g), 2,4-dimethylphenylboronic acid (26.0 g), toluene (700 mL), tris(dibenzylideneacetone)dipalladium (2.3 g), and 2-dicyclohexylphosphino-2',4',6'-triisopropylbiphenyl (2.8 g) and the mixture was heated at 90°C and stirred. Then, the reaction vessel was charged with a 40 mass% aqueous tetrabutylammonium hydroxide solution (409 mL) and then the mixture was stirred at 90°C for 9 hours. Then, the reaction vessel was cooled to room temperature and the obtained mixture was separated into two phases. The obtained organic layer was washed with ion-exchanged water (150 mL). The obtained washing solution was separated into two phases and the obtained organic layer was washed with ion-exchanged water (150 mL). The obtained washing solution was separated into two phases and the obtained organic layer was dried over magnesium sulfate and then filtered. Active carbon (4.0 g) was added to the obtained filtrate and the mixture was stirred at room temperature for 1 hour and then filtered through a filter lined with Celite. The obtained filtrate was concentrated under reduced pressure and then purified by preparative silica gel column chromatography (a mixed solvent of hexane and ethyl acetate) to obtain an oily substance.

The atmosphere within a reaction vessel was replaced with argon gas, then the reaction vessel was charged with the oily substance (30.0 g) obtained as described above, 2,4-dimethylphenylboronic acid (2.2 g), toluene (450 mL), tris(dibenzylideneacetone)dipalladium (1.0 g), and 2-dicyclohexylphosphino-2',4',6'-triisopropylbiphenyl (1.2 g) and the mixture was heated at 90°C and stirred. Then, the reaction vessel was charged with a 40 mass% aqueous tetrabutylammonium hydroxide solution (234 mL) and then the mixture was stirred at 90°C for 5 hours. Then, the reaction vessel was cooled to room temperature and the obtained mixture was separated into two phases. The obtained organic layer was washed with ion-exchanged water (150 mL). The obtained washing solution was separated into two phases and the obtained organic layer was washed with ion-exchanged water (150 mL). The obtained washing solution was separated into two phases and the obtained organic layer was dried over magnesium sulfate and then filtered. Active carbon (4.0 g) was added to the obtained filtrate and the mixture was stirred at room temperature for 1 hour and then filtered through a filter lined with Celite. The obtained filtrate was concentrated and obtained a reddish brown oily substance. The obtained reddish brown oily substance was purified by preparative reverse phase silica gel column chromatography (acetonitrile) and then the obtained oily substance was purified by preparative silica gel column chromatography (a mixed solvent of chloroform and ethanol). Then, the obtained oily substance was purified by preparative recycling GPC. The obtained solid was dried under reduced pressure at 50°C to obtain compound 10b (2.2 g, a colorless transparent oily substance).

The HPLC area percentage value of compound 10b was 99.5% or more.

The results of LC-MS and NMR measurement of compound 10b was as follows.

LC-MS (APCI, positive): m/z = 556 $[M+H]^+$

$^1$H-NMR (400 MHz, $CD_2Cl_3$) $\delta$ (ppm) = 0.86 (t, 3H), 1.12-1.44 (m, 11H), 1.58-2.04 (m, 10H), 2.20 (s, 6H), 2.37 (s, 3H), 6.46-7.25 (m, 12H).

The atmosphere within a reaction vessel was replaced with argon gas, then the reaction vessel was charged with trisacetylacetonatoiridium (0.4 g), compound 10b (2.0 g), and pentadecane (6 mL) and the mixture was stirred under reflux for 54 hours. Then, the reaction vessel was charged with toluene (30 mL) and the mixture was filtered with a filter lined with silica gel (20.0 g). Then, the obtained silica gel was extracted with a mixed solvent of toluene and ethyl acetate to obtain a yellow solution containing metal complex 10. The obtained solution was concentrated under reduced pressure and the obtained oily substance was purified by preparative silica gel column chromatography (a mixed solvent of toluene and ethyl acetate). Then, the obtained solid was purified by preparative reverse phase silica gel column chromatography (a mixed solvent of acetonitrile and ethyl acetate) to obtain a solid. The obtained solid was recrystallized from a mixed solvent of toluene and ethanol. The obtained solid was dried under reduced pressure at 50°C to obtain metal complex 10 (0.6 g, a yellow solid). The HPLC area percentage value of metal complex 10 was 99.5% or more.

The results of LC-MS and NMR measurement of metal complex 10 were as follows.

LC-MS (APCI, positive): m/z = 1858 $[M+H]^+$

$^1$H-NMR (400 MHz, $CDCl_3$) $\delta$ (ppm) = 0.82-2.30 (m, 99H), 5.69-7.27 (m, 33H)

<Example 9> Synthesis of Metal Complex 11

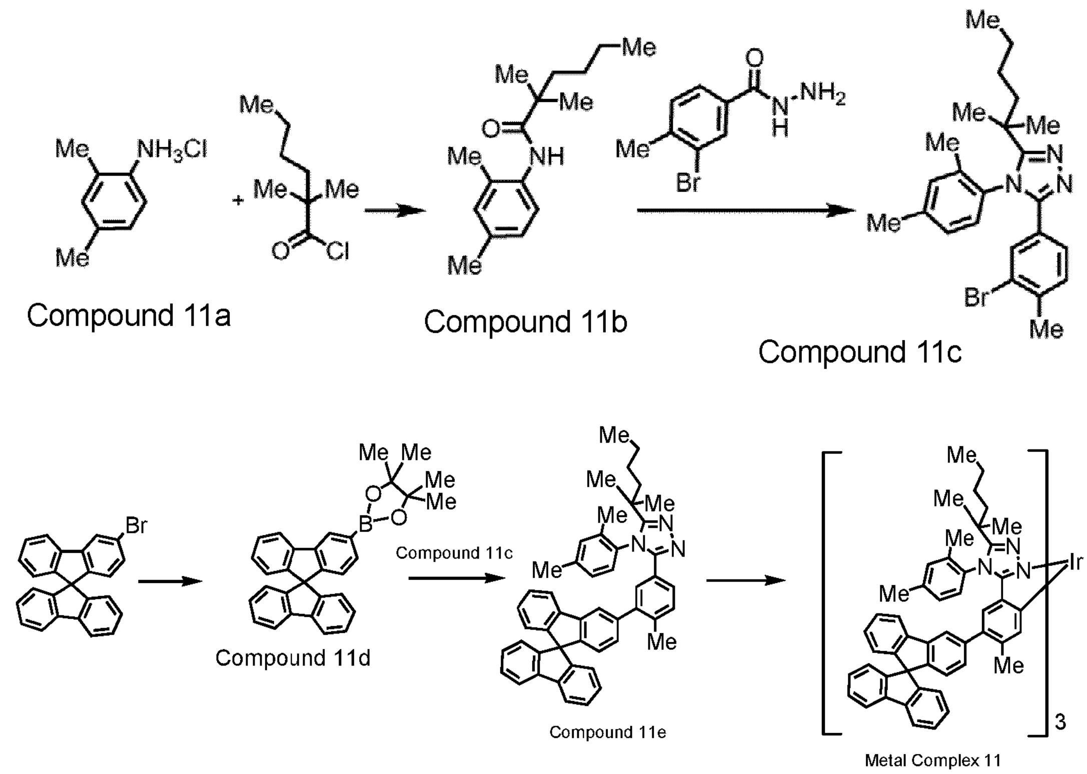


Compound 11a

Compound 11b

Compound 11c

Compound 11d

Compound 11e

Metal Complex 11

The atmosphere within a reaction vessel was replaced with argon gas, then the reaction vessel was charged with 2,2'-dimethylhexanoic acid (40 g), chloroform (240 mL), N,N'-dimethylformamide (0.21 mL), and thionyl chloride (20 mL) and the mixture was stirred at 45°C for 3 hours. Then, the reaction vessel was cooled in a water bath and a reaction solution containing 2,2'-dimethylhexanoyl chloride was obtained.

The atmosphere within a separately-prepared reaction vessel was replaced with argon gas, then the reaction vessel was charged with compound 11a (41.5 g), chloroform (400 mL), and triethylamine (75 mL) and placed in an ice bath to cool. Then, a reaction solution containing 2,2'-dimethylhexanoyl chloride obtained as described above was added dropwise thereto. After the dropwise addition, the mixture was further stirred for 1 hour at room temperature. Then a 2 mol/L aqueous sodium carbonate solution (280 mL) was added thereto and the mixture was stirred at room temperature.

The obtained mixture was separated into two phases and an organic layer was obtained. The obtained organic layer was washed with ion-exchanged water (280 mL). The obtained organic layer was dried over anhydrous magnesium sulfate and then concentrated under reduced pressure to obtain compound 6b (60 g, yield 88%) as a light yellow oily substance. The HPLC area percentage value of compound 11b was 99.5% or more.

The result of TLC-MS measurement of compound 11b was as follows.
TLC-MS (DART, positive): m/z = 248 $[M+H]^+$

The atmosphere within a reaction vessel was replaced with argon gas, then the reaction vessel was charged with compound 11b (25.2 g), 2-fluoropyridine (10.8 g), chlorobenzene (202 mL), and a trifluoroethanoic acid anhydride (31.3 g) and the mixture was stirred. Then, the reaction vessel was cooled in a water bath and charged with 2-bromo3-methylbenzoylhydrazine (25.4 g) and the mixture was stirred at room temperature for 10 minutes. A small amount of the obtained reaction solution was removed and diluted in chloroform and measured by HPLC. After confirming that the residual amount of compound 6b had become 2% or less, the mixture was stirred at 90°C for 7 hours. The reaction vessel was cooled and then charged with an aqueous sodium hydrogen carbonate solution (100 mL), an organic layer was extracted, and the obtained organic layer was washed with ion-exchanged water. Magnesium sulfate was added to the obtained organic layer to dry the organic layer. Then, 12.6 g of active carbon was added thereto and the mixture was stirred and filtered through filter lined with Celite. The obtained filtrate was concentrated under reduced pressure to obtain a solid. Chloroform and tetrahydrofuran were added to the obtained solid, the mixture was filtered through a filter lined with silica gel and Celite, and the obtained filtrate was concentrated under reduced pressure to obtain a solid. The obtained solid was recrystallized from a mixed solvent of toluene and heptane. The obtained solid was dried under reduced pressure at 50°C to obtain compound 11c (36.2 g, yield 81%) as a white solid. The HPLC area percentage value of compound 11c was 99.5% or more.

The result of NMR measurement of compound 11c was as follows.
$^1$H-NMR (400 MHz, $CD_2Cl_2$-$d_2$) $\delta$ (ppm) = 7.61-7.53 (m, 1H), 7.28-7.21 (m, 1H), 7.21-7.12 (m, 1H), 7.12-7.01 (m, 3H), 2.34 (s, 3H), 2.30 (s, 3H), 1.75-1.60 (m, 5H), 1.42-1.08 (m, 10H), 85 (t, 3H).

The atmosphere within a reaction vessel was replaced with nitrogen gas, then the reaction vessel was charged with 3-bromospirofluorene (5.0 g), bispinacolatodiboron (4.1 g), potassium acetate (4.9 g), and cyclopentyl methyl ether (125 mL), and the mixture was stirred. Then, the reaction vessel was charged with [1,1'-bis(diphenylphosphino)ferrocene]palladium (II) dichloride dichloromethane (0.3 g) and further stirred at 90°C for 16 hours. Then, the reaction vessel was cooled to room temperature and the obtained mixture was separated into two phases. The obtained organic layer was washed with ion-exchanged water (50 mL). The obtained washing solution was separated into two phases and the obtained organic layer was washed with ion-exchanged water (50 mL). The obtained washing solution was separated into two phases and the obtained organic layer was dried over magnesium sulfate and then filtered. The obtained filtrate was concentrated under reduced pressure. Toluene and active carbon (1.4 g) were added to the obtained solid and the mixture was stirred at room temperature for 1 hour and then filtered through a filter lined with Celite. The obtained filtrate was concentrated to obtain a white solid. The obtained white solid was recrystallized from toluene and acetonitrile and dried under reduced pressure at 50°C to obtain compound 11d (4.5 g, a white solid).

The result of the NMR measurement of compound 11d was as follows.
$^1$H-NMR (CD2Cl2, 400 MHz): $\delta$ (ppm) = 1.33 (12H, m), 6.64 (4H, m), 7.06-7.23 (3H, m), 7.35 (3H, t), 7.51 (1H, d), 7.86 (2H, d), 7.91 (1H, d), 8.26 (1H, s).

The atmosphere within a reaction vessel was replaced with argon gas, then the reaction vessel was charged with compound 11c (1.7 g), compound 11d (2.0 g), a 40% by mass aqueous tetrabutylammonium hydroxide solution (5.9 g), ion-exchanged water (5.9 g) and toluene (19.9 g) and the mixture was stirred at room temperature. Then, the reaction vessel was charged with bis(di-tert-butyl(4-dimethylaminobiphenyl)phosphine)dichloropalladiu m (0.03 g) and the mixture was stirred at 80°C for 19 hours. Then, the reaction vessel was cooled to room temperature and the obtained mixture was separated into two phases. The obtained organic layer was washed with ion-exchanged water (27.0 g). The obtained washing solution was separated into two phases and the obtained organic layer was washed with ion-exchanged water (27.0 g). The obtained washing solution was separated into two phases and the obtained organic layer was dried over magnesium sulfate and then filtered. Active carbon (0.5 g) was added to the obtained filtrate and the mixture was stirred at room temperature for 1 hour and then filtered through a filter lined with Celite. The obtained filtrate was concentrated under reduced pressure to obtain a solid. The obtained solid was purified by preparative silica gel column chromatography (a mixed solvent of hexane and ethyl acetate) to obtain a solid. The obtained solid was recrystallized from a mixed solvent of toluene and heptane and from a mixed solvent of toluene and acetonitrile a plurality of times and the obtained solid was dried under reduced pressure at 50°C.

A series of operations described above was repeated to obtain compound 11e (2.6 g, a white solid). The HPLC area percentage value of compound 11e was 99.5% or more.

The result of the NMR measurement of compound 11e was as follows.
$^1$H-NMR (CD2Cl2, 400 MHz): $\delta$ (ppm) = 7.89-7.85 (m, 2H), 7.84-7.80 (m, 1H), 7.60-7.57 (m, 1H), 7.40-7.35 (m, 3H), 7.30-7.26 (m, 2H), 7.23 (d, 1H), 7.18-7.08 (m, 5H), 7.05 (br, 1H), 6.82 (dd, 1H), 6.74-6.63 (m, 4H), 2.32 (s, 3H), 2.27 (s,

3H), 1.76 (s, 3H), 1.69-1.59 (m, 1H), 1.44-1.37 (m, 1H), 1.32 (s, 3H), 1.29-1.15 (m, 4H), 1.09 (s, 3H), 0.85 (t, 3H).

The atmosphere within a reaction vessel was replaced with argon gas, then the reaction vessel was charged with trisacetylacetonatoiridium (0.5 g), compound 11e (2.5 g), and pentadecane (7.2 g), and the mixture was stirred under reflux for 46 hours. Then, the reaction vessel was charged with toluene (9.0 g) and the mixture was filtered with a filter lined with silica gel (22.6 g). Then, the obtained silica gel was extracted with a mixed solvent of toluene and ethyl acetate to obtain a yellow solution containing metal complex 11. The obtained solution was concentrated under reduced pressure to obtain a solid and then the obtained solid was purified by preparative silica gel column chromatography (a mixed solvent of toluene and ethyl acetate) to obtain a solid. The obtained solid was recrystallized from toluene and acetonitrile. The obtained solid was dried under reduced pressure at 50°C to obtain metal complex 11 (0.7 g, a yellow solid). The HPLC area percentage value of metal complex 11 was 99.0%.

The results of LC-MS and NMR measurement of metal complex 11 were as follows.

LC-MS (APCI, positive): m/z = 2218 $[M+H]^+$

$^1$H-NMR (CD2Cl2, 400 MHz): $\delta$ (ppm) = 7.90-7.82 (m, 9H), 7.51-7.34 (m, 15H), 7.27-7.09 (m, 15H), 6.90-6.78 (m, 3H), 6.75-6.59 (m, 12H), 6.57-6.51 (m, 3H), 5.88-5.78 (m, 3H), 2.25-2.05 (m, 27H), 2.01-1.83 (m, 6H), 1.47-1.06 (m, 30H), 0.89-0.72 (m, 9H).

<Example 10> Synthesis of Metal Complex 12

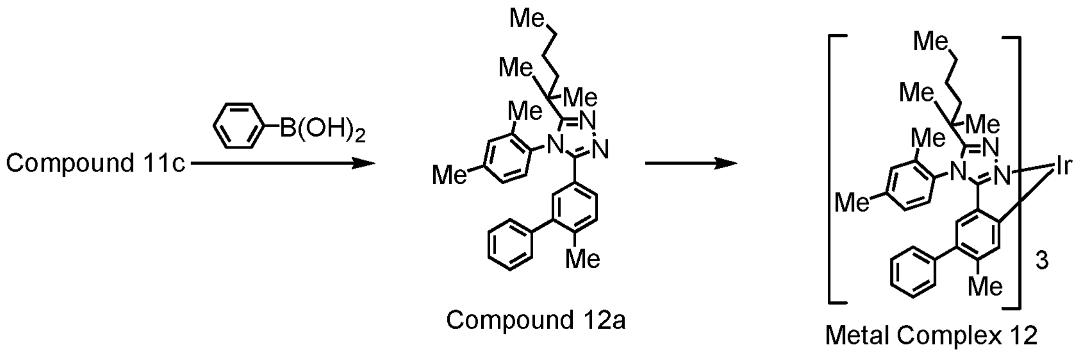

Compound 11c

Compound 12a

Metal Complex 12

The atmosphere within a reaction vessel was replaced with argon gas, then the reaction vessel was charged with compound 11c (15.0 g), phenylboric acid (4.4 g), bis(di-tert-butyl(4-dimethylaminobiphenyl)phosphine)dichloropalladiu m (0.1 g) and toluene (75 mL) and the mixture was stirred at 80°C. Then, the reaction vessel was charged with a 40 mass% aqueous tetrabutylammonium hydroxide solution (55 mL) and the mixture was stirred at 80°C for 40 hours. Then, the reaction vessel was cooled to room temperature and the obtained mixture was separated into two phases. The obtained organic layer was washed with ion-exchanged water (75 mL). The obtained washing solution was separated into two phases and the obtained organic layer was washed with ion-exchanged water (75 mL). The obtained washing solution was separated into two phases and the obtained organic layer was dried over magnesium sulfate. Then, active carbon (15.0 g) was added to the obtained filtrate and the mixture was stirred at room temperature for 1 hour and then filtered through a filter lined with Celite. The obtained filtrate was concentrated under reduced pressure to obtain an oily substance. The obtained oily substance was purified by preparative silica gel column chromatography (a mixed solvent of chloroform and ethanol) and the obtained solid was recrystallized from a mixed solvent of heptane and 2-propanol. The obtained solid was dried under reduced pressure at 50°C to obtain compound 12a (4.0 g, a white solid). The HPLC area percentage value of compound 12a was 99.5% or more.

The result of NMR measurement of compound 12a was as follows.

$^1$H-NMR (400 MHz, $CD_2Cl_2$) $\delta$ (ppm) = 7.40-6.94 (m, 11H), 2.42-2.34 (m, 3H), 2.23-2.15 (m, 3H), 1.78-1.48 (m, 6H), 1.42-1.16 (m, 6H), 1.13-1.06 (m, 3H), 0.92-0.77 (m, 3H).

The atmosphere within a reaction vessel was replaced with argon gas, then the reaction vessel was charged with trisacetylacetonatoiridium (1.1 g), compound 12a (4.0 g), and pentadecane (50 mL), and the mixture was stirred under reflux for 52 hours. Then, the reaction vessel was charged with toluene (32 mL) and the mixture was filtered with a filter lined with silica gel (16.0 g). Then, a yellow solution containing metal complex 12 was extracted with a mixed solvent of toluene and ethyl acetate. The obtained solution was concentrated under reduced pressure to obtain a solid and then the obtained solid was purified by preparative silica gel column chromatography (a mixed solvent of toluene and ethyl acetate) and the obtained solid was washed with ethanol. Furthermore, the obtained solid was purified by preparative reverse phase silica gel column chromatography (a mixed solvent of methylene chloride and acetonitrile).

The obtained solid was washed with acetonitrile and recrystallized from a mixed solvent of toluene and ethanol. The obtained solid was dried under reduced pressure at 50°C to obtain metal complex 12 (1.5 g, a yellow solid). The HPLC area percentage value of metal complex 12 was 99.4%.

The result of the NMR measurement of metal complex 12 was as follows.

$^1$H-NMR (400 MHz, $CD_2Cl_2$) δ (ppm) = 7.33-7.08 (m, 18H), 7.02-6.93 (m, 6H), 6.73-6.48 (m, 3H), 5.81-5.71 (m, 3H), 2.43-2.32 (m, 9H), 2.16-1.97 (m, 15H), 1.91-1.79 (m, 3H), 1.58-1.03 (m, 36H), 0.84-0.67 (m, 9H).

<Example 11> Synthesis of Metal Complex 13

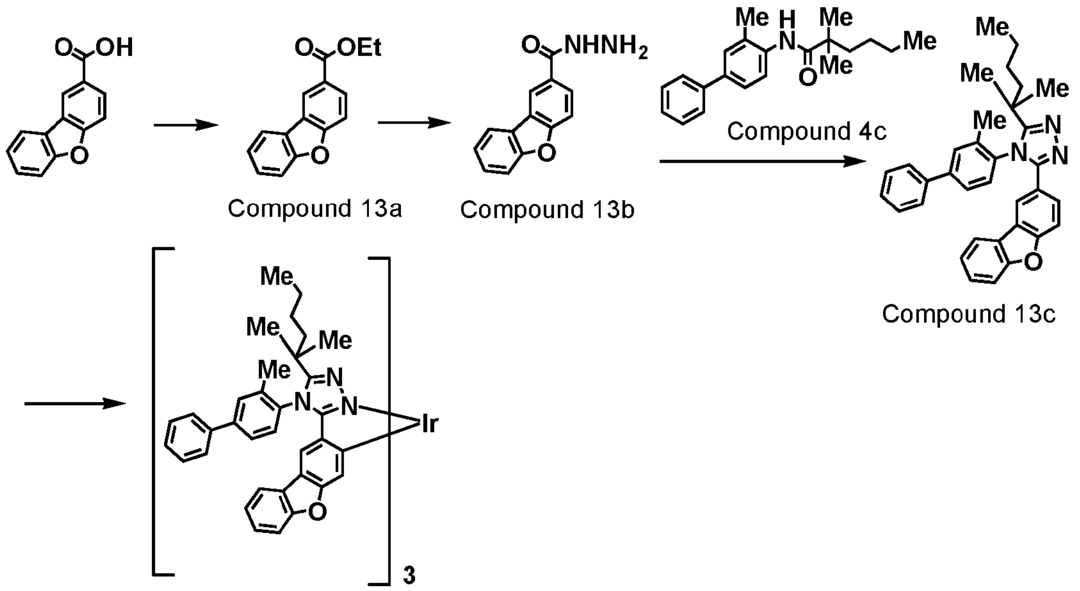

Compound 13a

Compound 13b

Compound 4c

Compound 13c

Metal Complex 13

The atmosphere within a reaction vessel was replaced with argon gas, then the reaction vessel was charged with 2-dibenzofurancarboxylic acid (20.0 g), sulfuric acid (1.8 g), and ethanol (600 mL) and the mixture was stirred at 80°C for 45 hours to obtain Reaction Solution 1. This procedure was repeated to obtain Reaction Solution 2. The obtained Reaction Solutions 1 and 2 were combined and concentrated and then ethyl acetate (400 mL) was added for substitution and concentration. Ethyl acetate (200 mL) and ion-exchanged water (200 mL) were added to the obtained solution for washing. The obtained organic layer was washed with an aqueous sodium carbonate solution (200 mL). Then, the obtained organic layer was washed with ion-exchanged water (200 mL). The obtained organic layer was dried over magnesium sulfate and then filtered with a filter lined with Celite and silica gel. The obtained filtrate was concentrated under reduced pressure to obtain an oily substance. The obtained oily substance was dried under reduced pressure at 50°C to obtain compound 13a (39.4 g, a yellow oily substance). The HPLC area percentage value of compound 13a was 99.0%.

The series of operations described above was repeated to obtain a required amount of compound 13a.

The result of NMR measurement of compound 13a was as follows.

$^1$H-NMR (400 MHz, $CD_2Cl_2$) δ (ppm) = 1.40 (3H, t), 4.39 (2H, q), 7.38 (1H, dt), 7.50 (1H, dt), 7.59 (2H, d), 8.02 (1H, dd), 8.16 (1H, dd), 8.67 (1H, d).

The atmosphere within a reaction vessel was replaced with argon gas, then the reaction vessel was charged with compound 13a (40.0 g), ethanol (360 mL), ion-exchanged water (40 mL), and hydrazine monohydrate (125.0 g) and the mixture was stirred at 80°C for 6 hours. The reaction vessel was cooled to room temperature, and then charged with ion-exchanged water (300 mL) and the mixture was stirred at 0°C for 1 hour to obtain a solid. The obtained solid was recovered by filtration, then washed with ion-exchanged water (200 mL) twice, and then washed with 50% ethanol water (200 mL) once. 2-propanol (565 mL) was added to the obtained solid to suspend the solid and the mixture was stirred and then filtered, and the obtained solid was dried under reduced pressure at 50°C to obtain compound 13b (34.5 g, a white solid). The HPLC area percentage value of compound 13b was 97.1%,

The result of the NMR measurement of compound 13b was as follows.

$^1$H-NMR (400 MHz, $CD_3OD$) δ (ppm) = 4.84 (2H, s), 7.39 (1H, dt), 7.52 (1H, dt), 7.60 (1H, dd), 7.64 (1H, d), 7.93 (1H, dd), 8.07 (1H, dd), 8.48 (1H, d).

The atmosphere within a reaction vessel was replaced with argon gas, then the reaction vessel was charged with compound 4c (22.0 g), monochlorobenzene (220 mL), 2-fluoropyridine (6.7 mL), and a trifluoromethanesulfonic acid anhydride (12.8 mL) and the mixture was stirred at room temperature. Then, the reaction vessel was charged with compound 13b (17.7 g) and the mixture was stirred at 85°C for 3 hours. The reaction vessel was cooled to room temperature, and then charged with an aqueous sodium hydrogen carbonate solution (78 mL) and an organic layer was extracted. The obtained organic layer was washed with ion-exchanged water (88 mL). The obtained organic layer was dried over magnesium sulfate and then filtered. The obtained filtrate was concentrated under reduced pressure. The obtained solid was washed with hexane. The obtained solid was recrystallized from acetonitrile and then dried under reduced pressure at 50°C to obtain compound 13c (28.2 g, a white solid). The HPLC area percentage value of compound 13c was 99.5% or more.

The result of the NMR measurement of compound 13c was as follows.
$^1$H-NMR (400 MHz, $CD_2Cl_2$) $\delta$ (ppm) = 0.89 (3H, t), 1.18 (3H, s), 1.20-1.35 (3H, m), 1.46 (1H, dt), 1.66-1.75 (1H, m), 1.83 (3H, s), 7.29 (1H, dt), 7.34-7.66 (12H, m), 7.80 (1H, dd), 8.02 (1H, d).

The atmosphere within a reaction vessel was replaced with argon gas, then the reaction vessel was charged with trisacetylacetonatoiridium (4.4 g), compound 13c (18.0 g), and pentadecane (90 mL), and the mixture was stirred under reflux for 66 hours. The reaction vessel was cooled to room temperature, and then charged with 2-propanol (90 mL) to generate a solid. The generated solid was recovered by filtration. Toluene (15 mL) was added thereto and the mixture was filtered through a filter lined with silica gel (76 g). The obtained solid was extracted with a mixed solvent of toluene and ethyl acetate to obtain a yellow solution containing metal complex 13. The obtained solution was concentrated under reduced pressure. The obtained solid was purified by preparative silica gel column chromatography (a mixed solvent of toluene and ethyl acetate) to obtain a solid. The obtained solid was recrystallized from a mixed solvent of toluene and ethanol and then dried under reduced pressure at 50°C to obtain metal complex 13 (7.0 g, a yellow solid). The HPLC area percentage value of metal complex 13 was 99.5% or more.

The results of LC-MS and NMR measurement of metal complex 13 were as follows.
LC-MS (APCI, positive): m/z = 1689 $[M+H]^+$
$^1$H-NMR (400 MHz, $CD_2Cl_2$) $\delta$ (ppm) = 0.49-0.86 (10H, m), 0.94-1.70 (35H, m), 1.81-1.91 (4H, m), 2.23-2.32 (5H, m), 6.51-6.59 (3H, m), 6.78-7.27 (15H, m), 7.43-7.81 (24H, m).

<Comparative Example 1> Synthesis of Metal Complex 6

Metal complex 6 was synthesized by the following method.

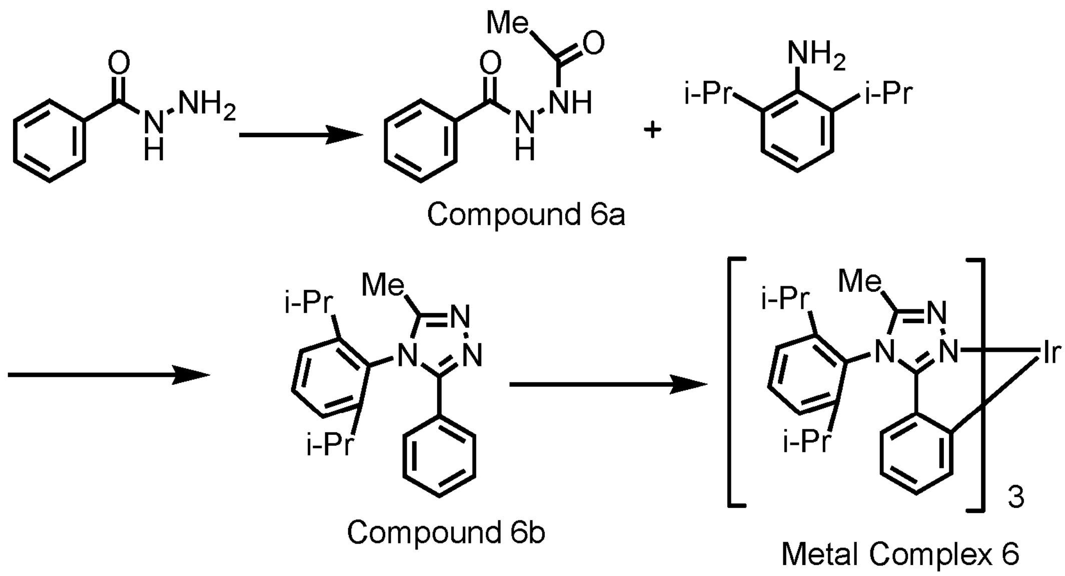

Compound 6a

Compound 6b

Metal Complex 6

The atmosphere within a reaction vessel was replaced with nitrogen gas, then the reaction vessel was charged with benzoylhydrazide (100 g), triethylamine (114 mL), and tetrahydrofuran (1.5 L) and the mixture was stirred at 0°C. Then, acetyl chloride (52 mL) was added dropwise thereto and the mixture was stirred at room temperature for 4 hours. Then, the reaction vessel was cooled to room temperature. The obtained solid was filtered. The obtained solid was washed with tetrahydrofuran. The obtained solution was concentrated and the obtained solid was recrystallized from ethyl acetate to obtain compound 6a (70 g). The HPLC area percentage value of compound 6a was 98.7%.

The results of LC-MS and NMR measurement of compound 6a were as follows.
LC-MS (APCI, positive): m/z = 179 $[M+H]^+$
$^1$H-NMR (300 MHz, DMSO-$d_6$) $\delta$ (ppm) = 10.26 (br, s, 1H), 9.86 (br, s, 1H), 7.83-7.86 (m, 2H), 7.45-7.56 (m, 3H), 1.90 (s, 3H).

The atmosphere within a reaction vessel was replaced with nitrogen gas, then the reaction vessel was charged with compound 6a (70 g) and xylene (700 mL) and the mixture was stirred at room temperature. Then, the reaction vessel was charged with phosphorus pentachloride (123 g) little by little there and the mixture was stirred at 130°C for 2 hours. Then, the reaction vessel was cooled to room temperature and charged with 2,6-diisopropylaniline (70 g) little by little and the mixture was stirred at 130°C for 8 hours. Then, the reaction vessel was cooled to room temperature and the obtained mixture was concentrated under reduced pressure to remove xylene. Then, the obtained residue was dissolved in ethyl acetate. The obtained solution was washed with each of ion-exchanged water, a 10% by mass aqueous sodium hydrogen carbonate solution, and saturated brine. The obtained organic layer was dried over sodium sulfate and then filtered and the obtained filtrate was concentrated under reduced pressure. The obtained solid was purified by preparative silica gel column chromatography (a mixed solvent of hexane and ethyl acetate) to obtain a solid. The obtained solid is recrystallized using N,N-dimethylformamide and water, and the obtained solid was dried under reduced pressure at 50°C to obtain compound 6b (70 g, a white solid). The HPLC area percentage value of compound 6b was 99.2%.

The results of LC-MS and NMR measurement of compound 6b were as follows.
LC-MS (APCI, positive): m/z = 320 $[M+H]^+$
$^1$H-NMR (400 MHz, $CDCl_3$) $\delta$ (ppm) = 7.53- 7.58 (m, 1H), 7.48 (d, 2H), 7.33 (d, 2H), 7.28-7.30 (m, 1H), 7.21-7.25 (m, 2H), 2.39 (q, 2H), 2.26 (s, 3H), 1.14 (d, 6H), 0.87 (d, 6H).

The atmosphere within a reaction vessel was replaced with nitrogen gas, then the reaction vessel was charged with trisacetylacetonatoiridium (1.2 g), compound 6b (4.0 g), and tridecane (1 mL) and the mixture was stirred at 280°C for 18 hours. Then, the reaction vessel was cooled to room temperature and charged with methylene chloride. The obtained solution was concentrated under reduced pressure and the obtained residue was purified by preparative silica gel column chromatography (a mixed solvent of ethyl acetate and ethanol) to obtain a solid. The obtained solid was recrystallized from toluene and acetonitrile and the obtained solid was dried under reduced pressure at 50°C to obtain metal complex 6 (1.7 g, a yellow solid). The HPLC area percentage value of metal complex 6 was 99.5% or more.

The result of the NMR measurement of metal complex 6 was as follows.
1H-NMR (600 MHz, THF-$d_8$) $\delta$ (ppm) = 7.56 (t, 3H), 7.42 (dd, 3H), 7.40 (dd, 3H), 6.87 (dd, 3H), 6.52 (td, 3H), 6.35 (td, 3H), 6.17 (dd, 3H), 2.83 (hept, 3H), 2.34 (hept, 3H), 2.10 (s, 9H), 1.23 (d, 9H), 0.98 (d, 9H), 0.96 (d, 9H), 0.92 (d, 9H).

<Comparative Example 2> Synthesis of metal complex 7

Metal complex 7 was synthesized by the following method.

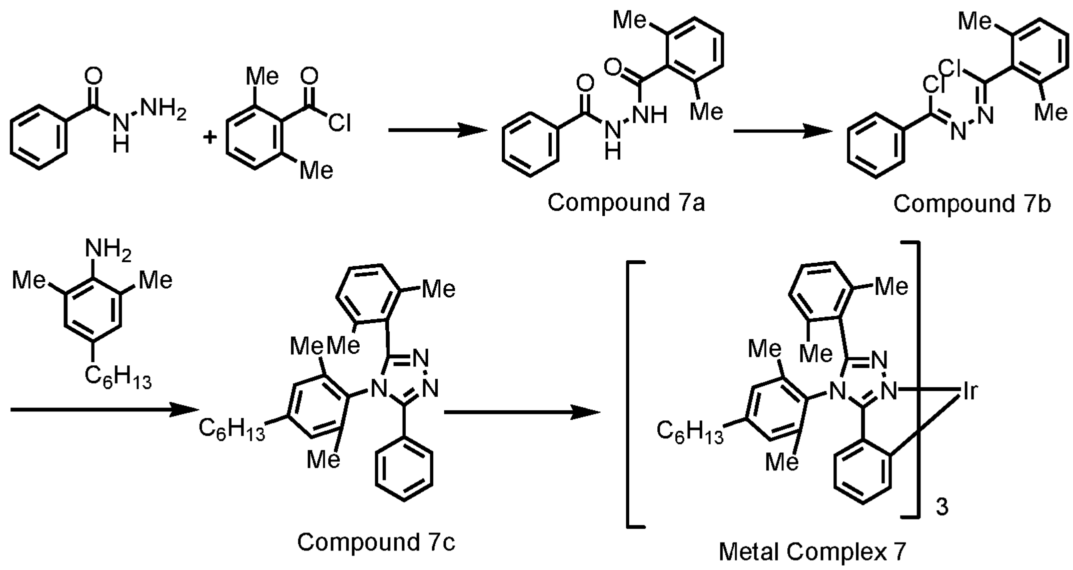

Compound 7a

Compound 7b

Compound 7c

Metal Complex 7

The atmosphere within a reaction vessel was replaced with nitrogen gas, then the reaction vessel was charged with benzoylhydrazide (50 g) and N-methyl-2-pyrrolidone (200 mL) and the mixture was stirred at 0°C. Then, 2,6-dimethyl benzoylchloride (40 g) dissolved in N-methyl-2-pyrrolidone (40 mL) was added dropwise thereto and the mixture was

stirred at room temperature for 18 hours. Then, the obtained mixture was added to ion-exchanged water (1.2 L), stirred, and then separated into 2 phases. The obtained organic layer was washed with each of a 1 M aqueous hydrochloric acid solution and ion-exchanged water. The obtained organic layer was dried over magnesium sulfate and then filtered. The obtained filtrate was concentrated under reduced pressure to obtain compound 7a (43 g, a white solid).

The result of the NMR measurement of compound 7a was as follows.
$^1$H-NMR (600 MHz, $CDCl_3$) $\delta$ (ppm) = 9.64 (br, 1H), 8.90 (br, 1H), 7.86 (d, 2H), 7.56 (t, 1H), 7.45 (t, 2H), 7.02-7.08 (m, 3H), 2.41 (s, 6H).

The atmosphere within a reaction vessel was replaced with nitrogen gas, then the reaction vessel was charged with compound 7a (43 g) and toluene (740 mL) and the mixture was stirred at room temperature. Then, the reaction vessel was charged with phosphorus pentachloride (67 g) was added little by little and the mixture was stirred at 110°C for 21 hours. Then, the reaction vessel was cooled to room temperature. The obtained mixture was added to iced water (500 mL) and stirred at room temperature for 2 hours. The obtained mixture was separated into two phases. The obtained organic layer was washed with each of ion-exchanged water and a 10% by mass aqueous sodium hydrogen carbonate solution. The obtained organic layer was dried over magnesium sulfate and then filtered. The obtained filtrate was concentrated under reduced pressure to obtain an oily compound 7b (40 g).

The atmosphere within a reaction vessel was replaced with nitrogen gas, then the reaction vessel was charged with compound 7b (40 g), 2,6-dimethyl-4-hexylaniline (32 g), and xylene (800 mL) and the mixture was stirred at room temperature. Then, the reaction vessel was charged with para-toluenesulfonic acid (3 g) and the mixture was stirred at 120°C for 116 hours. Then, the reaction vessel was cooled to room temperature and charged with ion-exchanged water (800 mL) and the mixture was stirred at room temperature for 1 hour. The obtained mixture was separated into two phases and the obtained organic layer was washed with a 5% aqueous sodium hydrogen carbonate solution. The obtained organic layer was dried over magnesium sulfate and then filtered. The obtained filtrate was concentrated under reduced pressure to obtain a brown oily substance. The obtained brown oily substance was purified a plurality of times by preparative silica gel column chromatography (a mixed solvent of heptane and ethyl acetate and acetonitrile and tetrahydrofuran) to obtain compound 7c (1.3 g, a white solid). The HPLC area percentage value of compound 7c was 99.5% or more. The procedure described above was repeated to obtain a required amount.

The result of the NMR measurement of compound 7c was as follows.
$^1$H-NMR (600 MHz, THF-$d_8$) $\delta$ (ppm) = 7.42 (d, 2H), 7.30 (t, 1H), 7.24 (t, 2H), 7.15 (t, 1H), 6.98 (d, 2H), 6.85 (s, 2H), 2.51 (t, 2H), 2.07 (s, 6H), 1.81 (s, 6H), 1.56 (m, 2H), 1.26-1.32 (m, 6H), 0.88 (t, 3H).

The atmosphere within a reaction vessel was replaced with nitrogen gas, then the reaction vessel was charged with trisacetylacetonatoiridium (0.6 g), compound 7c (2.0 g), and tridecane (2 mL) and the mixture was stirred at 250°C for 120 hours. Then, the reaction vessel was cooled to room temperature and charged with methylene chloride. The obtained solution was concentrated under reduced pressure and then the obtained residue was purified by preparative silica gel column chromatography (a mixed solvent of heptane and ethyl acetate) to obtain metal complex 7 (0.6 g, a yellow solid). The HPLC area percentage value of metal complex 7 was 99.2%.

The result of NMR measurement of metal complex 7 was as follows.
$^1$H-NMR (600 MHz, THF-$d_8$) $\delta$ (ppm) = 7.04-7.08 (m, 6H), 6.93 (s, 3H), 6.92 (s, 3H), 6.88 (d, 3H), 6.84 (d, 3H), 6.61 (t, 3H), 6.43 (t, 3H), 6.29 (d, 3H), 2.57 (t, 6H), 2.12 (s, 9H), 1.95 (s, 9H), 1.82 (s, 9H), 1.70 (s, 9H), 1.62 (m, 6H), 1.28-1.36 (m, 18H), 0.89 (t, 9H).

<Evaluation of Light Emission Stability>

[Apparatus for Evaluating Light Emission Stability]

Organic layers in measurement samples were irradiated with excitation light from the glass substrate side of the measurement samples described below with an apparatus for evaluating light emission stability to emit light. Lightningcure LC-L1V3 (wavelength 385 nm) manufactured by Hamamatsu Photonics K.K. was used as source of the excitation light. The light emission from measurement samples was measured by using a luminance meter BM-9 manufactured by Topcon Technohouse Corporation. A short wavelength blocking filter was inserted at the entrance of light for the measurement into the luminance meter to prevent light having a wavelength at 400 nm or less from being measured.

[Adjustment of Intensity of Excitation Light from Excitation Light Source]

In the evaluation of light emission stability, the intensity of excitation light from the excitation light source was adjusted so that the numbers of light emission photons from the measurement samples described below should be the same number.

To determine the condition for making the numbers of light emission photons from the measurement samples the same, Expression (11), Expression (12), Expression (13-1), Expression (13-2), Expression (14), Expression (15),

Expression (16), and Expression (17) were used.

First, the numbers of light emission photons from measurement samples were calculated from Expression (11). Here, $Int_{PL}$ ($\lambda$), which represents the intensity of light emission spectrum, was determined by measuring the organic layer contained in the measurement sample described below with FP-6500 manufactured by JASCO Corporation, with the sample formed on quartz substrate.

[Expression 1]

$$N_{PL} = \sum_{\lambda} \frac{Int_{PL}(\lambda) \times \lambda}{1240 \times 1.6 \times 10^{-19}} \qquad (11)$$

(wherein, $N_{PL}$ represents the number of light emission photons. $\lambda$ represents a wavelength [nm]. $Int_{PL}$ ($\lambda$) represents the intensity of light emission spectrum [W].)

Second, Expression for $N_{PL}$, which represents the number of light emission photons calculated by Expression (11), was converted to Expression (12).

[Expression 2]

$$N_{PL} = K_{int} \times n_{nrm-PL} \qquad (12)$$

(wherein, $N_{PL}$ has the same meaning as described above. $K_{int}$ represents a proportionality coefficient. $n_{nrm-PL}$ represents the normalized number of photons.)

$n_{nrm-PL}$, which represented the normalized number of photons in Expression 2 was (12) calculated by Expression (13-1).

[Expression 3]

$$n_{nrm-PL} = \sum_{\lambda} \frac{Int_{nrm-PL}(\lambda) \times \lambda}{1240 \times 1.6 \times 10^{-19}} \qquad (13-1)$$

(wherein, $\lambda$ and $n_{nrm-PL}$ have the same meanings as those described above. $Int_{nrm-PL}$ ($\lambda$) represents a normalized light emission spectrum.)

$Int_{nrm-PL}$ ($\lambda$), which represents a normalized light emission spectrum in Expression (13-1) was calculated from Expression (13-2).

[Expression 4]

$$Int_{nrm-PL}(\lambda) = Int_{PL}(\lambda) / \max(Int_{PL}(\lambda)) \qquad (13-2)$$

(wherein, $\lambda$, $Int_{nrm-PL}$ ($\lambda$), and $Int_{PL}$ ($\lambda$) have the same meanings as those described above.)

Third, normalized luminance was calculated from $Int_{nrm-PL}$ ($\lambda$), which represents a normalized light emission spectrum, according to Expression (14).

[Expression 5]

$$l_{nrm} = \sum_{\lambda} \left( Int_{nrm-PL}(\lambda) \cdot Lf(\lambda) \right) \qquad (14)$$

(wherein, $\lambda$ and $Int_{nrm-PL}$ ($\lambda$) have the same meanings as those described above. $1_{nrm}$ represents normalized luminance. Lf ($\lambda$) represents spectral luminous efficiency.)

Fourth, light emission luminance was calculated from $1_{nrm}$, which represents normalized luminance, according to Expression (15).

[Expression 6]

$$L_{PL} = \sum_{\lambda}\left(Int_{PL}(\lambda)\times Lf(\lambda)\right) = \kappa_{\mathrm{int}}\times\sum_{\lambda}\left(Int_{nrm-PL}(\lambda)\times Lf(\lambda)\right) = \kappa_{\mathrm{int}}\times l_{nrm} \quad (15)$$

(wherein, $L_{PL}$ represents light emission luminance [cd/m$^2$]. $\lambda$, $Int_{PL}$ ($\lambda$), Lf ($\lambda$), $K_{int}$, $Int_{nrm-PL}$ ($\lambda$), and $1_{nrm}$ have the same meanings as those described above.)

Fifth, the condition for making the numbers of light emission photons the same was calculated from Expression (16) using Expression (12) and Expression (15). By using this Expression (16), the light emission luminance of each measurement sample that satisfies the condition for making the numbers of the light emission photons from the measurement samples the same can be calculated.

[Expression 7]

$$N_{PL} = \kappa_{\mathrm{int}}\times n_{nrm-PL} = \mathrm{constant}$$

(wherein, $N_{PL}$, $K_{int}$, and $n_{nrm-PL}$ have the same meanings as those described above.)
[Expression 8]

$$L_{eqv}[cd/m^2] = \mathrm{constant}\times\frac{l_{nrm}}{n_{nrm-PL}} = \kappa_{\mathrm{int}}\times l_{nrm} \quad (16)$$

(wherein, $L_{eqv}$ represents light emission luminance [cd/m$^2$]. $1_{nrm}$, $n_{nrm-PL}$ and $K_{int}$ have the same meanings as those described above.)

For example, when making Sample A have light emission at a luminance $L^A$, the light emission luminance of Sample B that makes the number of light emission photons the same as that of Sample A can be calculated from Expression (17) using the normalized numbers of photons and the normalized luminance of Sample A and Sample B.

[Expression 9]

$$L^B[cd/m^2] = \mathrm{L}^{\mathrm{A}}\times\frac{n^A_{nrm-PL}}{l^A_{nrm}}\times\frac{l^B_{nrm}}{n^B_{nrm-PL}} \quad (17)$$

(wherein, $L^A$ represents light emission luminance [cd/m$^2$] of Sample A. $L^B$ represents light emission luminance [cd/m$^2$] of Sample B. $n^A_{nrm-PL}$ represents the normalized number of photons of Sample A. $n^B_{nrm-PL}$ represents the normalized number of photons of Sample B. $1^A_{nrm}$ represents normalized luminance of Sample A. $1^B_{nrm}$ represents normalized luminance of Sample B.)

<Working Measurement Example 1> Measurement of Light Emission Stability

A toluene solution in which metal complex 1 (a mixture of isomers 3 and 4) and a compound represented by Formula (H-113) (hereinafter, also referred to as "compound H-113".) (a product manufactured by Light emission Technology Corp., LT-N4013 (metal complex 1: compound H-113 = 25% by mass :75% by mass) were dissolved at a concentration of 2.0% by mass was prepared.

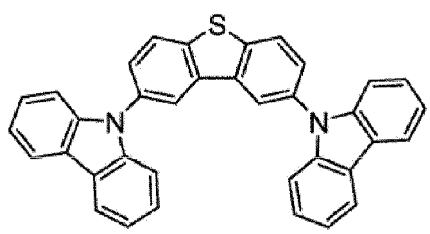

(H-113)

The toluene solution obtained as described above was deposited on a glass substrate by spin coating to form a film with a thickness of 75 nm and, under a nitrogen gas atmosphere (oxygen concentration of 10 ppm or less, water concentration of 10 ppm or less), the film was heated at 130°C for 10 minutes to form an organic layer.

The pressure in the deposition equipment was decreased to $1.0 \times 10^{-4}$ Pa or lower and then aluminum was deposited at a thickness of approximately 80 nm by vapor deposition on the substrate on which the organic layer had been formed. After the vapor deposition, under a nitrogen gas atmosphere (oxygen concentration of 10 ppm or less, water concentration of 10 ppm or less), the layers were sealed using a glass substrate to prepare measurement sample FL-1.

The intensity of excitation light from the excitation light source was adjusted so that light emission luminance of measurement sample FL-1 would be 2736 cd/$m^2$. The light emission spectrum of light emission observed from Measurement Sample FL-1 had a peak at 468 nm and the chromaticity CIE (x, y) thereof was (0.177, 0.324). The light emission was light emission from metal complex 1. Then, measurement sample FL-1 was made emit light continually with the adjusted intensity of excitation light kept constant and time before the light emission luminance becomes 85% of the light emission luminance at the time of start of measurement (hereinafter, referred to as "LT85") was measured. The result of measurement indicated that LT85 was 50.1 hours.

<Working Measurement Example 2> Measurement of Light Emission Stability

Measurement sample FL-2 was prepared in the same manner as in Working Measurement Example 1, except that isomer 1 of metal complex 1 was used in place of a mixture of isomers 3 and 4 of metal complex 1. The light emission stability was measured.

According to Expression (17) above, the light emission luminance of measurement sample FL-2 that makes the number of light emission photons same as that of Measurement Sample FL-1 was calculated to be 2652 cd/$m^2$.

The intensity of excitation light from the excitation light source was adjusted so that the light emission luminance of measurement sample FL-2 would be 2652 cd/$m^2$. The emission spectrum of light emission observed from measurement sample FL-2 had a peak at 467 nm and the chromaticity CIE (x, y) thereof was (0.195, 0.311). The light emission was light emission from metal complex 1. Then, measurement sample FL-2 was made emit light continually with the adjusted intensity of excitation light kept constant and LT85 was measured. The result of measurement indicated that LT85 was 46.2 hours.

<Working Measurement Example 3> Measurement of Light Emission Stability

Measurement sample FL-3 was prepared in the same manner as in Working Measurement Example 1, except that isomer 2 of metal complex 1 was used in place of a mixture of isomers 3 and 4 of metal complex 1.

According to Expression (17) above, the light emission luminance of measurement sample FL-3 that makes the number of light emission photons same as that of measurement sample FL-1 was calculated to be 2695 cd/$m^2$.

The intensity of excitation light from the excitation light source was adjusted so that light emission luminance of measurement sample FL-3 would be 2695 cd/$m^2$. The emission spectrum of light emission observed from measurement sample FL-3 had a peak at 467 nm and the chromaticity CIE (x, y) thereof was (0.184, 0.318). The light emission was a light emission from metal complex 1. Then, measurement sample FL-3 was made emit light continually with the adjusted intensity of excitation light kept constant and LT85 was measured. The result of measurement indicated that LT85 was 40.6 hours.

<Working Measurement Example 4> Measurement of Light emission stability

Measurement sample FL-4 was prepared in the same manner as in Working Measurement Example 1, except that metal complex 2 was used in place of a mixture of isomers 3 and 4 of metal complex 1.

According to Expression (17) above, the light emission luminance of measurement sample FL-4 that makes the number of light emission photons same as that of measurement sample FL-1 was calculated to be 3007 cd/$m^2$.

The intensity of excitation light from the excitation light source was adjusted so that light emission luminance of measurement sample FL-4 would be 3007 cd/$m^2$. The emission spectrum of light emission observed from measurement sample FL-5 had a peak at 479 nm and the chromaticity CIE (x, y) thereof was (0.173, 0.402). The light emission was light emission from metal complex 2. Then, measurement sample FL-5 was made emit light continually with the adjusted intensity of excitation light kept constant and LT85 was measured. The result of measurement indicated that LT85 was 83.3 hours.

<Working Measurement Example 5> Measurement of Light emission stability

Measurement sample FL-5 was prepared in the same manner as in Working Measurement Example 1, except that metal complex 3 was used in place of a mixture of isomers 3 and 4 of metal complex 1, and the light emission stability was measured.

According to Expression (17) above, the light emission luminance of measurement sample FL-5 that makes the number of light emission photons same as that of measurement sample FL-1 was calculated to be 3225 cd/$m^2$.

The intensity of excitation light from the excitation light source was adjusted so that light emission luminance of measurement sample FL-5 would be 3225 cd/$m^2$. The emission spectrum of light emission observed from measurement sample FL-6 had a peak at 477 nm and the chromaticity CIE (x, y) thereof was (0.187, 0.425). The light emission was light emission from metal complex 3. Then, measurement sample FL-5 was made emit light continually with the adjusted intensity of excitation light kept constant and LT85 was measured. The result of measurement indicated that LT85 was 45.8 hours.

<Working Measurement Example 6> Measurement of Light emission stability

Measurement sample FL-6 was prepared in the same manner as in Working Measurement Example 1, except that metal complex 4 was used in place of a mixture of isomers 3 and 4 of metal complex 1, and the light emission stability was measured.

According to Expression (17) above, the light emission luminance of measurement sample FL-6 that makes the number of light emission photons same as that of measurement sample FL-1 was calculated to be 3004 cd/$m^2$.

The intensity of excitation light from the excitation light source was adjusted so that light emission luminance of measurement sample FL-6 would be 3004 cd/$m^2$. The emission spectrum of light emission observed from measurement sample FL-7 had a peak at 479 nm and the chromaticity CIE (x, y) thereof was (0.170, 0.404). The light emission was light emission from metal complex 4. Then, measurement sample FL-6 was made emit light continually with the adjusted intensity of excitation light kept constant and LT85 was measured. The result of measurement indicated that LT85 was 69.6 hours.

<Working Measurement Example 7> Measurement of Light emission stability

Measurement sample FL-7 was prepared in the same manner as in Working Measurement Example 1, except that metal complex 5 was used in place of a mixture of isomers 3 and 4 of metal complex 1, and the light emission stability was measured.

According to Expression (17) above, the light emission luminance of measurement sample FL-7 that makes the number of light emission photons same as that of measurement sample FL-1 was calculated to be 2895 cd/$m^2$.

The intensity of excitation light from the excitation light source was adjusted so that light emission luminance of measurement sample FL-7 would be 2895 cd/$m^2$. The emission spectrum of light emission observed from measurement sample FL-7 had a peak at 477 nm and the chromaticity CIE (x, y) thereof was (0.168, 0.380). The light emission was light emission from metal complex 5. Then, measurement sample FL-7 was made emit light continually with the adjusted intensity of excitation light kept constant and LT85 was measured. The result of measurement indicated that LT85 was 54.1 hours.

<Working Measurement Example 8> Measurement of Light emission stability

Measurement sample FL-8 was prepared in the same manner as in Working Measurement Example 1, except that metal complex 8 was used in place of a mixture of isomers 3 and 4 of metal complex 1, and the light emission stability was measured.

According to Expression (17) above, the light emission luminance of measurement sample FL-8 that makes the number of light emission photons same as that of measurement sample FL-1 was calculated to be 3063 cd/$m^2$.

The intensity of excitation light from the excitation light source was adjusted so that light emission luminance of measurement sample FL-8 would be 3063 cd/$m^2$. The emission spectrum of light emission observed from measurement sample FL-8 had a peak at 480 nm and the chromaticity CIE (x, y) thereof was (0.178, 0.415). The light emission was light emission from metal complex 8. Then, measurement sample FL-8 was made emit light continually with the adjusted intensity of excitation light kept constant and LT85 was measured. The result of measurement indicated that LT85 was 44.9 hours.

<Working Measurement Example 9> Measurement of Light emission stability

Measurement sample FL-9 was prepared in the same manner as in Working Measurement Example 1, except that metal complex 9 was used in place of a mixture of isomers 3 and 4 of metal complex 1, and the light emission stability was measured.

According to Expression (17) above, the light emission luminance of measurement sample FL-9 that makes the number of light emission photons same as that of measurement sample FL-1 was calculated to be 3085 cd/$m^2$.

The intensity of excitation light from the excitation light source was adjusted so that light emission luminance of measurement sample FL-9 would be 3085 cd/$m^2$. The emission spectrum of light emission observed from measurement sample FL-9 had a peak at 480 nm and the chromaticity CIE (x, y) thereof was (0.197, 0.412). The light emission was light emission from metal complex 9. Then, measurement sample FL-9 was made emit light continually with the adjusted intensity of excitation light kept constant and LT85 was measured. The result of measurement indicated that LT85 was 97.6 hours.

<Working Measurement Example 10> Measurement of Light emission stability

Measurement sample FL-10 was prepared in the same manner as in Working Measurement Example 1, except that metal complex 10 was used in place of a mixture of isomers 3 and 4 of metal complex 1, and the light emission stability was measured.

According to Expression (17) above, the light emission luminance of measurement sample FL-10 that makes the number of light emission photons same as that of measurement sample FL-1 was calculated to be 3503 cd/$m^2$.

The intensity of excitation light from the excitation light source was adjusted so that light emission luminance of measurement sample FL-10 would be 3503 cd/$m^2$. The emission spectrum of light emission observed from measurement sample FL-10 had a peak at 485 nm and the chromaticity CIE (x, y) thereof was (0.214, 0.477). The light emission was light emission from metal complex 10. Then, measurement sample FL-10 was made emit light continually with the adjusted intensity of excitation light kept constant and LT85 was measured. The result of measurement indicated that LT85 was 44.1 hours.

<Working Measurement Example 11> Measurement of Light emission stability

Measurement sample FL-11 was prepared in the same manner as in Working Measurement Example 1, except that metal complex 11 was used in place of a mixture of isomers 3 and 4 of metal complex 1, and the light emission stability was measured.

According to Expression (17) above, the light emission luminance of measurement sample FL-11 that makes the number of light emission photons same as that of measurement sample FL-1 was calculated to be 2649 cd/$m^2$.

The intensity of excitation light from the excitation light source was adjusted so that light emission luminance of measurement sample FL-11 would be 2649 cd/$m^2$. The emission spectrum of light emission observed from measurement sample FL-11 had a peak at 469 nm and the chromaticity CIE (x, y) thereof was (0.173, 0.317). The light emission was light emission from metal complex 11. Then, measurement sample FL-11 was made emit light continually with the adjusted intensity of excitation light kept constant and LT85 was measured. The result of measurement indicated that LT85 was 41.2 hours.

<Working Measurement Example 12> Measurement of Light emission stability

Measurement sample FL-12 was prepared in the same manner as in Working Measurement Example 1, except that metal complex 12 was used in place of a mixture of isomers 3 and 4 of metal complex 1, and the light emission stability was measured.

According to Expression (17) above, the light emission luminance of measurement sample FL-12 that makes the number of light emission photons same as that of measurement sample FL-1 was calculated to be 2679 cd/$m^2$.

The intensity of excitation light from the excitation light source was adjusted so that light emission luminance of measurement sample FL-12 would be 2679 cd/$m^2$. The emission spectrum of light emission observed from Measurement Sample FL-12 had a peak at 469 nm and the chromaticity CIE (x, y) thereof was (0.175, 0.319). The light emission was light emission from metal complex 12. Then, measurement sample FL-12 was made emit light continually with the adjusted intensity of excitation light kept constant and LT85 was measured. The result of measurement indicated that LT85 was 45.6 hours.

<Working Measurement Example 13> Measurement of Light emission stability

Measurement sample FL-13 was prepared in the same manner as in Working Measurement Example 1, except that metal complex 13 was used in place of a mixture of isomers 3 and 4 of metal complex 1 and that a compound represented by the formula (H-103) below (hereinafter, also referred to as "compound H-103".) (a product manufactured by Light emission Technology Corp., LT-E107) was used in place of compound H-113.

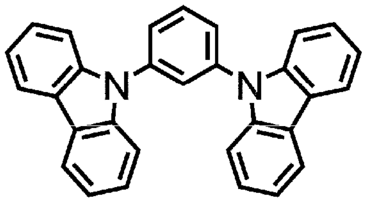

(H-103)

According to Expression (17) above, the light emission luminance of measurement sample FL-13 that makes the number of light emission photons same as that of measurement sample FL-1 was calculated to be 1941 cd/$m^2$.

The intensity of excitation light from the excitation light source was adjusted so that light emission luminance of measurement sample FL-13 would be 1941 cd/$m^2$. The emission spectrum of light emission observed from measurement sample FL-13 had a peak at 453 nm and the chromaticity CIE (x, y) thereof was (0.149, 0.196). The light emission was light emission from metal complex 13. Then, measurement sample FL-13 was made emit light continually with the adjusted intensity of excitation light kept constant and LT85 was measured. The result of measurement indicated that LT85 was 44.5 hours.

<Working Measurement Example 14> Measurement of Light emission stability

Measurement sample FL-14 was prepared in the same manner as in Working Measurement Example 1, except that metal complex 3 was used in place of a mixture of isomers 3 and 4 of metal complex 1 and that compound H-103 was used in place of compound H-113, and the light emission stability was measured.

According to Expression (17) above, the light emission luminance of measurement sample FL-14 that makes the number of light emission photons same as that of measurement sample FL-1 was calculated to be 3178 cd/$m^2$.

The intensity of excitation light from the excitation light source was adjusted so that light emission luminance of measurement sample FL-14 would be 3178 cd/$m^2$. The emission spectrum of light emission observed from measurement sample FL-14 had a peak at 477 nm and the chromaticity CIE (x, y) thereof was (0.186, 0.419). The light emission was light emission from metal complex 3. Then, measurement sample FL-14 was made emit light continually with the adjusted intensity of excitation light kept constant and LT85 was measured. The result of measurement indicated that LT85 was 53.5 hours.

<Working Measurement Example 15> Measurement of Light emission stability

Measurement sample FL-15 was prepared in the same manner as in Working Measurement Example 1, except that metal complex 4 was used in place of a mixture of isomers 3 and 4 of metal complex 1 and that compound H-103 was used in place of compound H-113, and the light emission stability was measured.

According to Expression (17) above, the light emission luminance of measurement sample FL-15 that makes the number of light emission photons same as that of measurement sample FL-1 was calculated to be 2965 cd/$m^2$.

The intensity of excitation light from the excitation light source was adjusted so that light emission luminance of measurement sample FL-15 would be 2965 cd/$m^2$. The emission spectrum of light emission observed from measurement sample FL-15 had a peak at 479 nm and the chromaticity CIE (x, y) thereof was (0.164, 0.400). The light emission was light emission from metal complex 4. Then, measurement sample FL-15 was made emit light continually with the adjusted intensity of excitation light kept constant and LT85 was measured. The result of measurement indicated that LT85 was 103.7 hours.

<Comparison Measurement Example 1> Measurement of Light emission stability

Measurement sample CFL-1 was prepared in the same manner as in Working Measurement Example 1, except that metal complex 6 was used in place of a mixture of isomers 3 and 4 of metal complex 1, and the light emission

stability was measured.

According to Expression (17) above, the light emission luminance of measurement sample CFL-1 that makes the number of light emission photons same as that of measurement sample FL-1 was calculated to be 2595 cd/$m^2$.

The intensity of excitation light from the excitation light source was adjusted so that light emission luminance of measurement sample CFL-1 would be 2595 cd/$m^2$. The emission spectrum of light emission observed from measurement sample CFL-1 had a peak at 467 nm and the chromaticity CIE (x, y) thereof was (0.161, 0.304). The light emission was light emission from metal complex 6. Then, measurement sample CFL-1 was made emit light continually with the adjusted intensity of excitation light kept constant and LT85 was measured. The result of measurement indicated that LT85 was 1.97 hours.

<Working Measurement Example 2> Measurement of Light emission stability

Measurement sample CFL-2 was prepared in the same manner as in Working Measurement Example 1, except that metal complex 7 was used in place of a mixture of isomers 3 and 4 of metal complex 1, and the light emission stability was measured.

According to Expression (17) above, the light emission luminance of measurement sample CFL-2 that makes the number of light emission photons same as that of measurement sample FL-1 was calculated to be 2631 cd/$m^2$.

The intensity of excitation light from the excitation light source was adjusted so that light emission luminance of measurement sample CFL-2 would be 1195 cd/$m^2$, which is lower luminance than that described above. The emission spectrum of light emission observed from measurement sample CFL-2 had a peak at 470 nm and the chromaticity CIE (x, y) thereof was (0.164, 0.324). The light emission was light emission from metal complex 7. Then, measurement sample CFL-2 was made emit light continually with the adjusted intensity of excitation light kept constant and LT85 was measured. The result of measurement indicated that LT85 was 1.17 hours.

As described above, metal complexes 1 to 5 and 8 to 12 are superior in light emission stability to metal complexes 6 and 7. Moreover, metal complexes 13, 3, and 4 are equally excellent in light emission stability.

[Table 2]

| Measurement Sample | Metal Complex | Mass [%] | Low Molecular weight Host | Mass [%] | LT85 [time] | Light emission Peak Wavelength [nm] | Chromaticity Coordinate CIE (x,y) |
|---|---|---|---|---|---|---|---|
| FL-1 | Metal Complex 1 Isomers 3 & 4 | 25 | Compound H-113 | 75 | 50.1 | 468 | (0.177,0.324) |
| FL-2 | Metal Complex 1 Isomer 1 | 25 | Compound H-113 | 75 | 46.2 | 467 | (0.195,0.311) |
| FL-3 | Metal Complex 1 Isomer 2 | 25 | Compound H-113 | 75 | 40.6 | 467 | (0.184,0.318) |
| FL-4 | Metal Complex 2 | 25 | Compound H-113 | 75 | 83.3 | 479 | (0.173,0.402) |
| FL-5 | Metal Complex 3 | 25 | Compound H-113 | 75 | 45.8 | 477 | (0.187,0.425) |
| FL-6 | Metal Complex 4 | 25 | Compound H-113 | 75 | 69.6 | 479 | (0.170, 0.404) |
| FL-7 | Metal Complex 5 | 25 | Compound H-113 | 75 | 54.1 | 477 | (0.168,0.380) |
| FL-8 | Metal Complex 8 | 25 | Compound H-113 | 75 | 44.9 | 480 | (0.178,0.415) |
| FL-9 | Metal Complex 9 | 25 | Compound H-113 | 75 | 97.6 | 480 | (0.197,0.412) |
| FL-10 | Metal Complex 10 | 25 | Compound H-113 | 75 | 44.1 | 485 | (0.214,0.477) |
| FL-11 | Metal Complex 11 | 25 | Compound H-113 | 75 | 41.2 | 469 | (0.173,0.317) |

(continued)

| Measurement Sample | Metal Complex | Mass [%] | Low Molecular weight Host | Mass [%] | LT85 [time] | Light emission Peak Wavelength [nm] | Chromaticity Coordinate CIE (x,y) |
|---|---|---|---|---|---|---|---|
| FL-12 | Metal Complex 12 | 25 | Compound H-113 | 75 | 45.6 | 469 | (0.175, 0.319) |
| FL-13 | Metal Complex 13 | 25 | Compound H-103 | 75 | 44.5 | 453 | (0.149, 0.196) |
| FL-14 | Metal Complex 3 | 25 | Compound H-103 | 75 | 53.5 | 477 | (0.186,0.419) |
| FL-15 | Metal Complex 4 | 25 | Compound H-103 | 75 | 103.7 | 479 | (0.164,0.400) |
| CFL-1 | Metal Complex 6 | 25 | Compound H-113 | 75 | 1.97 | 467 | (0.161, 0.304) |
| CFL-2 | Metal Complex 7 | 25 | Compound H-113 | 75 | 1.17 | 470 | (0.164, 0.324) |

**Industrial Availability**

According to the present invention, metal complexes having excellent light emission stability can be provided. Moreover, according to the present invention, a composition, a film, and a light emitting device comprising such a metal complex can be provided.

**Claims**

**1.** A metal complex represented by formula (1):

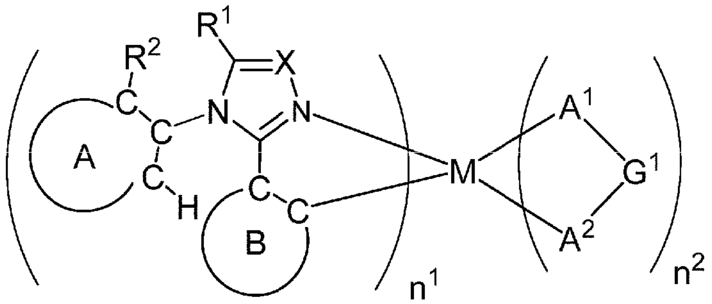

(1)

wherein,

X represents a nitrogen atom or a group represented by =C($R^X$)-, where $R^X$ represents a hydrogen atom, an alkyl group, a cycloalkyl group, an alkoxy group, a cycloalkoxy group, an aryl group, an aryloxy group, a monovalent heterocyclic group, a substituted amino group, or a halogen atom and these groups may have a substituent selected from the group consisting of a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group and a cycloalkynyl group, and when there are a plurality of X, they may be the same or different;

$R^1$ represents an alkyl group having 5 or more carbon atoms, the group may have a substituent selected from the group consisting of an alkoxy group, a cycloalkyl group, a cycloalkoxy group, an aryl group, a monovalent heterocyclic group, a substituted amino group and a halogen atom, and when there are a plurality of $R^1$, they may be the same or different;

$R^2$ represents an alkyl group, a cycloalkyl group, an alkoxy group, a cycloalkoxy group, an aryl group, an aryloxy group, a monovalent heterocyclic group, a substituted amino group, or a halogen atom and these groups may

have a substituent selected form the group consisting of an alkyl group, a cycloalkyl group, an alkoxy group, a cycloalkoxy group, an aryl group, a monovalent heterocyclic group, a substituted amino group and a halogen atom, and when there are a plurality of $R^2$, they may be the same or different;

ring A and ring B each independently represent an aromatic hydrocarbon ring or an aromatic heterocyclic ring and these rings may have a substituent, and when there are a plurality of substituents, they may be the same or different or bonded to each other to form a ring together with atoms to which they are bonded; when there are a plurality of ring A and ring B, they may be the same or different;

wherein the optional substituents of ring A are selected from the group consisting of an alkyl group, a cycloalkyl group, an aryl group, a monovalent heterocyclic group and a substituted amino group;

wherein the optional substituents of ring B are selected from the group consisting of an alkyl group, a cycloalkyl group, an aryl group, a monovalent heterocyclic group, a substituted amino group and a halogen atom; M represents a rhodium atom, a palladium atom, an iridium atom, or a platinum atom;

$n^1$ represents an integer of 1 or higher, $n^2$ represents an integer of 0 or higher, and $n^1 + n^2$ is 2 or 3;

when M is a rhodium atom or an iridium atom, $n^1 + n^2$ is 3, and when M is a palladium atom or a platinum atom, $n^1 + n^2$ is 2;

$A^1$-$G^1$-$A^2$ represents an anionic bidentate ligand; $A^1$ and $A^2$ each independently represent a carbon atom, an oxygen atom, or a nitrogen atom and these atoms may be atoms constituting a ring; $G^1$ represents a single bond; or an atomic group constituting a bidentate ligand together with $A^1$ and $A^2$; and when there are a plurality of $A^1$-$G^1$-$A^2$, they may be the same or different.

**2.** The metal complex according to claim 1, wherein the ring B is a benzene ring, a fluorene ring, a dibenzofuran ring, or a dibenzothiophene ring.

**3.** The metal complex according to claim 2, wherein the metal complex is represented by formula (1a):

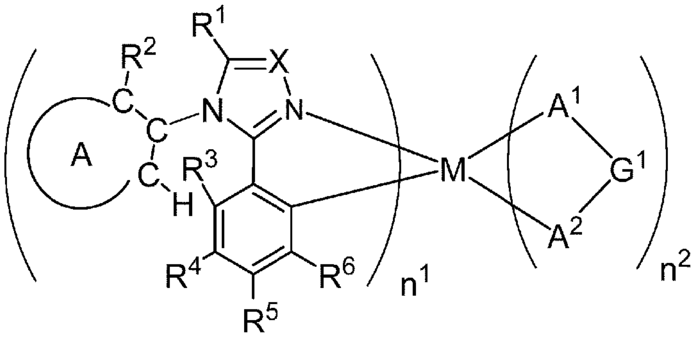

(1a)

wherein,

M, $n^1$, $n^2$, $R^1$, $R^2$, ring A, X, and $A^1$-$G^1$-$A^2$ have the same meanings as described above;

$R^3$, $R^4$, $R^5$, and $R^6$ each independently represent a hydrogen atom, an alkyl group, a cycloalkyl group, an alkoxy group, a cycloalkoxy group, an aryl group, an aryloxy group, a monovalent heterocyclic group, a substituted amino group, or a halogen atom and these groups may have a substituent selected from the group consisting of an alkyl group, a cycloalkyl group, an alkoxy group, a cycloalkoxy group, an aryl group, a monovalent heterocyclic group, a substituted amino group and a halogen atom;

when there are a plurality of $R^3$, $R^4$, $R^5$, and $R^6$, they may be the same or different; $R^3$ and $R^4$, $R^4$ and $R^5$, and $R^5$ and $R^6$ each may be bonded to each other to form a ring together with the atoms to which they are bonded.

**4.** The metal complex according to claim 3, wherein the metal complex is represented by formula (1b):

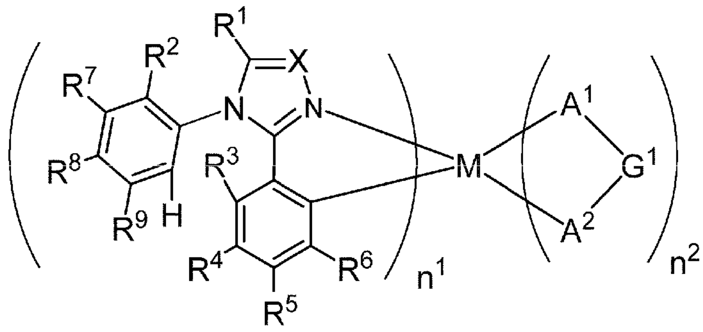

(1b)

wherein,

M, $n^1$ $n^2$, $R^1$, $R^2$, $R^3$, $R^4$, $R^5$, $R^6$, X, and $A^1$-$G^1$-$A^2$ have the same meanings as described above;
$R^7$, $R^8$, and $R^9$ each independently represent a hydrogen atom, an alkyl group, a cycloalkyl group, an alkoxy group, a cycloalkoxy group, an aryl group, an aryloxy group, a monovalent heterocyclic group, a substituted amino group, or a halogen atom and these groups may have a substituent selected from the group consisting of an alkyl group, a cycloalkyl group, an alkoxy group, a cycloalkoxy group, an aryl group, a monovalent heterocyclic group, a substituted amino group and a halogen atom; when there are a plurality of $R^7$, $R^8$, and $R^9$, they may be the same or different; $R^7$ and $R^8$ and $R^8$ and $R^9$ may be bonded to each other to form a ring together with the atoms to which they are bonded.

**5.** The metal complex according to any one of claims 1 to 4, wherein at least one of $R^1$ is a group represented by formula (2):

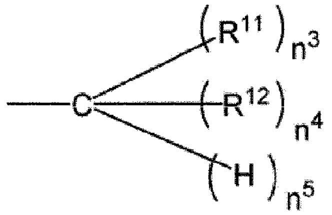

(2)

(wherein,

$R^{11}$ represents an alkyl group and the group may have a substituent selected from the group consisting of an alkoxy group, a cycloalkyl group, a cycloalkoxy group, an aryl group, a monovalent heterocyclic group, a substituted amino group and a halogen atom; when there are a plurality of $R^{11}$, they may be the same or different;
$R^{12}$ represents a cycloalkyl group, an alkoxy group, a cycloalkoxy group, an aryl group, an aryloxy group, a monovalent heterocyclic group, a substituted amino group, or a halogen atom and these groups may have a substituent selected from the group consisting of an alkyl group, a cycloalkyl group, an alkoxy group, a cycloalkoxy group, an aryl group, a monovalent heterocyclic group, a substituted amino group and a halogen atom; when there are a plurality of $R^{12}$, they may be the same or different;
$n^3$ represents an integer of 1 to 3, $n^4$ represents an integer of 0 to 2, $n^5$ represents 0 or 1, and $n^3 + n^4 + n^5$ is 3).

**6.** The metal complex according to claim 5, wherein $n^5$ is 0.

**7.** The metal complex according to claim 5 or 6, wherein $n^4$ is 0.

**8.** The metal complex according to any one of claims 1 to 7, wherein $R^2$ is an alkyl group that may have a substituent.

**9.** The metal complex according to any one of claims 1 to 8, wherein M is a platinum atom or an iridium atom.

**10.** The metal complex according to any one of claims 1 to 9, wherein $n^2$ is 0.

**11.** The metal complex according to any one of claims 1 to 10, wherein X is a nitrogen atom.

**12.** A composition comprising:

a metal complex according to any one of claims 1 to 11; and
a compound represented by formula (H-1) and at least one selected from the group consisting of polymer compounds comprising a constitutional unit represented by formula (Y):

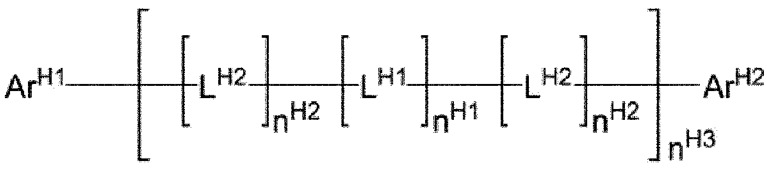

**(H-1)**

wherein,

$Ar^{H1}$ and $Ar^{H2}$ each independently represent an aryl group or a monovalent heterocyclic group and these groups may have a substituent selected from the group consisting of a halogen atom, an alkyl group, a cycloalkyl group, an alkoxy group, a cycloalkoxy group, an aryl group and a monovalent heterocyclic group;
$n^{H1}$ and $n^{H2}$ each independently represent 0 or 1; when there are a plurality of $n^{H1}$, they may be the same or different; when there are a plurality of $n^{H2}$, they may be the same or different;
$n^{H3}$ represents an integer of 0 or more;
$L^{H1}$ represents an arylene group, a divalent heterocyclic group, or a group represented by $-[C(R^{H11})_2]n^{H11}-$ and these groups may have a substituent selected from the group consisting of a halogen atom, an alkyl group, a cycloalkyl group, an alkoxy group, a cycloalkoxy group, an aryl group and a monovalent heterocyclic group; when there are a plurality of $L^{H1}$, they may be the same or different;
$n^{H11}$ represents an integer of 1 or more and 10 or less; $R^{H11}$ represents a hydrogen atom, an alkyl group, a cycloalkyl group, an alkoxy group, a cycloalkoxy group, an aryl group, or a monovalent heterocyclic group and these groups may have a substituent selected from the group consisting of a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group and a cycloalkynyl group; a plurality of $R^{H11}$ may be the same or different and they may be bonded to each other to form a ring together with carbon atoms to which they are bonded;
$L^{H2}$ represents a group represented by $-N(-L^{H21}-R^{H21})-$; when there are a plurality of $L^{H2}$, they may be the same or different;
$L^{H21}$ represents a single bond, an arylene group, or a divalent heterocyclic group, and these groups may have a substituent selected from the group consisting of a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group and a cycloalkynyl group; $R^{H21}$ represents a hydrogen atom, an alkyl group, a cycloalkyl group, an aryl group, or a monovalent heterocyclic group, and these groups may have a substituent selected from the group consisting of a halogen atom, an alkyl group, a cycloalkyl group, an alkoxy group, a cycloalkoxy group, an aryl group and a monovalent heterocyclic group.

$$-[-Ar^{Y1}-]- \qquad (Y)$$

wherein $Ar^{Y1}$ represents an arylene group, a divalent heterocyclic group, or a divalent group in which at least one arylene group and at least one divalent heterocyclic group are directly bonded and these groups may have a substituent selected from the group consisting of an alkyl group, a cycloalkyl group and an aryl group.

**13.** A composition comprising
a metal complex according to any one of claims 1 to 11 and
at least one material selected from the group consisting of a hole transporting material, a hole injecting material, an electron transporting material, an electron injecting material, a luminescent material, an antioxidant, and a solvent.

**14.** A film comprising the metal complex according to any one of claims 1 to 11.

**15.** A light emitting device comprising a metal complex according to any one of claims 1 to 11.

## Patentansprüche

**1.** Metallkomplex, dargestellt durch Formel (1):

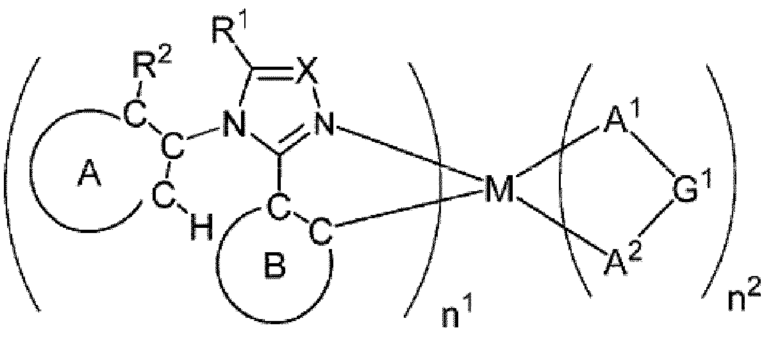

(1)

wobei

x ein Stickstoffatom oder eine Gruppe darstellt, dargestellt durch =C($R^X$)-,wobei $R^X$ ein Wasserstoffatom, eine Alkylgruppe, eine Cycloalkylgruppe, eine Alkoxygruppe, eine Cycloalkoxygruppe, eine Arylgruppe, eine Aryloxygruppe, eine monovalente heterozyklische Gruppe, eine substituierte Aminogruppe oder ein Halogenatom darstellt und diese Gruppen einen Substituenten haben können, ausgewählt aus der Gruppe bestehend aus einem Halogenatom, einer Cyanogruppe, einer Alkylgruppe, einer Cycloalkylgruppe, einer Arylgruppe, einer monovalenten heterozyklischen Gruppe, einer Alkoxygruppe, einer Cycloalkoxygruppe, einer Aryloxygruppe, einer Aminogruppe, einer substituierten Aminogruppe, einer Alkenylgruppe, einer Cycloalkenylgruppe, einer Alkynylgruppe und einer Cycloalkynylgruppe, und wenn es eine Vielzahl von X gibt, können sie gleich oder unterschiedlich sein;

$R^1$ eine Alkylgruppe mit 5 oder mehr Kohlenstoffatomen darstellt, die Gruppe einen Substituenten haben kann, ausgewählt aus der Gruppe bestehend aus einer Alkoxygruppe, einer Cycloalkylgruppe, einer Cycloalkoxygruppe, einer Arylgruppe, einer monovalenten heterozyklischen Gruppe, einer substituierten Aminogruppe und einem Halogenatom, und wenn es eine Vielzahl von $R^1$ gibt, können sie gleich oder unterschiedlich sein;

$R^2$ eine Alkylgruppe, eine Cycloalkylgruppe, eine Alkoxygruppe, eine Cycloalkoxygruppe, eine Arylgruppe, eine Aryloxygruppe, eine monovalente heterozyklische Gruppe, eine substituierte Aminogruppe oder ein Halogenatom darstellt und diese Gruppen einen Substituenten haben können, ausgewählt aus der Gruppe bestehend aus einer Alkylgruppe, einer Cyckloaklylgruppe, einer Alkoxygruppe, einer Cycloalkoxygruppe, einer Arylgruppe, einer monovalenten heterozyklischen Gruppe, einer substituierten Aminogruppe und einem Halogenatom und wenn es eine Vielzahl von $R^2$ gibt, können sie gleich oder unterschiedlich sein;

Ring A und Ring B jeweils unabhängig einen aromatischen Kohlenwasserstoffring oder einen aromatischen heterozyklischen Ring darstellen und diese Ringe einen Substituenten haben können und wenn es eine Vielzahl von Substituenten gibt, können sie gleich oder unterschiedlich oder aneinander gebunden sein, um einen Ring zusammen mit Atomen zu bilden, an die sie gebunden sind; wenn es eine Vielzahl von Ring A und Ring B gibt, können sie gleich oder unterschiedlich sein;

wobei die optionalen Substituenten von Ring A ausgewählt sind aus der Gruppe bestehend aus einer Alkylgruppe, einer Cycloalkylgruppe, einer Arylgruppe, einer monovalenten heterozyklischen Gruppe und einer substituierten Aminogruppe;

wobei die optionalen Substituenten von Ring B ausgewählt sind aus der Gruppe bestehend aus einer Alkylgruppe, einer Cycloalkylgruppe, einer Arylgruppe, einer monovalenten heterozyklischen Gruppe, einer substituierten Aminogruppe und einem Halogenatom; M ein Rhodiumatom, ein Palladiumatom, ein Iridiumatom oder ein Platinatom darstellt;

$n^1$ eine Ganzzahl von 1 oder höher darstellt, $n^2$ eine Ganzzahl von 0 oder höher darstellt und $n^1 + n^2$ 2 oder 3 ist; wenn M ein Rhodiumatom oder ein Iridiumatom ist, $n^1 + n^2$ 3 ist und wenn M ein Palladiumatom oder ein Platinatom ist, $n^1 + n^2$ 2 ist;

$A^1$-$G^1$-$A^2$ einen anionischen, zweizähnigen Liganden darstellt; $A^1$ und $A^2$ jeweils unabhängig ein Kohlenstoffatom, ein Sauerstoffatom oder ein Stickstoffatom darstellen und diese Atome Atome sein können, die einen Ring bilden; $G^1$ eine Einfachbindung darstellt; oder eine Atomgruppe, die einen zweizähnigen Liganden zu-

sammen mit $A^1$ und $A^2$ bildet; und wenn es eine Vielzahl von $A^1$-$G^1$-$A^2$ gibt, können sie gleich oder unterschiedlich sein.

**2.** Metallkomplex nach Anspruch 1, wobei der Ring B ein Benzolring, ein Fluorenring, ein Dibenzofuranring oder ein Dibenzothiophenring ist.

**3.** Metallkomplex nach Anspruch 2, wobei der Metallkomplex durch Formel (1a) dargestellt ist:

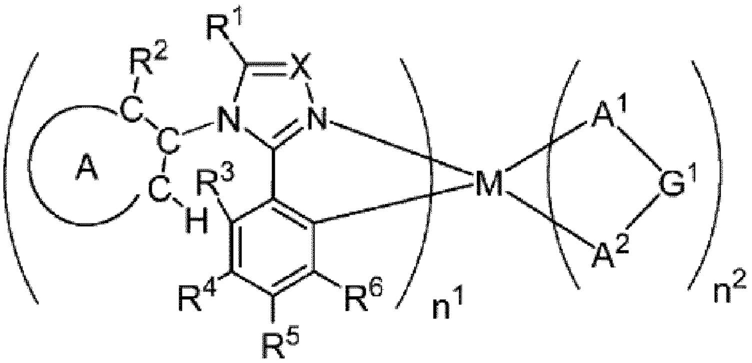

(1a)

wobei

M, $n^1$, $n^2$, $R^1$, $R^2$, Ring A, X und $A^1$-$G^1$-$A^2$ die gleichen Bedeutungen wie oben beschrieben haben;
$R^3$, $R^4$, $R^5$ und $R^6$ jeweils unabhängig ein Wasserstoffatom, eine Alkylgruppe, eine Cycloalkylgruppe, eine Alkoxygruppe, eine Cycloalkoxygruppe, eine Arylgruppe, eine Aryloxygruppe, eine monovalente heterozyklische Gruppe, eine substituierte Aminogruppe oder ein Halogenatom darstellen und diese Gruppen einen Substituenten haben können, ausgewählt aus der Gruppe bestehend aus einer Alkylgruppe, einer Cycloalkylgruppe, einer Alkoxygruppe, einer Cycloalkoxygruppe, einer Arylgruppe, einer monovalenten heterozyklischen Gruppe, einer substituierten Aminogruppe und einem Halogenatom;
wenn es eine Vielzahl von $R^3$, $R^4$, $R^5$ und $R^6$ gibt, können sie gleich oder unterschiedlich sein; $R^3$ und $R^4$, $R^4$ und $R^5$, und $R^5$ und $R^6$ jeweils aneinandergebunden sein können, um einen Ring zusammen mit den Atomen zu bilden, an die sie gebunden sind.

**4.** Metallkomplex nach Anspruch 3, wobei der Metallkomplex durch Formel (1b) dargestellt ist:

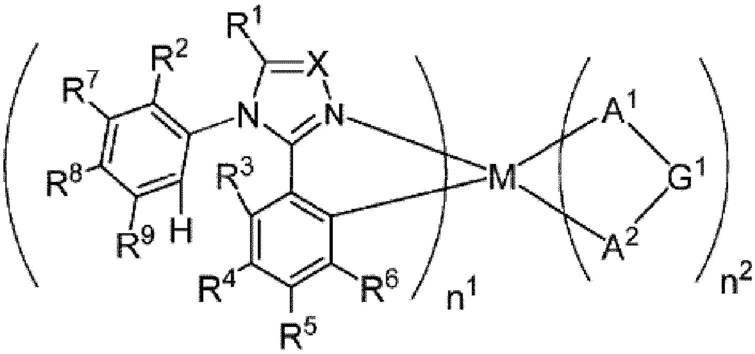

(1b)

wobei

M, $n^1$, $n^2$, $R^1$, $R^2$, $R^3$, $R^4$, $R^5$, $R^6$, X und $A^1$-$G^1$-$A^2$ die gleichen Bedeutungen wie oben beschrieben haben;
$R^7$, $R^8$ und $R^9$ jeweils unabhängig ein Wasserstoffatom, eine Alkylgruppe, eine Cycloalkylgruppe, eine Alkoxygruppe, eine Cycloalkoxygruppe, eine Arylgruppe, eine Aryloxygruppe, eine monovalente heterozyklische Gruppe, eine substituierte Aminogruppe oder ein Halogenatom darstellen und diese Gruppen einen Substituenten haben können, ausgewählt aus der Gruppe bestehend aus einer Alkylgruppe, einer Cycloalkylgruppe, einer Alkoxygruppe, einer Cycloalkoxygruppe, einer Arylgruppe, einer monovalenten heterozyklischen Gruppe, einer substituierten Aminogruppe und einem Halogenatom; wenn es eine Vielzahl von $R^7$, $R^8$ und $R^9$ gibt, können

sie gleich oder unterschiedlich sein; $R^7$ und $R^8$, und $R^8$ und $R^9$ aneinandergebunden sein können, um einen Ring zusammen mit den Atomen zu bilden, an die sie gebunden sind.

**5.** Metallkomplex nach einem der Ansprüche 1 bis 4, wobei mindestens eines aus $R^1$ eine Gruppe ist, dargestellt durch Formel (2):

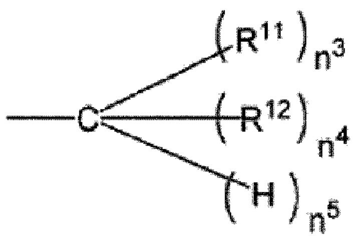

(2)

(wobei

$R^{11}$ eine Alkylgruppe darstellt und die Gruppe einen Substituenten haben kann, ausgewählt aus der Gruppe bestehend aus einer Alkoxygruppe, einer Cycloalkylgruppe, einer Cycloalkoxygruppe, einer Arylgruppe, einer monovalenten heterozyklischen Gruppe, einer substituierten Aminogruppe und einem Halogenatom; wenn es eine Vielzahl von $R^{11}$ gibt, können sie gleich oder unterschiedlich sein;
$R^{12}$ eine Cycloalkylgruppe, eine Alkoxygruppe, eine Cycloalkoxygruppe, eine Arylgruppe, eine Aryloxygruppe, eine monovalente heterozyklische Gruppe, eine substituierte Aminogruppe oder ein Halogenatom darstellt und diese Gruppen einen Substituenten haben können, ausgewählt aus der Gruppe bestehend aus einer Alkylgruppe, einer Cycloalkylgruppe, einer Alkoxygruppe, einer Cycloalkoxygruppe, einer Arylgruppe, einer monovalenten heterozyklischen Gruppe, einer substituierten Aminogruppe und einem Halogenatom; wenn es eine Vielzahl von $R^{12}$ gibt, können sie gleich oder unterschiedlich sein;
$n^3$ eine Ganzzahl von 1 bis 3 darstellt, $n^4$ eine Ganzzahl von 0 bis 2 darstellt, $n^5$ 0 oder 1 darstellt und $n^3 + n^4 + n^5$ 3 ist).

**6.** Metallkomplex nach Anspruch 5, wobei $n^5$ 0 ist.

**7.** Metallkomplex nach Anspruch 5 oder 6, wobei $n^4$ 0 ist.

**8.** Metallkomplex nach einem der Ansprüche 1 bis 7, wobei $R^2$ eine Alkylgruppe ist, die einen Substituenten haben kann.

**9.** Metallkomplex nach einem der Ansprüche 1 bis 8, wobei M ein Platinatom oder ein Iridiumatom ist.

**10.** Metallkomplex nach einem der Ansprüche 1 bis 9, wobei $n^2$ 0 ist.

**11.** Metallkomplex nach einem der Ansprüche 1 bis 10, wobei X ein Stickstoffatom ist.

**12.** Zusammensetzung, umfassend:

einen Metallkomplex nach einem der Ansprüche 1 bis 11; und
eine Verbindung, dargestellt durch Formel (H-1) und mindestens eines, ausgewählt aus der Gruppe bestehend aus Polymerverbindungen, umfassend eine konstitutionelle Einheit, dargestellt durch Formel (Y):

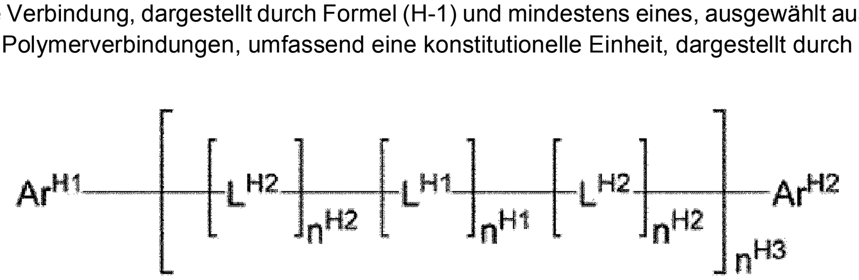

**(H-1)**

wobei

$Ar^{H1}$ und $Ar^{H2}$ jeweils unabhängig eine Arylgruppe oder eine monovalente heterozyklische Gruppe darstellen und diese Gruppen einen Substituenten haben können, ausgewählt aus der Gruppe bestehend aus einem Halogenatom, einer Alkylgruppe, einer Cycloalkylgruppe, einer Alkoxygruppe, einer Cycloalkoxygruppe, einer Arylgruppe und einer monovalenten heterozyklischen Gruppe;
$n^{H1}$ und $n^{H2}$ jeweils unabhängig 0 oder 1 darstellen; wenn es eine Vielzahl von $n^{H1}$ gibt, können sie gleich oder unterschiedlich sein; wenn es eine Vielzahl von $n^{H2}$ gibt, können sie gleich oder unterschiedlich sein;
$n^{H3}$ eine Ganzzahl von 0 oder mehr darstellt;
$L^{H1}$ eine Arylengruppe, eine divalente heterozyklische Gruppe oder eine Gruppe darstellt, die durch $-[C(R^{H11})_2]n^{H11}-$ dargestellt ist, und diese Gruppe können einen Substituenten haben, ausgewählt aus der Gruppe bestehend aus einem Halogenatom, einer Alkylgruppe, einer Cycloalkylgruppe, einer Alkoxygruppe, einer Cycloalkoxygruppe, einer Arylgruppe und einer monovalenten heterozyklischen Gruppe, wenn es eine Vielzahl von $L^{H1}$ gibt, können sie gleich oder unterschiedlich sein;
$n^{H11}$ eine Ganzzahl von 1 oder mehr und 10 oder weniger darstellt; $R^{H11}$ ein Wasserstoffatom, eine Alkylgruppe, eine Cycloalkylgruppe, eine Alkoxygruppe, eine Cycloalkoxygruppe, eine Arylgruppe oder eine monovalente heterozyklische Gruppe darstellt und diese Gruppen einen Substituenten haben können, ausgewählt aus der Gruppe bestehend aus einem Halogenatom, einer Cyanogruppe, einer Alkylgruppe, einer Cycloalkylgruppe, einer Arylgruppe, einer monovalenten heterozyklischen Gruppe, einer Alkoxygruppe, einer Cycloalkoxygruppe, einer Aryloxygruppe, einer Aminogruppe, einer substituierten Aminogruppe, einer Alkenylgruppe, einer Cycloalkenylgruppe, einer Alknylgruppe und einer Cycloalkynylgruppe; eine Vielzahl von $R^{H11}$ kann gleich oder unterschiedlich sein und sie können aneinander gebunden sein, um einen Ring zusammen mit Kohlenstoffatomen zu bilden, an die sie gebunden sind;
$L^{H2}$ eine Gruppe darstellt, dargestellt durch $-N(-L^{H21}-R^{H21})-$; wenn es eine Vielzahl von $L^{H2}$ gibt, können sie gleich oder unterschiedlich sein;
$L^{H21}$ eine Einfachbindung, eine Arylengruppe oder eine divalente heterozyklische Gruppe darstellt und diese Gruppen einen Substituenten haben können, ausgewählt aus der Gruppe bestehend aus einem Halogenatom, einer Cyanogruppe, einer Alkylgruppe, einer Cycloalkylgruppe, einer Arylgruppe, einer monovalenten heterozyklischen Gruppe, einer Alkoxygruppe, einer Cycloalkoxygruppe, einer Aryloxygruppe, einer Aminogruppe, einer substituierten Aminogruppe, einer Alkenylgruppe, einer Cycloalkenylgruppe, einer Alkylylgruppe und einer Cycloalkynylgruppe; $R^{H21}$ ein Wasserstoffatom, eine Alkylgruppe, eine Cycloalkylgruppe, eine Arylgruppe oder eine monovalente heterozyklische Gruppe darstellt und diese Gruppen einen Substituenten haben können, ausgewählt aus der Gruppe bestehend aus einem Halogenatom, einer Alkylgruppe, einer Cycloalkylgruppe, einer Alkoxygruppe, einer Cycloalkoxygruppe, einer Arylgruppe und einer monovalenten heterozyklischen Gruppe.

$$-[-Ar^{Y1}-]- \qquad (Y)$$

wobei $Ar^{Y1}$ eine Arylengruppe, eine divalente heterozyklische Gruppe oder eine divalente Gruppe darstellt, in der mindestens eine Arylengruppe und mindestens eine divalente heterozyklische Gruppe unmittelbar verbunden sind und diese Gruppen einen Substituenten haben können, ausgewählt aus der Gruppe bestehend aus einer Alkylgruppe, einer Cycloalkylgruppe und einer Arylgruppe.

**13.** Zusammensetzung, umfassend
einen Metallkomplex nach einem der Ansprüche 1 bis 11 und
mindestens ein Material, ausgewählt aus der Gruppe bestehend aus einem Lochtransportmaterial, einem Lochinjektionsmaterial, einem Elektronentransportmaterial, einem Elektroneninjektionsmaterial, einem Leuchtstoff, einem Antioxidationsmittel und einem Lösungsmittel.

**14.** Film, umfassend den Metallkomplex nach einem der Ansprüche 1 bis 11.

**15.** Lichtemittierende Vorrichtung, umfassend einen Metallkomplex nach einem der Ansprüche 1 bis 11.

## Revendications

**1.** Complexe métallique représenté par la formule (1) :

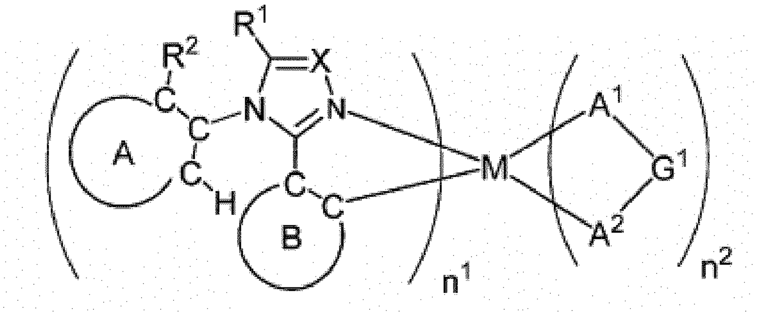

(1)

dans lequel X représente un atome d'azote ou un groupe représenté par $=C(R^X)-$, où $R^X$ représente un atome d'hydrogène, un groupe alkyle, un groupe cycloalkyle, un groupe alcoxy, un groupe cycloalcoxy, un groupe aryle, un groupe aryloxy, un groupe hétérocyclique monovalent, un groupe amino substitué ou un atome d'halogène et ces groupes peuvent avoir un substituant choisi dans le groupe constitué par un atome d'halogène, un groupe cyano, un groupe alkyle, un groupe cycloalkyle, un groupe aryle, un groupe hétérocyclique monovalent, un groupe alcoxy, un groupe cycloalcoxy, un groupe aryloxy, un groupe amino, un groupe amino substitué, un groupe alcényle, un groupe cycloalcényle, un groupe alcynyle et un groupe cycloalcynyle, et lorsqu'il y a une pluralité de X, ils peuvent être identiques ou différents ;
$R^1$ représente un groupe alkyle ayant 5 atomes de carbone ou plus, le groupe peut avoir un substituant choisi dans le groupe constitué par un groupe alcoxy, un groupe cycloalkyle, un groupe cycloalcoxy, un groupe aryle, un groupe hétérocyclique monovalent, un groupe amino substitué et un atome d'halogène, et lorsqu'il y a une pluralité de $R^1$, ils peuvent être identiques ou différents ;
$R^2$ représente un groupe alkyle, un groupe cycloalkyle, un groupe alcoxy, un groupe cycloalcoxy, un groupe aryle, un groupe aryloxy, un groupe hétérocyclique monovalent, un groupe amino substitué ou un atome d'halogène et ces groupes peuvent avoir un substituant choisi parmi le groupe constitué d'un groupe alkyle, d'un groupe cycloalkyle, d'un groupe alcoxy, d'un groupe cycloalcoxy, d'un groupe aryle, d'un groupe hétérocyclique monovalent, d'un groupe amino substitué et d'un atome d'halogène, et lorsqu'il y a une pluralité de $R^2$, ils peuvent être identiques ou différents ;
le cycle A et le cycle B représentent chacun indépendamment un cycle hydrocarboné aromatique ou un cycle hétérocyclique aromatique et ces cycles peuvent avoir un substituant, et lorsqu'il y a une pluralité de substituants, ils peuvent être identiques ou différents ou liés les uns aux autres pour former un cycle avec les atomes auxquels ils sont liés; lorsqu'il y a une pluralité de cycles A et B, ils peuvent être identiques ou différents ;
dans lequel les substituants facultatifs du cycle A sont choisis dans le groupe constitué par un groupe alkyle, un groupe cycloalkyle, un groupe aryle, un groupe hétérocyclique monovalent et un groupe amino substitué ;
dans lequel les substituants facultatifs du cycle B sont choisis dans le groupe constitué par un groupe alkyle, un groupe cycloalkyle, un groupe aryle, un groupe hétérocyclique monovalent, un groupe amino substitué et un atome d'halogène ; M représente un atome de rhodium, un atome de palladium, un atome d'iridium ou un atome de platine ;
$n^1$ représente un entier de 1 ou plus, $n^2$ représente un entier de 0 ou plus, et $n^1 + n^2$ vaut 2 ou 3 ;
lorsque M est un atome de rhodium ou un atome d'iridium, $n^1 + n^2$ vaut 3, et lorsque M est un atome de palladium ou un atome de platine, $n^1 + n^2$ vaut 2 ;
$A^1$-$G^1$-$A^2$ représente un ligand bidenté anionique ; $A^1$ et $A^2$ représentent chacun indépendamment un atome de carbone, un atome d'oxygène ou un atome d'azote et ces atomes peuvent être des atomes constituant un cycle ; $G^1$ représente une liaison simple ; ou un groupe atomique constituant un ligand bidenté avec $A^1$ et $A^2$ ; et lorsqu'il y a une pluralité de $A^1$-$G^1$-$A^2$, ils peuvent être identiques ou différents.

2. Complexe métallique selon la revendication 1, dans lequel le cycle B est un cycle benzène, un cycle fluorène, un cycle dibenzofurane ou un cycle dibenzothiophène.

3. Complexe métallique selon la revendication 2, dans lequel le complexe métallique est représenté par la formule (la):

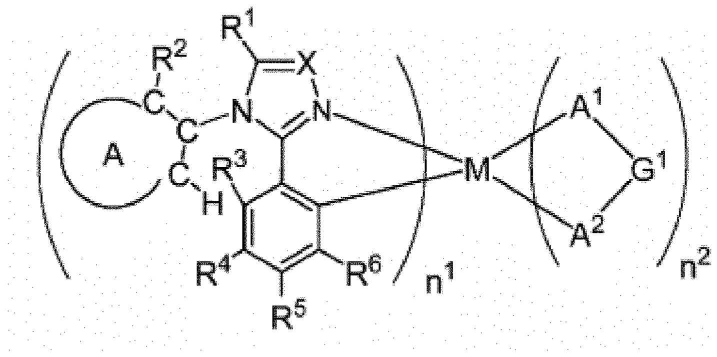

(1a)

dans lequel,

M, $n^1$, $n^2$, $R^1$, $R^2$, le cycle A, X et $A^1$-$G^1$-$A^2$ ont les mêmes significations que décrit ci-dessus;
$R^3$, $R^4$, $R^5$ et $R^6$ représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent, un groupe amino substitué, ou un atome d'halogène et ces groupes peuvent avoir un substituant choisi dans le groupe constitué par un groupe alkyle, un groupe cycloalkyle, un groupe alcoxy, un groupe cycloalcoxy, un groupe aryle, un groupe hétérocyclique monovalent, un groupe amino substitué et un atome d'halogène ;
lorsqu'il y a une pluralité de $R^3$, $R^4$, $R^5$ et $R^6$, ils peuvent être identiques ou différents ;
$R^3$ et $R^4$, $R^4$ et $R^5$, et $R^5$ et $R^6$ peuvent chacun être liés les uns aux autres pour former un cycle avec les atomes auxquels ils sont liés.

**4.** Complexe métallique selon la revendication 3, dans lequel le complexe métallique est représenté par la formule (1b) :

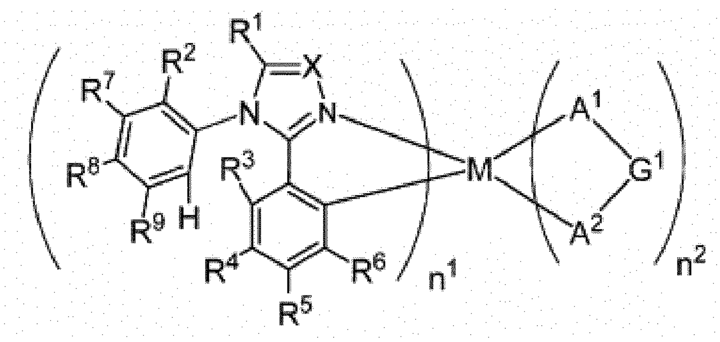

(1b)

dans lequel,

M, $n^1$, $n^2$, $R^1$, $R^2$, $R^3$, $R^4$, $R^5$, $R^6$, X et $A^1$-$G^1$-$A^2$ ont les mêmes significations que celles décrites ci-dessus;
$R^7$, $R^8$ et $R^9$ représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent, un groupe amino substitué ou un halogène atome et ces groupes peuvent avoir un substituant choisi dans le groupe constitué par un groupe alkyle, un groupe cycloalkyle, un groupe alcoxy, un groupe cycloalcoxy, un groupe aryle, un groupe hétérocyclique monovalent, un groupe amino substitué et un atome d'halogène ; lorsqu'il y a une pluralité de $R^7$, $R^8$ et $R^9$, ils peuvent être identiques ou différents ; $R^7$ et $R^8$, et $R^8$ et $R^9$, peuvent être liés les uns aux autres pour former un cycle avec les atomes auxquels ils sont liés.

**5.** Complexe métallique selon l'une quelconque des revendications 1 à 4, dans lequel au moins un de $R^1$ est un groupe représenté par la formule (2) :

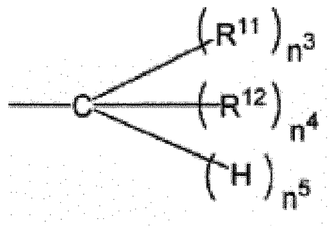

(2)

(dans lequel,

$R^{11}$ représente un groupe alkyle et le groupe peut avoir un substituant choisi dans le groupe constitué par un groupe alcoxy, un groupe cycloalkyle, un groupe cycloalcoxy, un groupe aryle, un groupe hétérocyclique monovalent, un groupe amino substitué et un atome d'halogène ; lorsqu'il y a une pluralité de $R^{11}$, ils peuvent être identiques ou différents ;
$R^{12}$ représente un groupe cycloalkyle, un groupe alcoxy, un groupe cycloalcoxy, un groupe aryle, un groupe aryloxy, un groupe hétérocyclique monovalent, un groupe amino substitué ou un atome d'halogène et ces groupes peuvent avoir un substituant choisi dans le groupe constitué par un groupe alkyle, un groupe cycloalkyle, un groupe alcoxy, un groupe cycloalcoxy, un groupe aryle, un groupe hétérocyclique monovalent, un groupe amino substitué et un atome d'halogène ; lorsqu'il y a une pluralité de $R^{12}$, ils peuvent être identiques ou différents;
$n^3$ représente un entier de 1 à 3, $n^4$ représente un entier de 0 à 2, $n^5$ représente 0 ou 1 et $n^3 + n^4 + n^5$ vaut 3).

**6.** Complexe métallique selon la revendication 5, dans lequel $n^5$ vaut 0.

**7.** Complexe métallique selon la revendication 5 ou 6, dans lequel $n^4$ vaut 0.

**8.** Complexe métallique selon l'une quelconque des revendications 1 à 7, dans lequel $R^2$ est un groupe alkyle qui peut avoir un substituant.

**9.** Complexe métallique selon l'une quelconque des revendications 1 à 8, dans lequel M est un atome de platine ou un atome d'iridium.

**10.** Complexe métallique selon l'une quelconque des revendications 1 à 9, dans lequel $n^2$ vaut 0.

**11.** Complexe métallique selon l'une quelconque des revendications 1 à 10, dans lequel X est un atome d'azote.

**12.** Composition comprenant :

un complexe métallique selon l'une quelconque des revendications 1 à 11 ; et
un composé représenté par la formule (H-1) et au moins un composé choisi dans le groupe constitué de composés polymères comprenant une unité constitutionnelle représentée par la formule (Y):

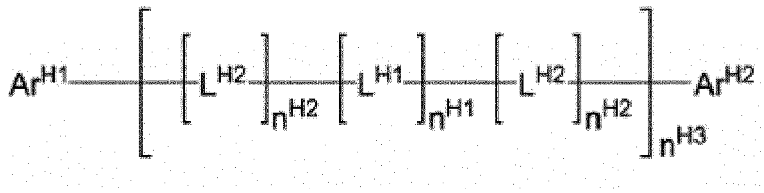

(H-1)

dans laquelle,

$Ar^{H1}$ et $Ar^{H2}$ représentent chacun indépendamment un groupe aryle ou un groupe hétérocyclique monovalent et ces groupes peuvent avoir un substituant choisi dans le groupe constitué par un atome d'halogène, un groupe alkyle, un groupe cycloalkyle, un groupe alcoxy, un groupe cycloalcoxy, un groupe aryle et un groupe hétérocyclique monovalent ;
$n^{H1}$ et $n^{H2}$ représentent chacun indépendamment 0 ou 1 ; lorsqu'il y a une pluralité de $n^{H1}$, ils peuvent être

identiques ou différents ; lorsqu'il y a une pluralité de $n^{H2}$, ils peuvent être identiques ou différents ;
$n^{H3}$ représente un entier de 0 ou plus ;
$L^{H1}$ représente un groupe arylène, un groupe hétérocyclique divalent ou un groupe représenté par $-[C(RH^{11})_2]n^{H11}-$ et ces groupes peuvent avoir un substituant choisi dans le groupe constitué par un atome d'halogène, un groupe alkyle, un groupe cycloalkyle, un groupe alcoxy, un groupe cycloalcoxy, un groupe aryle et un groupe hétérocyclique monovalent ; lorsqu'il y a une pluralité de $L^{H1}$, ils peuvent être identiques ou différents;
$n^{H11}$ représente un entier de 1 ou plus et 10 ou moins ; $R^{H11}$ représente un atome d'hydrogène, un groupe alkyle, un groupe cycloalkyle, un groupe alcoxy, un groupe cycloalcoxy, un groupe aryle ou un groupe hétérocyclique monovalent et ces groupes peuvent avoir un substituant choisi dans le groupe constitué par un atome d'halogène, un groupe cyano, un groupe alkyle, un groupe cycloalkyle, un groupe aryle, un groupe hétérocyclique monovalent, un groupe alcoxy, un groupe cycloalcoxy, un groupe aryloxy, un groupe amino, un groupe amino substitué, un groupe alcényle, un groupe cycloalcényle, un groupe alcynyle et un groupe cycloalcynyle ; une pluralité de $R^{H11}$ peuvent être identiques ou différents et ils peuvent être liés les uns aux autres pour former un cycle avec des atomes de carbone auxquels ils sont liés ;
$L^{H2}$ représente un groupe représenté par $-N(-L^{H21}-R^{H21})-$ ; lorsqu'il y a une pluralité de $L^{H2}$, ils peuvent être identiques ou différents;
$L^{H21}$ représente une liaison simple, un groupe arylène ou un groupe hétérocyclique divalent, et ces groupes peuvent avoir un substituant choisi dans le groupe constitué par un atome d'halogène, un groupe cyano, un groupe alkyle, un groupe cycloalkyle, un groupe aryle, un groupe hétérocyclique monovalent, un groupe alcoxy, un groupe cycloalcoxy, un groupe aryloxy, un groupe amino, un groupe amino substitué, un groupe alcényle, un groupe cycloalcényle, un groupe alcynyle et un groupe cycloalcynyle ; $R^{H21}$ représente un atome d'hydrogène, un groupe alkyle, un groupe cycloalkyle, un groupe aryle ou un groupe hétérocyclique monovalent, et ces groupes peuvent avoir un substituant choisi dans le groupe constitué par un atome d'halogène, un groupe alkyle, un groupe cycloalkyle, un groupe alcoxy, un groupe cycloalcoxy, un groupe aryle et un groupe hétérocyclique monovalent.

$$-[-Ar^{Y1}-]- \qquad (Y)$$

dans laquelle $Ar^{Y1}$ représente un groupe arylène, un groupe hétérocyclique divalent ou un groupe divalent dans laquelle au moins un groupe arylène et au moins un groupe hétérocyclique divalent sont directement liés et ces groupes peuvent avoir un substituant choisi dans le groupe constitué par un groupe alkyle, un groupe cycloalkyle et un groupe aryle.

**13.** Composition comprenant
un complexe métallique selon l'une quelconque des revendications 1 à 11 et
au moins un matériau choisi dans le groupe constitué par un matériau de transport de trous, un matériau d'injection de trous, un matériau de transport d'électrons, un matériau d'injection d'électrons, un luminescent matériau, un antioxydant et un solvant.

**14.** Film comprenant le complexe métallique selon l'une quelconque des revendications 1 à 11.

**15.** Dispositif électroluminescent comprenant un complexe métallique selon l'une quelconque des revendications 1 à 11.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20150349267
- WO 2014085296 A
- JP 2015113283 A
- WO 2002067343 A
- JP 2003231692 A
- WO 2003079736 A
- WO 2006097717 A


### Non-patent literature cited in the description


- *European Journal of Medicinal Chemistry,* 2015, vol. 96, 330-339
- *Tetrahedron Letters,* 2013, vol. 54 (26), 3353-3358
- *Journal of the American Chemical Society,* 2008, vol. 130 (49), 16474-16475
- *Catalysis Science & Technology,* 2015, vol. 5 (2), 1181-1186
- *Chemical Engineering & Technology,* 2016, vol. 39 (10), 1933-1938
- *Organic & Biomolecular Chemistry,* 2016, vol. 14 (38), 9046-9054
- *Chemical Review (Chem. Rev.),* 2009, vol. 109, 897-1091